# EUROPEAN PATENT SPECIFICATION

(11) **EP 1 035 124 B1**
(45) Date of publication and mention of the grant of the patent: **26.05.2004**
(21) Application number: 00300978.4
(22) Date of filing: 08.02.2000
(51) Int. Cl.: C07F 5/02, C07F 17/02

(54) **Borate compound, and photopolymerizable composition and recording material which contains the same**
Boratverbindungen, diese enthaltende fotopolymerisierbare Zusammensetzungen und Aufzeichnungsmaterialien
Compositions photopolymérisables et matériaux d'enregistrement contenants des composés borates

(30) Priority: 08.03.1999 JP 6086299; 15.04.1999 JP 10846699
(43) Date of publication of application: 13.09.2000
(73) Proprietor: Fuji Photo Film Co., Ltd., Kanagawa (JP)
(72) Inventor: Arai, Yoshimitsu, Fujinomiya-shi, Shizuoka-ken (JP); Fukushige, Yuuichi, Fujinomiya-shi, Shizuoka-ken (JP)
(74) Representative: Blake, John Henry Francis

(56) References cited:
- WO-A-97/42227
- DE-A- 19 648 313
- DE-A- 19 730 498
- DE-A- 19 850 139
- US-A- 5 952 152
- Cunningham et al: 'Acid-Stable Dye-Borate Electron Transfer Photoinitiators'; RadTech'98 North Am. UV/EB Conf. Proc. (1998), 38-41 Publisher: Radtech Int. North America, Northbrook, Ill. XP000940495
- http://www.pharmacy.umaryland.edu/courses/PHAR5- 31/lectures/qsar.html
- http://www.engin.unich.edu/dept/cee/research/ad- riens/CEE%20692/CEE-692-QSARs.ppt.

## Description

### BACKGROUND OF THE INVENTION

### Field of the Invention

The present invention relates to a novel borate compound, and a photopolymerizable compound and a recording material which contain the borate compound.

### Description of the Related Art

Examples using a borate compound in combination with a sensitizing dye as a photopolymerization initiator have hitherto been known. For example, U.S. Patent Nos. 4,772,530 and 4,772,541 and 5,151,520 disclose triarylalkyl borates containing a cationic dye such as cyanine, rhodamine, and the like, as a counter ion. These compounds are used as a photopolymerization initiator. As is known from U.S. Patent No. 5,055,372, a quaternary ammonium compound such as tetramethylammonium, pyridinium and cetyl pyridinium as a counter cation of the triaryl alkyl borate.

However, since these borate compounds are unstable in a medium containing a component having an acidic group (hereinafter referred to as an "acid-containing medium"), they can not be used as the photopolymerization initiator in the medium. Japanese Patent Application Laid-Open (JP-A) No. 9-188686 discloses that a triarylalkyl borate becomes stable in an acid-containing medium by introducing an electron attractive group into an aryl group of the triarylalkyl borate. However, since an oxidation potential of the borate compound is enhanced by introducing the electron attractive group, there is the drawback that the sensitivity becomes lower than that of triphenylalkyl borate.

WO97/42227 cited in the European Search Report discloses photopolymerizable compositions containing borate compounds satisfying the structure represented by the following formula (I): 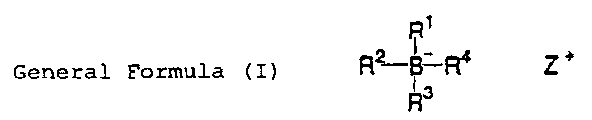 wherein R¹ represents an alkyl group which may have a substituent; R², R³ and R⁴ each represents an aryl group; and Z⁺ represents a group capable of forming a cation.

Also quaternary boron salt sensitizers are disclosed in DE-A-19730498 cited in the European Search Report and in Cunningham *et al* "Acid-Stable Dye-Borate Electron Transfer Photoinitiators"; RadTech '98 North Am. UV/EB Conf. proc. (1998), 38-41 Publisher: Radtech Int. North America, Northbrook, III cited during the examination procedure.

### SUMMARY OF THE INVENTION

The present invention is directed to attain the following object. That is, an object of the present invention is to provide a novel borate compound which has high sensitivity and is superior in storage properties even in cases where an acid-containing medium is also present, and a photopolymerizable compound and a recording material which contain the borate compound.

To solve the aforementioned problems of the prior art, the present inventors have conducted intensive studies. As a result, they have found that not only the sensitivity is improved, but also the storage properties are improved by a steric protection effect by introducing an electron donative group at the ortho-position of an aryl group of a triarylalkyl borate, thus completing the present invention.

The present invention provides certain borate compounds listed in claim 1 and represented by one of the following general formulae (III) and (IV): 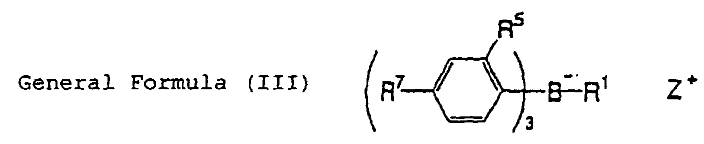 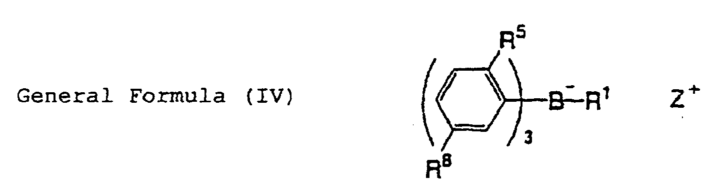 wherein Z⁺ represents a group capable of forming a cation, R¹ represents an alkyl group which may have a substituent; R⁵ represents an electron donative group. In the compound of the invention, R⁷ and R⁸ are substituents such that the total of the Hammett σ constants of substituents R⁵ and R⁷ or R⁵ and R⁸ are from 0 to 1.

Still another aspect of the present invention is a photopolymerizable composition comprising one of the above borate compounds.

Another aspect of the present invention is a photopolymerizable composition as above, further comprising a dye and a radical-polymerizable compound.

A further aspect of the present invention is a recording material comprising a substrate and a recording layer on the substrate, said recording layer containing a photopolymerizable composition as above, a color developing component (A), and a color developing component (B) capable of reacting with the color developing component (A) to develop a color of the color developing component (A).

### DETAILED DESCRIPTION OF THE INVENTION

The present invention will be described in detail hereinafter.

### Borate compound

The borate compounds of the present invention have structures that can be represented by the following general formula (III)and (IV):

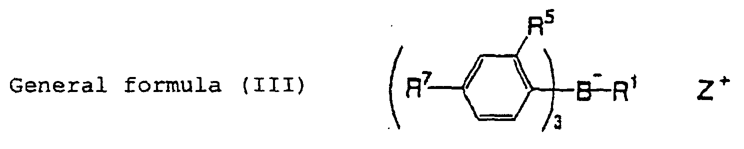

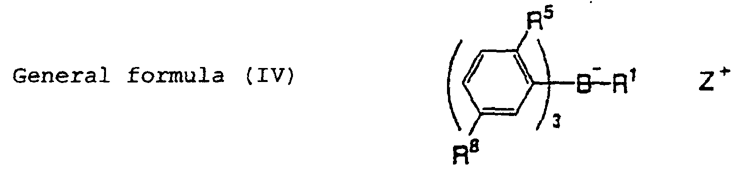

In the general formulas (III) and (IV), R⁵ represents an electron donative group. The electron donative group represented by R⁵ refers to a substituent wherein a Hammett σ constant ( σₚ) is negative.

In the compounds of the invention a methyl group, ethyl group, methoxy group and ethoxy group are found as electron donative groups.

The substituents represented by R⁷ and R⁸ are chlorine and fluorine atoms and the trifluoromethyl group.

The substituent represented by R⁷ and R⁸ are selected so that the total value of the Hammett substituent σ constants of R⁵ and R⁷ or R⁸ is from 0 to 1.

The total value of the Hammett substituent σ constants of R⁵ to R⁹ (hereinafter referred merely to as "total σ constant") is from 0 to 1, but is particularly preferably from 0.1 to 0.6.

When the total σ constant is larger than 1, the sensitivity is lowered because of too strong an electron attractive property, which is not preferred. When the total sigma constant is from 0.1 to 0.6, the sensitivity is high and stability is sufficient in an acid-containing medium, which is more preferred.

The Hammett substituent σ constant is, for example, explained in detail in "Hammett's Rule: structure And Reactivity" (written by Naoki INAMOTO, Maruzen Co.); "New Experimental Chemistry Course No. 14: Synthesis And Reaction of Organic Compound V" (published by Japan Chemical Association, page 2605, Maruzen Co., Ltd); "Explanation of Theoretical Organic Chemistry" (written by Tadao NAKAYA, page 217, Tokyo Kagaku Dojin Co.); and Chemical Review (Vol. 91, pages 165 to 195, 1991).

In the general formula (III) and (IV), Z⁺ represents a group capable of forming a cation. In the compounds of the invention, Z⁺ is found among alkali metal (particularly sodium), alkali earth metal, transition metal, quaternary ammonium, dye cation or cationic transition metal coordination complex compound. Ammonium, tetraalkylammonium or dye cation is preferred. Tetraalkylammonium is represented by the following formula.

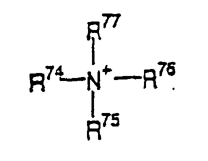

In the formula, R⁷⁴ to R⁷⁷ each represents an alkyl group. Examples thereof include tetramethylammonium wherein R⁷⁴ to R⁷⁷ each represents a methyl group, tetraethylammonium wherein R⁷⁴ to R⁷⁷ each represents an ethyl group, tetrapropylammonium wherein R⁷⁴ to R⁷⁷ each represents a propyl group, tetrabutylammonium wherein R⁷⁴ to R⁷⁷ each represents a butyl group and the like.

As Z⁺, benzyltrialkylammonium described below is also preferred.

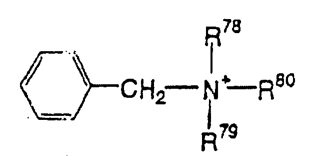

In the formula, R⁷⁸ to R⁸⁰ each represents an alkyl group. Preferred examples of the benzyltrialkylammonium include benzyltrimethylammonium, benzyltriethylammonium, benzyltripropylammonium, and benzyltributylammonium. Trialkylammonium ion, e.g., trimethylammonium, is also preferred. As Z⁺, phosphonium ion and ammonium ion may also be used.

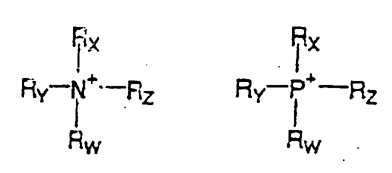

In the formula, R_{W}, R_{X}, R_{Y} and R_{Z} each independently represents a hydrogen atom, a non-substituted or substituted alkyl group, a cycloalkyl group, an alkenyl group, a phenyl group or an arylalkyl group or the like.

specific examples of the alkyl group, cycloalkyl group, alkenyl group, phenyl group and aralkyl group include a halogen atom, hydroxyl group, heterocycloalkyl group (e.g. epoxy group, aziridyl group, oxetanyl group, furanyl group, pyrrolidinyl group, pyrrolyl group, thiophenyl group, tetrahydrofuranyl group, etc.), dialkylamino group, amino group, carboxyl group, alkyl or arylcarbonyl, and an aryloxy or alkoxycarbonyl group. Tetravalent nitrogen atom may be a portion of a five or six membered ring, or the other ring may be condensed. These ring systems may also include other hetero atoms such as S, N and O.

As Z⁺, a polyammonium ion or polyphosphonium ion as a poly compound of the above ammonium ion or phosphonium ion may be used, and a bis compound thereof is preferred. Examples of the substituent, in cases where the poly ion is substituted, are the same substituents as those of the mono ion.

The ammonium ion and phosphonium ion can be substituted with a neutral dye (e.g., thioxanthene, thioxanthone, coumarin, ketocoumarin, and the like.). These ions can be obtained by reacting ammonium and phosphonium ions substituted with a reactive group (e.g. epoxy group, amino group, hydroxyl group, etc.) with a proper neutral dye. For example, these ions are described in EP-A No. 224967 (Quantacure QTX).

In the same manner, an ammonium ion and phosphonium ion can be substituted with a colorless electron acceptor (e.g. benzophenone, etc.). Examples of Z⁺ in cases where ammonium ion is substituted with benzophenone are shown below, but are not limited thereto.

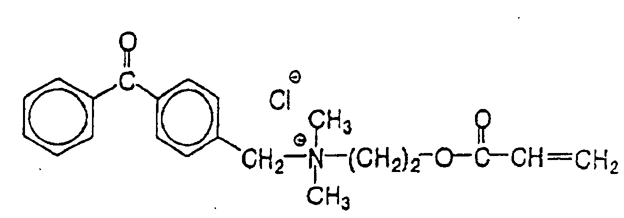

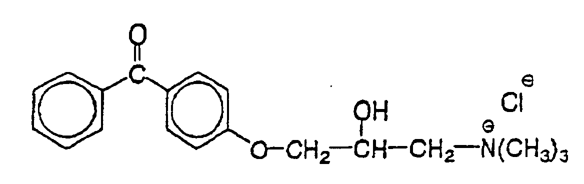

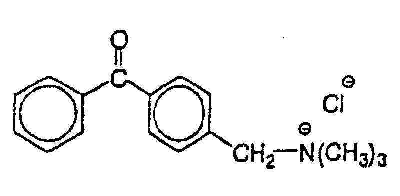

The other quaternary ammonium ion includes, for example, trimethylcetylammonium ion or cetylpyrdinium ion.

Other examples of Z⁺ include cations of the following cation group 1.

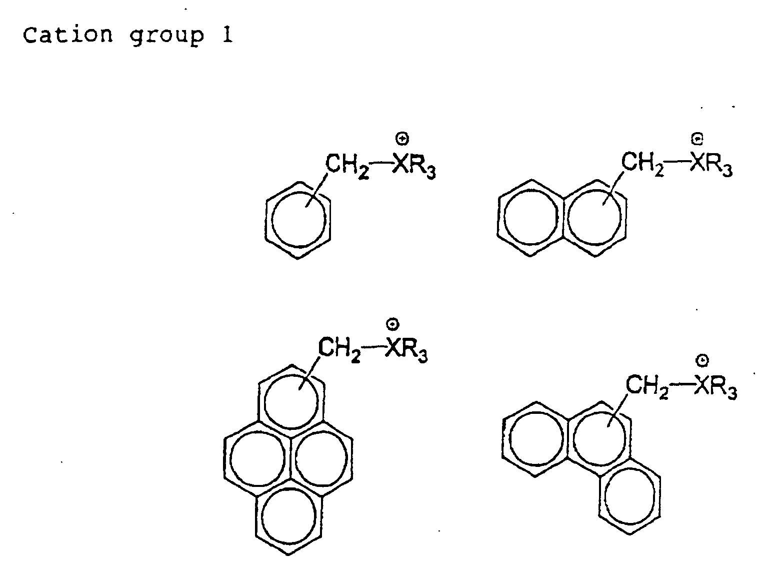

In the formula, X represents P (phosphorous), S (sulfur) or N (nitrogen), and R represents an alkyl group or an aryl group.

Other examples of Z⁺ include cations of the following cation group 2 or cation group 3. In the following cation group 2, R represents an alkyl group or an aryl group. These cations are described in J. Polym. Sci. Part A: Polymer Chem. 1992, 30, 1998 and Polymer 1993, 34 (6), 1130 by YAGUCHI et al. In the cation group 3, R' represents a non-substituted or substituted benzyl or phenacyl group. These cations are disclosed in JP-A No. 7-770221. An aromatic ring in the pyrimidium portion of these cations may also be substituted.

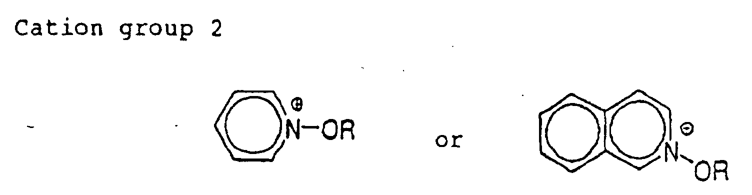

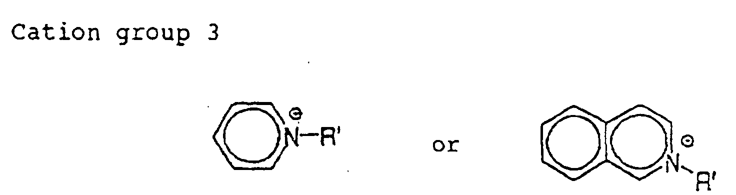

Examples of other counter cations as 2⁺ include other onium ions, e.g., iodonium ion or sulfonium ion. These cations include, for example, those disclosed in EP-A No. 555058 and EP-A No. 690074, which are represented by the following formula.

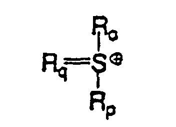

As Z⁺, the following cations are also preferred.

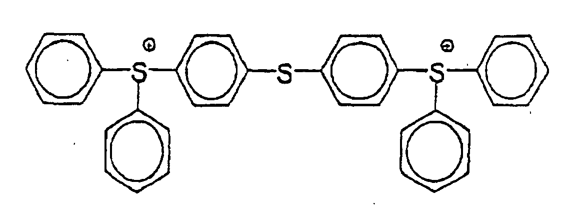

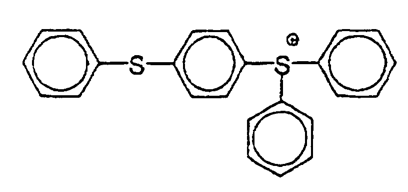

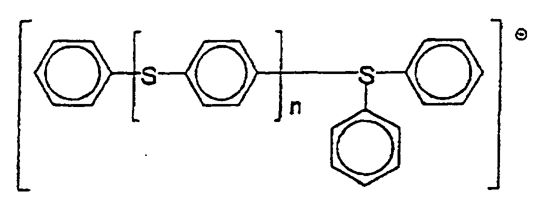

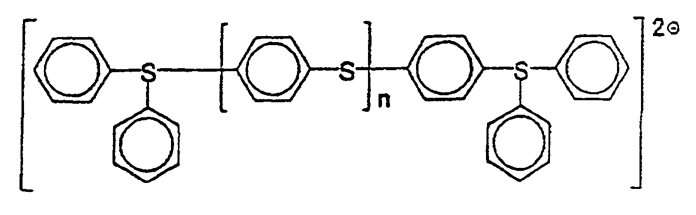

Other examples of Z⁺ include cations described below. In the following formula, R_{g} represents an alkyl group, particularly an ethyl group, or a benzyl group. The aromatic ring may have a substituent.

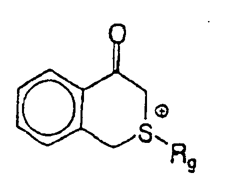

Z⁺ may also be a halonium ion, and diaryliodonium ions disclosed in EP-A No. 334056 and EP-A No. 562897 are particularly preferred.

Preferable examples of Z⁺ also include a ferrosenium cation represented by the following formula disclosed in EP-A No. 94915 and EP-A No. 109851.

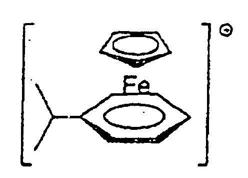

Z⁺ may also be an ammonium ion, phosphonium ion, sulfonium ion, iodonium ion, cellonium ion, arsonium ion, telonium ion, onium ion such as bismusonium ion or the like.

Z⁺ may also be a cationic transition metal complex compound and specific examples thereof include those described in U.S. Patent No. 4,954,414. Among these, bis(2,2'-bipyridine), (4,4'-dimethyl-2,2'-bipyridine)ruthenium, tris(4,4'-dimethyl-2,2'-bipyridine)ruthenium, tris(4,4'-dimethyl-2,2'-bipyridine)iron, tris(2,2',2"-terpyridine)ruthenium, tris(2,2'-bipyridine)ruthenium and (2,2'-bipyridine)(5-chloro-1,10-phenanthrine)ruthenium are particularly preferred.

Z⁺ may also be cationic dyes described in "Chemistry of Functional Pigment" (1981, CMC Publishing Co., pages 393-416) and "Coloring Material" (60 [4], pages 212-224 (1987)).

Specifically, any cationic dyes having a maximum absorption wavelength of 300nm or more, and preferably within a range from 400 to 1100 nm can be preferably used. Among these, cationic methane pigment, polymethine pigment, triarylmethane pigment, indoline pigment, azine pigment, xanthene pigment, cyanine pigment, hemicyanine pigment, rhodamine pigment, azamethine pigment, oxazine pigment or acridine pigment is preferred, and cationic cyanine pigment, hemicyanine pigment, rhodamine pigment or azamethine pigment is further preferred.

The borate compounds of the present invention are illustrated below, together with the Hammett constant total for each compound:

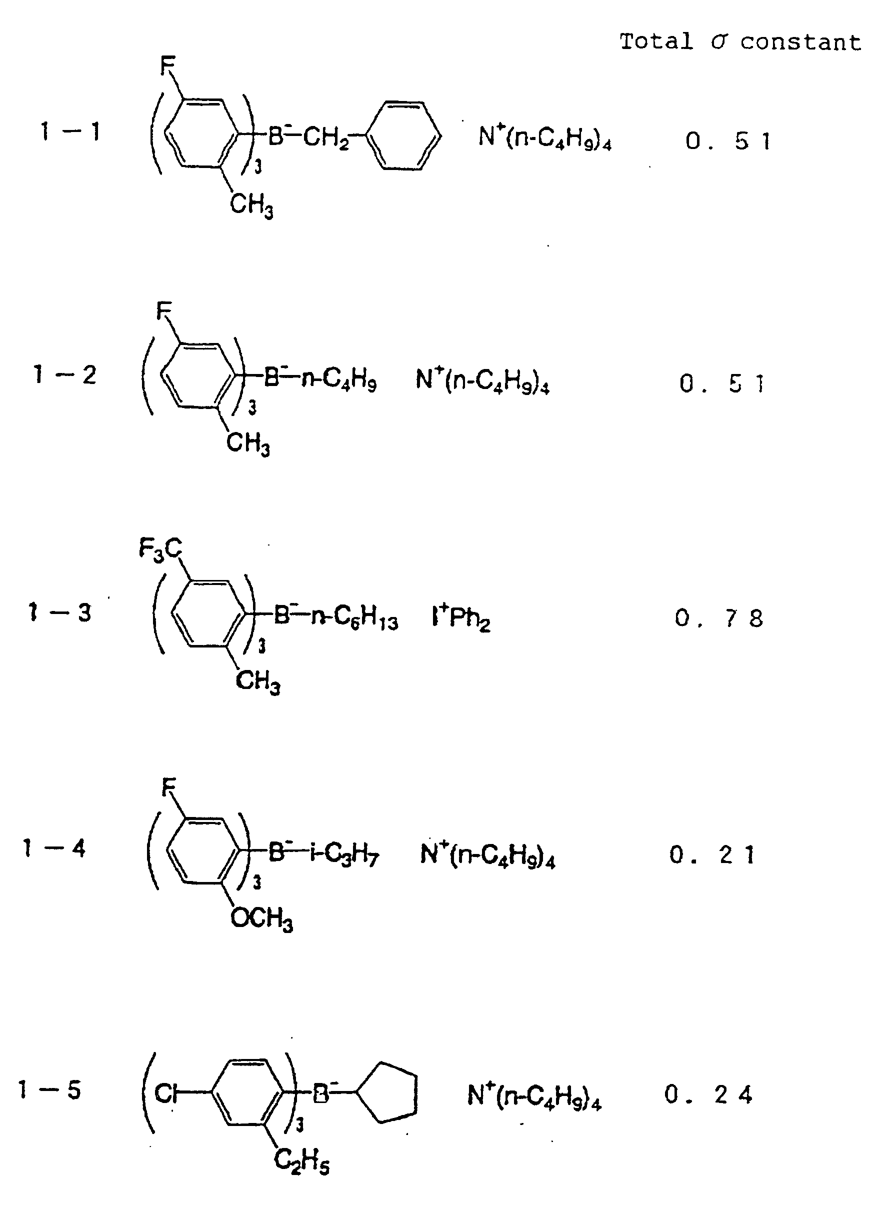

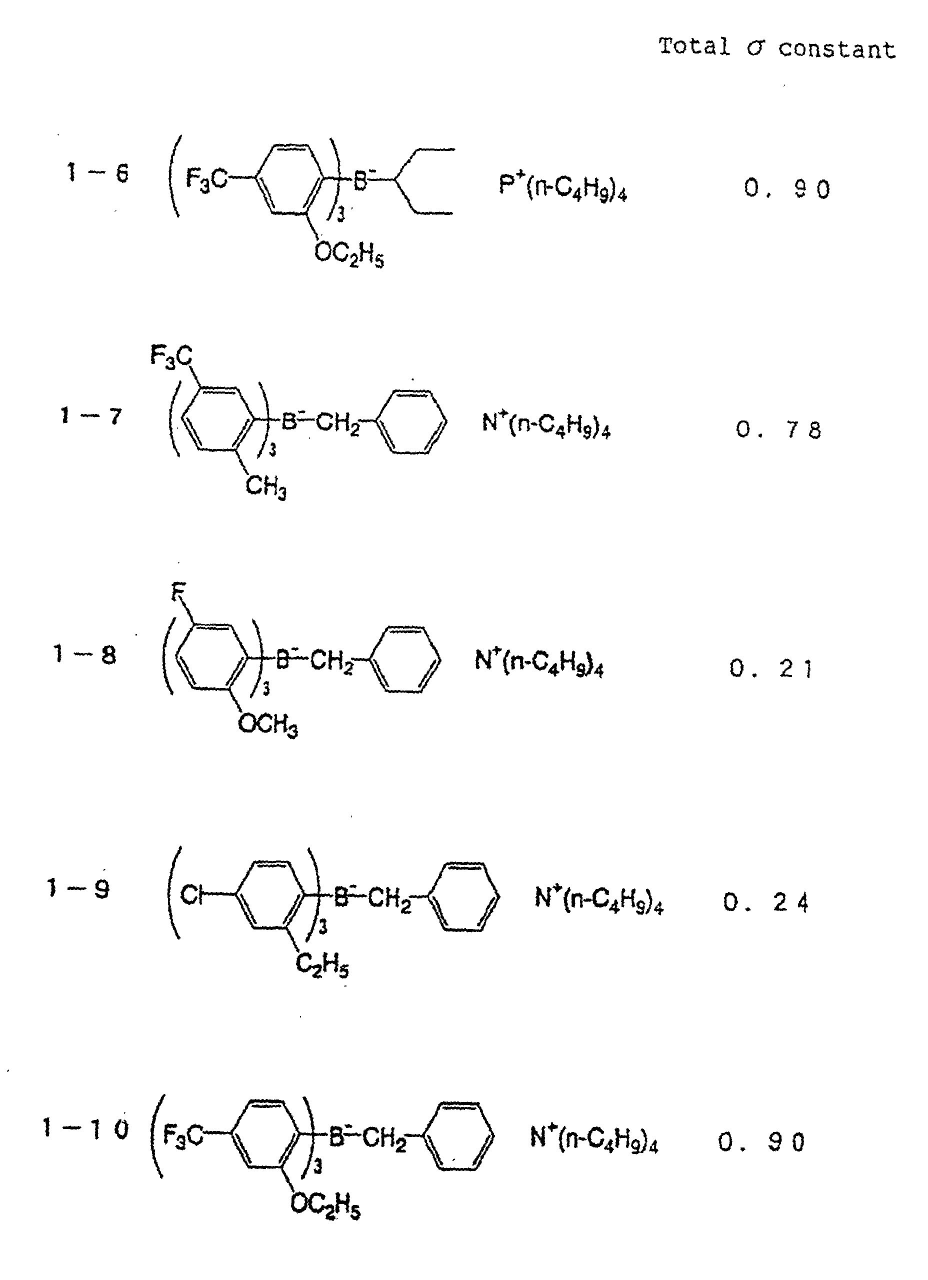

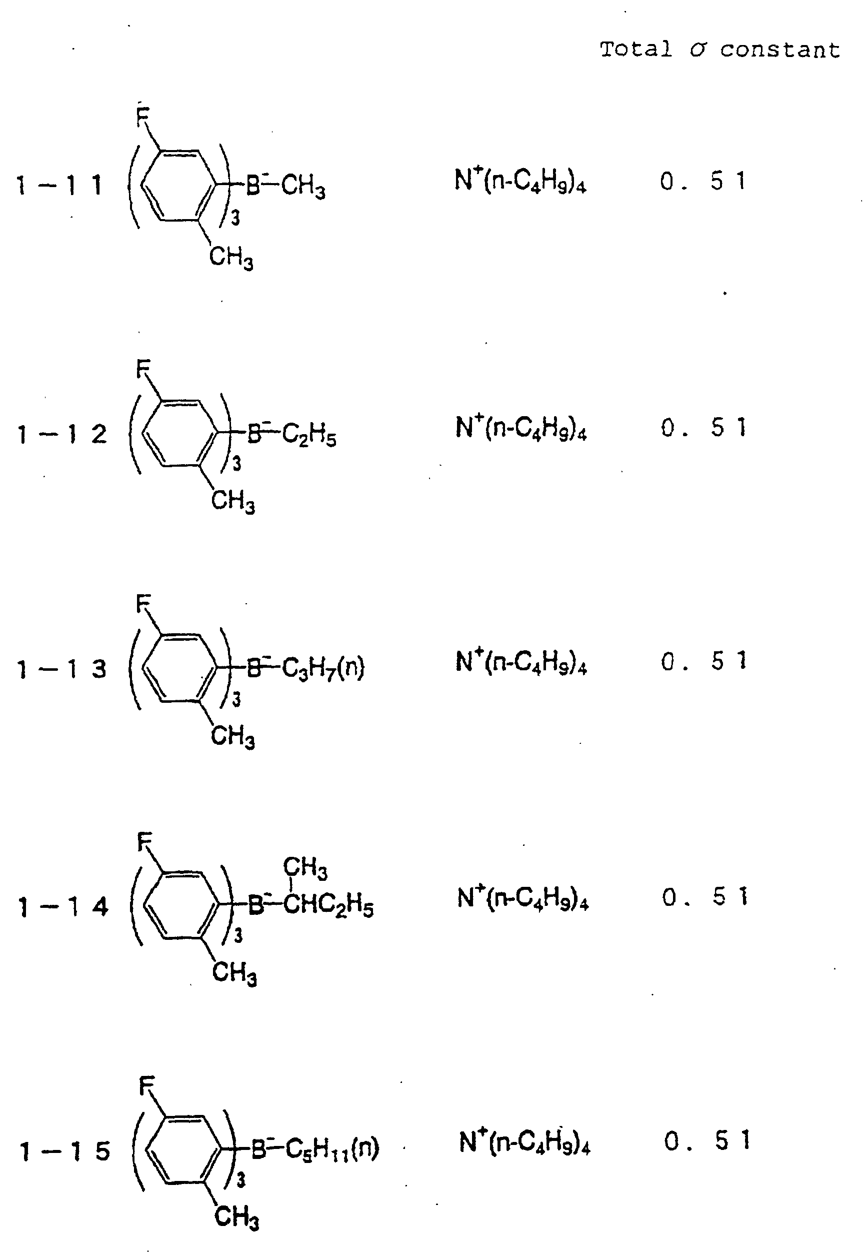

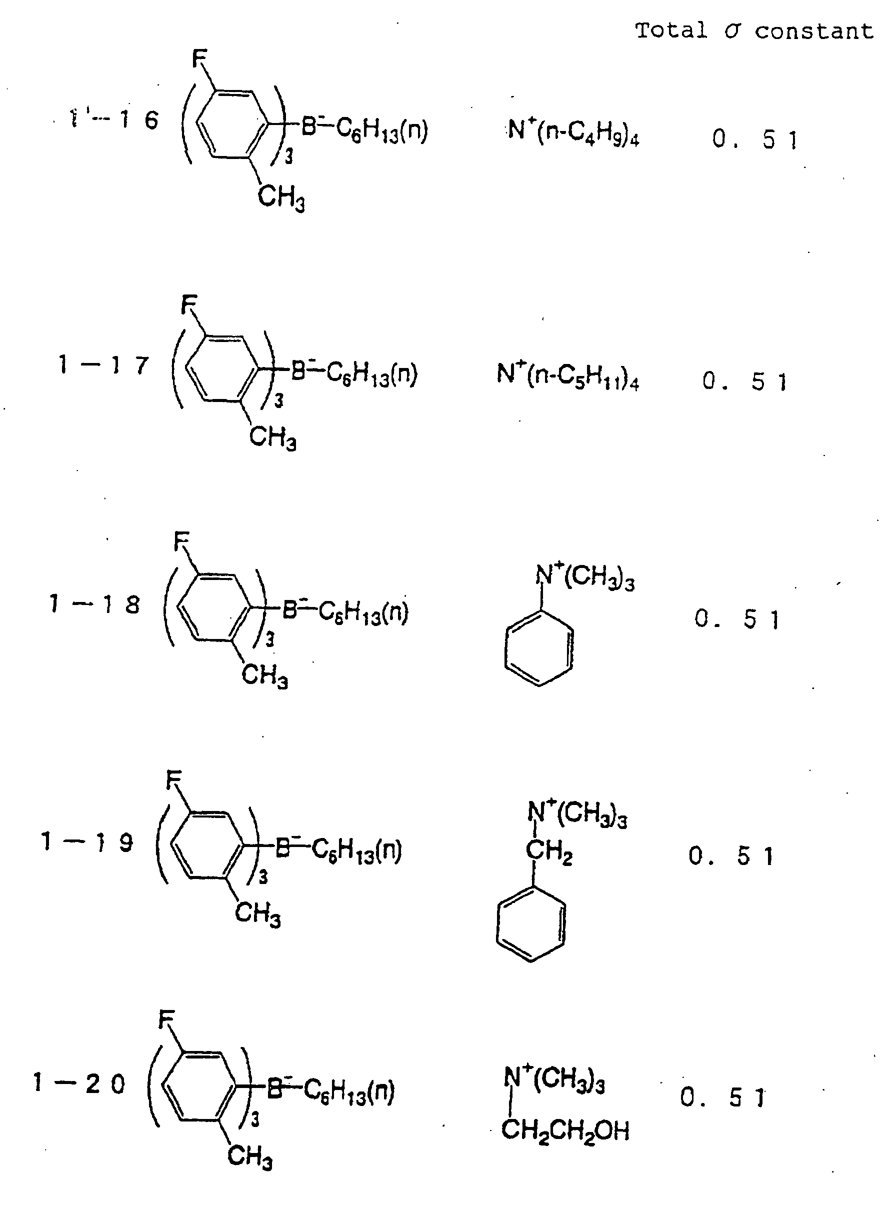

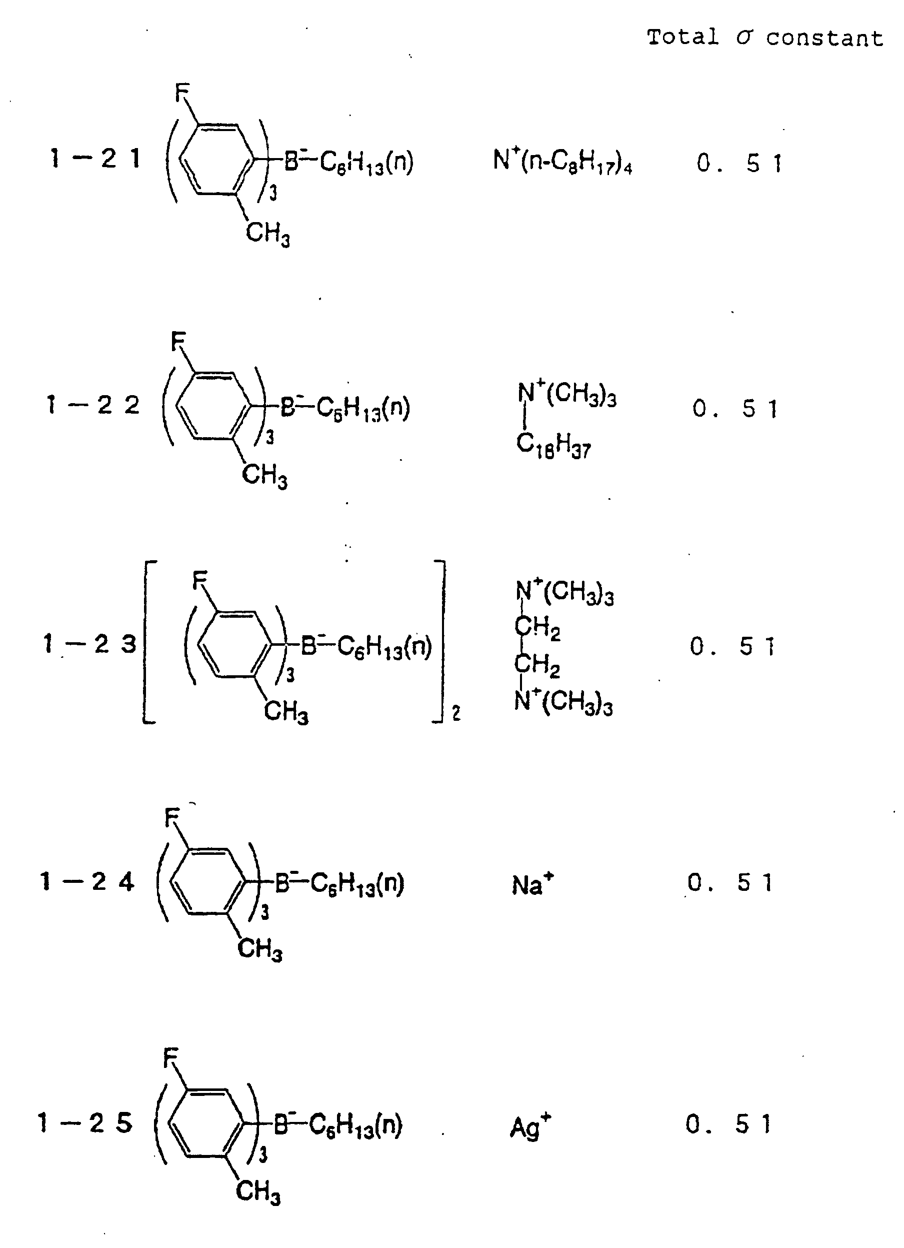

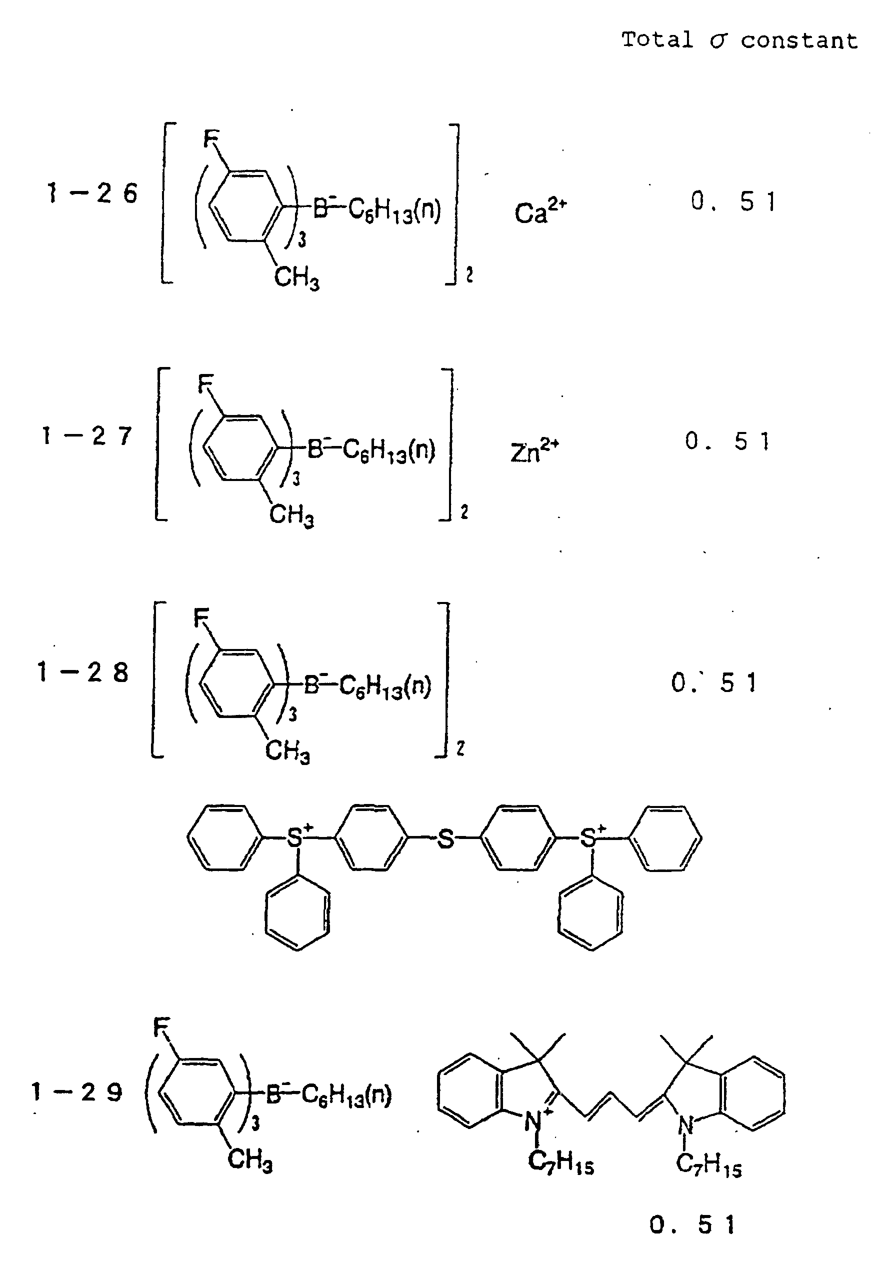

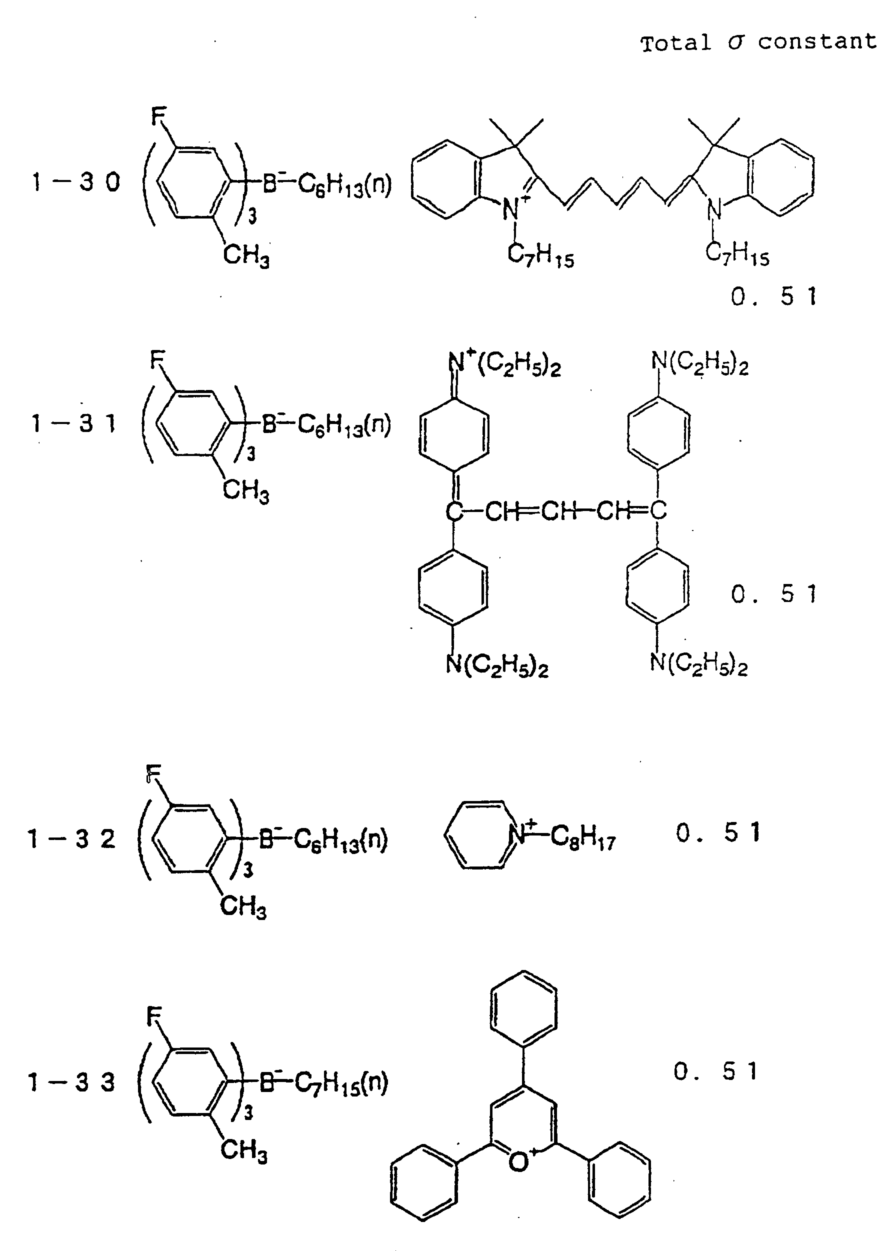

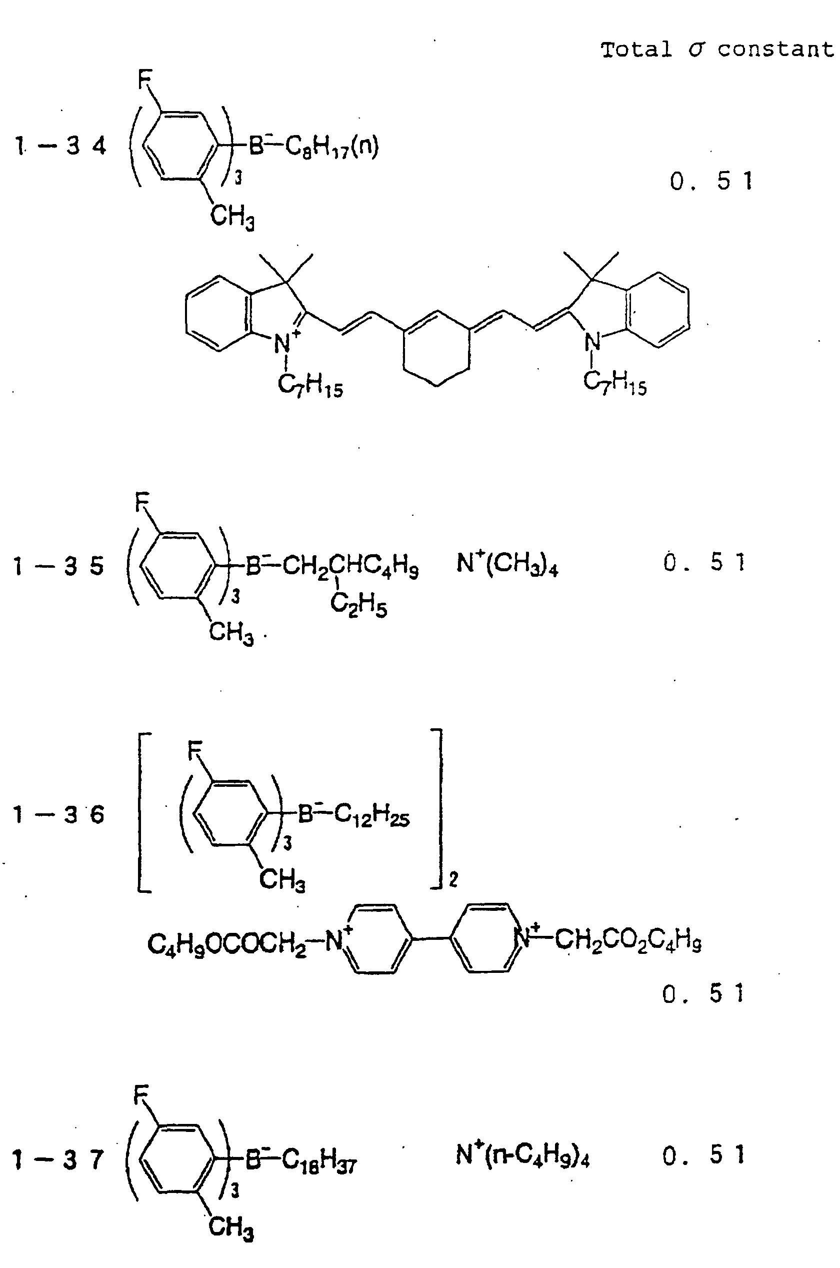

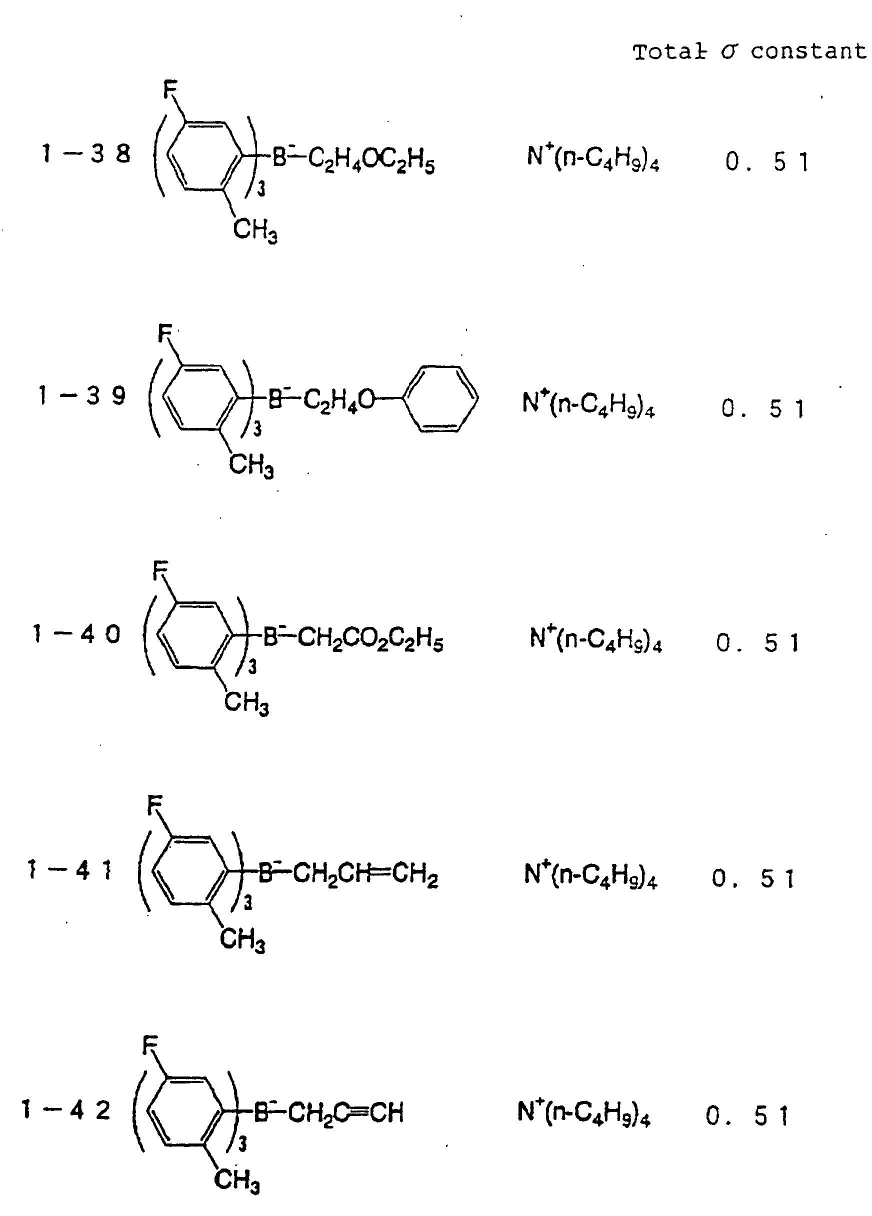

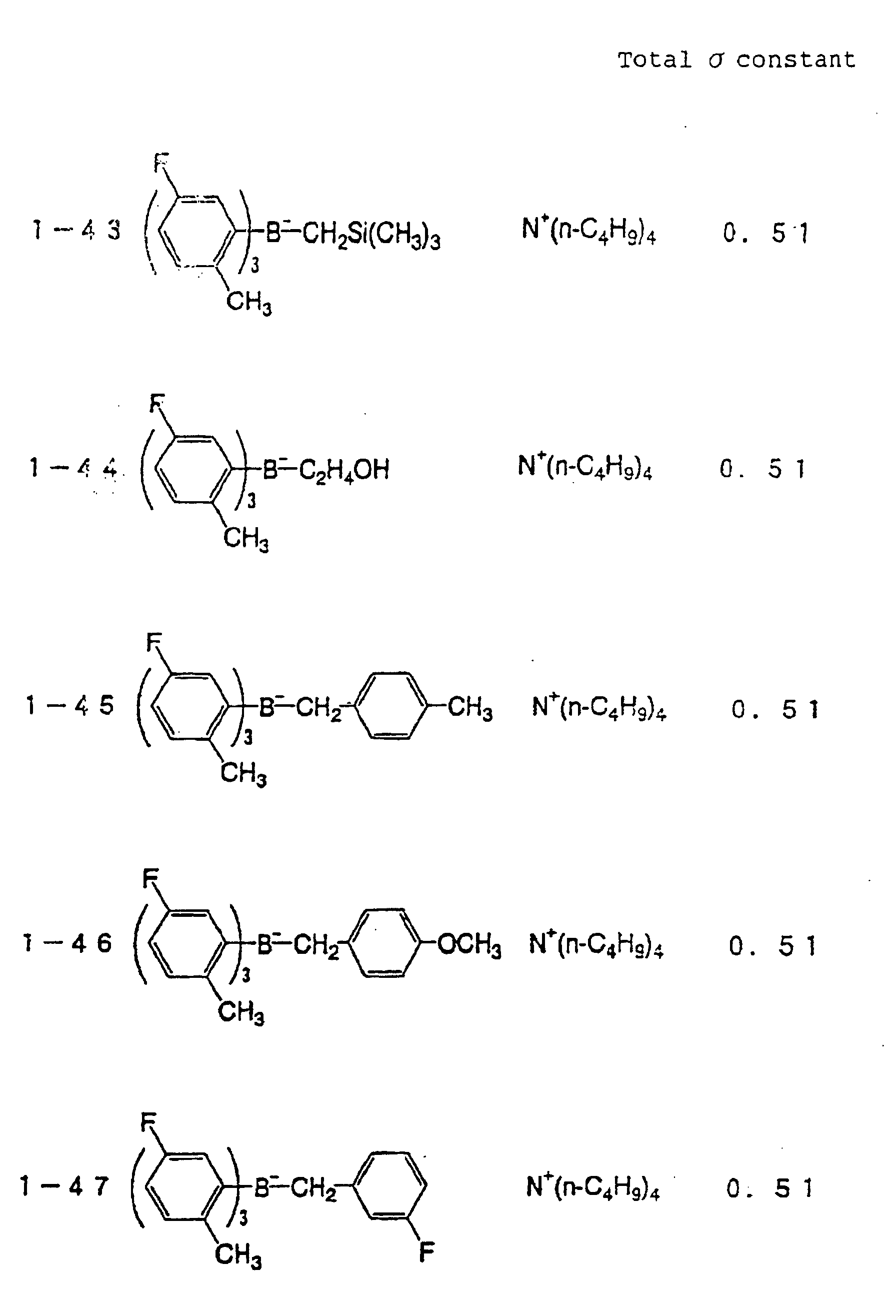

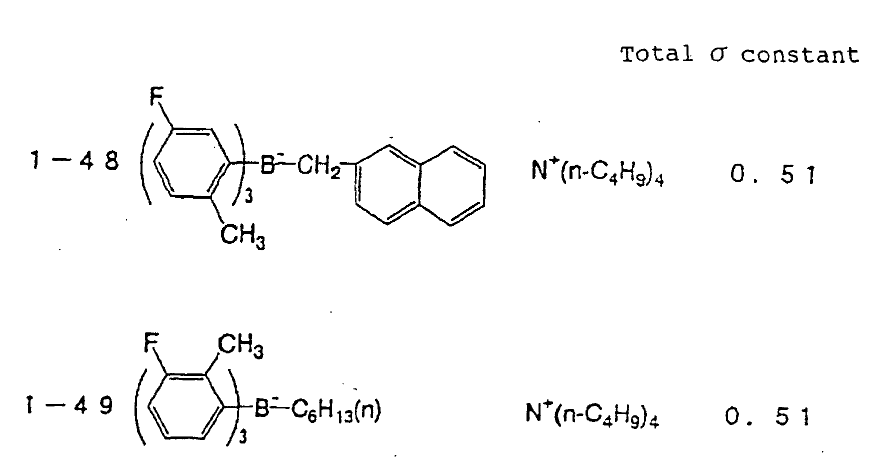

Synthesis Examples of the borate compound according to the present invention are shown below. The number in parenthesis of the borate compound represents the number of aforementioned compound.

### Synthesis Example 1

### Synthesis of borate compound (1-1)

25 ml of a 1M THF solution of benzylmagnesium chloride was added dropwise to 6.7 g of tris(5-fluoro-2-methylphenyl)borane in 20 ml of toluene at 0°C. After the mixture was heated to room temperature and stirred for 1 hour, a solution prepared by dissolving 9.67 g of tetrabutylammonium bromide in 50 ml of water was added. After stirring for 1 hour, the reaction solution was extracted with ethyl acetate and the extract was dried over magnesium sulfate, filtered and then concentrated to obtain an oily substance. This oily substance was recrystallized from methanol and dried to obtain 6.97 g of the desired borate compound (1-1).

The melting point was of from 127 to 128°C. ¹H-NMR (CDCl₃) analysis afforded the results of 0.94 (12H), 1.28 (8H), 1.89 (9H), 2.80 (10H), 6.47 (3H), 6.7-6.9 (8H), and 7.07 (3H).

### Synthesis Example 2

### Synthesis of borate compound (1-2)

15 ml of a 1.6M hexane solution of n-butyl lithium was added dropwise to 6.76 g of tris(5-fluoro-2-methylphenyl)borane in 20 ml of toluene at 0°C. After the mixture was heated to room temperature and stirred for 1 hour, a solution prepared by dissolving 9.67 g of tetrabutylammonium bromide in 50 ml of water was added. After stirring for 1 hour, the reaction solution was extracted with ethyl acetate and the extract was dried over magnesium sulfate, filtered and then concentrated to obtain an oily substance. This oily substance was recrystallized from methanol and dried to obtain 6.51 g of the desired borate compound (1-2).

The melting point was of from 166 to 167°C. ¹H-NMR (CDCl₃) analysis afforded the results of 0.83 (3H), 0.93 (12H), 1.05-1.47 (22H), 1.94 (9H), 2.77 (8H), 6.48 (3H), 6.81 (3H), and 6.93 (3H).

### Synthesis Example 3

### Synthesis of borate compound (1-45)

25 ml of a 1M diethyl ether solution of 4-methylbenzylmagnesium chloride was added dropwise to 6.76 g of tris (5-fluoro-2-methylphenyl)borane in 20 ml of toluene at 0°C. After the mixture was heated to room temperature and stirred for 1 hour, a solution prepared by dissolving 9.67 g of tetrabutylammonium bromide in 50 ml of water was added. After stirring for 1 hour, the reaction solution was extracted with ethyl acetate and the extract was dried over magnesium sulfate, filtered and then concentrated to obtain an oily substance. This oily substance was recrystallized from methanol and dried to obtain 7.63 g of the desired borate compound (1-45).

The melting point was of from 152 to 153°C. ¹H-NMR (CDCl₃) analysis afforded the results of 0.95 (12H), 1.29 (8H), 1.39 (8H), 1.89 (9H), 2.14 (3H), 2.70 (2H), 2.81 (8H), 6.50 (3H), 6.63 (2H), 6.76 (5H), and 7.07 (3H).

### Synthesis Example 4

### Synthesis of borate compound (1-16)

16.7 ml of a 1.8M hexane solution of n-hexyl lithium was added dropwise to 6.76 g of tris(5-fluoro-2-methylphenyl)borane in 20 ml of toluene at 0°C. After the mixture was heated to room temperature and stirred for 1 hour, a solution prepared by dissolving 9.67 g of tetrabutylammonium bromide in 50 ml of water was added. After stirring for 1 hour, the reaction solution was extracted with ethyl acetate and the extract was dried over magnesium sulfate, filtered and then concentrated to obtain an oily substance. This oily substance was recrystallized from methanol and dried to obtain 6.79 g of the desired borate compound (1-16).

The melting point was of from 92-93°C. ¹H-NMR (CDCl₃) analysis afforded the results of 0.84 (3H), 0.96 (12H), 1.09-1.49 (26H), 1.97 (9H), 2.78 (8H), 6.49 (8H), 6.49 (3H), 6.82 (3H), and 6.94 (3H).

### Synthesis Example 5

### Synthesis of borate compound (1-17)

16.7 ml of a 1.8M hexane solution of n-butyl lithium was added dropwise to 6.76 g of tris(5-fluoro-2-methylphenyl)borane in 20 ml of toluene at 0°C. After the mixture was heated to room temperature and stirred for 1 hour, 50 ml of water was added and a solution prepared by dissolving 11.4 g of tetrapentylammonium bromide in 20 ml of methanol was further added. After stirring for 1 hour, the reaction solution was extracted with ethyl acetate and the extract was dried over magnesium sulfate, filtered and then concentrated to obtain an oily substance. This oily substance was recrystallized from methanol and dried to obtain 8.37 g of the desired borate compound (117).

The melting point was of from 96 to 97°C. ¹H-NMR (CDCl₃) analysis afforded the results of 0.84 (3H), 0.92 (12H), 1.10-1.53 (34H), 1.96 (9H), 2.77 (8H), 6.49 (3H), 6.82 (3H), and 6.93 (3H).

The borate compound represented by the general formula (I) of the present invention can be preferably used as a photopolymerization initiator. That is, since the borate compound of the present invention has high sensitivity and excellent storage properties due to a steric protection effect even in cases where an acid-containing medium is also present by introducing an electron donative group at the ortho-position of an aryl group of a triarylalkyl borate and controlling the total σ constant of all substituents on the aryl group within a range from 0 to 1, the borate compound can be used in the photopolymerizable composition and the recording material described hereinafter, particularly preferably.

### Photopolymerizable composition

The photopolymerizable composition of the present invention contains at least the borate compound (capable of functioning as a "photopolymerization initiator") of the present invention and contains preferably a pigment and a radical-polymerizable compound, and contains other components, if necessary.

### Photopolymerization initiator

The photopolymerizable composition of the present invention contains at least the borate compound represented by the general formula (I) of the present invention as a photopolymerization initiator.

The borate compounds represented by the general formula (I) may be used alone, or two or more kinds of them may be used in combination.

When using a borate compound of the general formula (I) wherein Z⁺ is not one of the aforementioned cationic pigments(hereinafter referred to as a "borate compound I") in combination with a borate compound of the general formula (II) wherein Z⁺ is one of the aforementioned cationic pigments, (hereinafter referred to as a "borate compound II") among the borate compounds of the present invention, these borate compounds are preferably used in combination so that a molar ratio of the borate portion to the cationic dyes portion is 1 or more, in view of sufficient enhanced sensitization and discoloration performances.

A ratio of the borate compound I to the borate compound II is preferably used within a range from 1:1 to 50:1, more preferably from 1.2:1 to 30:1, and most preferably from 1.2:1 to 20:1. When the ratio of the borate compound I to the borate compound II is smaller than 1:1, sufficient polymerization reactivity and discoloration performances are not obtained sometimes. On the other hand, when the ratio exceeds 50:1, sufficient sensitivity can not obtained sometimes.

The amount of the borate compound contained in the photopolymerizable composition of the present invention is preferably from 1 to 20% by weight, and more preferably from 4 to 15% by weight, based on the total weight of the following radical-polymerizable compound in the photopolymerizable composition.

When the amount is smaller than 1% by weight, the polymerizability and discoloration performances are lowered sometimes. On the other hand, when the amount is larger than 20% by weight, the storage stability is lowered sometimes.

The photopolymerizable composition of the present invention can also contain compounds other than the borate compound of the present invention as the other photopolymerization initiator as far as the effect of the present invention is not adversely affected.

Examples of the other photopolymerization initiator include: aromatic ketones, for example, bisacylphosphine oxides such as benzophenone, 4,4-bis(dimethylamino)benzophenone, 4-methoxy-4'-dimethylaminobenzophenone, 4,4'-dimethoxybenzophenone, 4-dimethylaminobenzophenone, 4-dimethylaminoacetophenone, benzylanthraquinone, 2-tert-butylanthraquinone, 2-methylanthraquinone, xanthone, thioxanthone, 2-chlorthioxanthone, 2,4-diethylthioxanthone, fluorenone, acridone, bis(2,4,6-trimethylbenzoyl)-phenylphosphine oxide, and the like; acylphosphine oxides such as 2,4,6-trimethylbenzoyl diphenylphosphine oxide, and the like;
benzoins and benzoin ethers, such as benzoin methyl ether, benzoin ethyl ether, benzoin isopropyl ether, benzoin phenyl ether, etc.; 2,4,6-triarylimidazole dimers such as 2-(o-chlorophenyl)-4,5-diphenylimidazole dimer, 2-(o-chlorophenyl)-4,5-di(m-methoxyphenyl)imidazole dimer, 2-(o-fluorophenyl)-4,5-diphenylimidazole dimer, 2-(o-methoxyphenyl)-4,5-diphenylimidazole dimer, 2-(p-methoxyphenyl)-4,5-diphenylimidazole dimer, etc.; polyhalides such as carbon tetrabromide, phenyltribromomethylsulfone, phenyltrichloromethylketone, and the like; compounds described in JP-A No. 59-133428, Japanese Patent Application Publication (JP-B) Nos. 57-1819 and 57-6096, and U.S. Patent No. 3,615,455;
S-triazine derivatives having a trihalogen-substituted methyl group described in JP-A No. 58-290803, such as 2,4,6-tris(trichloromethyl)-S-triazine, 2-methoxy-4,6-bis(trichloromethyl)-S-triazine, 2-amino-4,6-bis(trichloromethyl)-S-triazine, 2-(P-methoxystyryl)-4,6-bis(trichloromethyl)-S-triazine, etc.;
Organic peroxides described in JP-A No. 59-189340, such as methyl ethyl ketone peroxide, cyclohexanone peroxide, 3,3,5-trimethylcyclohexanone peroxide, benzoyl peroxide, ditert-butyldiperoxyisophthalate, 2,5-dimethyl-2,5-di(benzoylperoxy)hexane, tert-butylperoxybenzoate, a,a'-bis(tert-butylperoxyisopropyl)benzene, dicumyl peroxide, 3,3',4,4'-tetra-(tert-isobutylperoxycarbonyl)benzophenone, and the like;
azinium salt compound dedscribed in U.S. Patent No. 4,743,530; organic organoboron compounds described in European Patent No. 0223587, such as tetramethylammonium salt of triphenylbutyl borate, tetrabutylammonium salt of triphenylbutyl borate, tetramethylammonium salt of tri(P-methoxyphenyl)butyl borate, and the like; and diaryl iodonium salts and iron-arene complex.

Those using two or more compounds in combination are also known and can be used in the photopolymerizable composition of the present invention.

Examples of the combination of two or more compounds include a combination of 2,4,5-triarylimidazole dimer and mercaptobenzoxazole, a combination of 4,4'-bis(dimethylamino)benzophenone and benzophenone or benzoin methyl ether described in U.S. Patent No. 3,427,161, a combination of benzoyl-N-methylnaphthothiazoline and 2,4-bis(trichloromethyl)-6-(4'-methoxyphenyl)-triazole described in U.S. Patent No. 4,239,850, a combination of dialkylaminobenzoate and dimethylthioxanthone described in JP-A No. 57-23602, a combination of three kinds of compounds such as 4,4'-bis(dimethylamino)benzophenone, benzophenone and methyl polyhalide compound described in JP-A No. 59-78339 and the like.

Borate compounds other than the borate compound of the present invention can also be added as the other photopolymerization initiator as far as the effect of the present invention is not adversely affected.

Examples of such a borate compound include, for example, organoborate compounds described in JP-A Nos. 62-143044, 9-188685, 9-188686 and 9-188710, spectral sensitizing dye borate compound obtained from a cationic dyes or the like.

### Dye

A dye is preferably contained in the photopolymerizable composition of the present invention.

The dye is preferably a spectral sensitizing dye having a maximum absorption wavelength at 300-1000 nm. When the spectral sensitizing dyes is present together with the borate compound of the present invention, the resulting composition is efficiently sensitive to an exposure light source within a spectral absorption wavelength range. Therefore, the sensitivity is enhanced and generation of a radical can be controlled by using an arbitrary light source within an ultraviolet to infrared range.

When the borate compound of the present invention is the borate compound II, particularly a compound having both functions of a dye portion having a maximum absorption wavelength at 300-1000 nm in the structure and a borate portion, the aforementioned spectral sensitizing dye may not be used.

By using, as the spectral sensitizing dye, a dye selected arbitrarily from spectral sensitizing dyes within the above wavelength range for the purpose of controlling the sensitive wavelength so as to be suited for a light source used, high sensitivity can be obtained, and blue, green and red light sources or an infrared laser can be selected as the light source used for image exposure.

In cases where a color image is formed by using a multicolor recording material produced by laminating monochromatic recording layers capable of developing colors having different hues, even a recording material produced by laminating a plurality of layers can form an image wherein each layer (color) has high sensitivity and high sharpness, by including a spectral sensitizing dye having a different absorption wavelength in each monochromatic layer having a different hue and using a light source suited for the absorption wavelength. Thus, high sensitivity and high sharpness of the entire multicolor recording material can be attained.

As the spectral sensitizing dye, for example, a known cation dye, neutral dye or anion dye can be used.

Examples of the spectral sensitizing dye include those described in "Research Disclosure, Vol. 1. 200, December 1980, Item 20036" and "Sensitizer" (pages 160-163, Kodansha; edited by Katsumi TOKUMARU and Shin OGAWARA, 1987).

Specific examples thereof include 3-ketocoumarin compound described in JP-A No. 58-15603, thipyrilium salt described in JP-A No. 58-40302, naphthothiazole merocyanine compound described in JP-A Nos. 59-28328 and 60-53300, merocyanine compound described in JP-B Nos. 61-9621, 62-3842, JP-A Nos. 59-89303 and 60-60104 and the like.

Further examples include dyes described in "Chemistry of Functional Dyes" (1981, CMC Publishing Co., pages 393-416) and "Coloring Material" (60[4]212-224 (1987), and specific examples thereof include cationic dyes, cationic carbonium dyes, cationic quinoneimine dyes, cationic indoline dyes, cationic styryl dyes and the like.

The spectral sensitizing dye includes keto dyes such as coumarin (including ketocoumarin or sulfonocoumarin) dyes, oxonol dyes, hemioxonol dyes, etc.; non-keto dyes such as non-keto polymethine dyes, triarylmethane dyes, xanthene dyes, anthracene dyes, rhodamine, dyes, acridine dyes, aniline dyes, azo dyes, etc.; non-ketopolymethine dyes such as azomethine dyes, cyanine dyes, carbocyanine dyes, dicarbocyanine dyes, tricarbocyanine dyes, tricarbocyanine dyes, hemicyanine dyes, styryl dyes, etc.; and quinoneimine dyes such as azine dyes, oxazine dyes, thiazine dyes, quinoline dyes, thiazole dyes, etc.

By appropriately using the spectral sensitizing pigment, spectral sensitivity of the photopolymerization initiator used in the photopolymerizable composition of the present invention within the ultraviolet to infrared range can be obtained.

Aforementioned various spectral sensitizing dyes may be used alone, or two or more kinds of them may also be used in combination.

A ratio of the amount of the spectral sensitizing dye to the borate compound of the present invention is very important with regards to obtaining high sensitivity and, when used as the recording material, sufficient discoloration property due to light irradiation in a fixing step.

In addition to the ratio of the spectral sensitizing dye to the borate compound (= 1:1 (molar ratio)), which is required for the photopolymerization reaction, the borate compound is preferably added in an amount required to sufficiently discolor the spectral sensitizing dye remaining in the layer so as to obtain sufficiently high sensitivity and discoloration performance.

A ratio of the spectral sensitizing dye to the borate compound is preferably used within a range from 1:1 to 1:50, more preferably from 1:1.2 to 1:30, and most preferably from 1:1.2 to 1:20. When the ratio of the spectral sensitizing dye to the borate compound exceeds 1:1, sufficient polymerization reactivity and discoloration performances are not obtained sometimes. On the other hand, when the ratio is smaller than 1:50, coating properties are lowered sometimes.

The total amount of the spectral sensitizing dye and borate compound is preferably from 0.1 to 25% by weight, more preferably from 0.1 to 20% by weight, and most preferably from 0.1 to 15% by weight, based on the amount of the radical-polymerizable compound used. When the amount is smaller than 0.1% by weight, the effect of the present invention is not obtained sometimes. On the other hand, when the amount exceeds 25% by weight, the storage stability is lowered and the coating properties are lowered, sometimes.

The amount of the spectral sensitizing dye is preferably from 0.1 to 5% by weight, and more preferably from 0.5 to 2% by weight, based on the total weight of the recording layer when using the photopolymerizable composition of the present invention as the recording layer of the recording material.

The spectral sensitizing dye and borate compound may be added to a coating solution for recording layer after mixing previously, or the spectral sensitizing dye and borate compound may also be added separately when preparing the coating solution for recording layer.

### Radical-polymerizable compound

A radical-polymerizable compound is preferably contained in the photopolymerizable composition of the present invention. The radical-polymerizable compound is contained for the purpose of imparting image durability and improving the sensitivity of the recording material after recording when using the photopolymerizable composition of the present invention as the recording material.

The radical-polymerizable compound, for example is preferably a compound having at least one ethylenically unsaturated bond in a chemical structure, said compound having a chemical structure such as monomer, prepolymer (dimer, trimer and oligomer thereof), a mixture thereof or a copolymer thereof.

Specific examples thereof include unsaturated carboxylic acid and a salt thereof, ester of aliphatic polyhydric alcohol compound and unsaturated carboxylic acid, amide of aliphatic polyhydic amine compound and unsaturated carboxylic acid and the like.

Specific examples of the unsaturated carboxylic acid include acrylic acid, methacrylic acid, itaconic acid, crotonic acid, isocrotonic acid, maleic acid and the like.

Specific examples of the unsaturated carboxylic acid include sodium and potassium salts of aforementioned unsaturated carboxylic acid.

Examples of the ester of the aliphatic polyhydric alcohol and unsaturated carboxylic acid include acrylate, methacrylate, itaconate, crotonate, isocrotonate and the like. These compounds are described in detail below.

Examples of the acrylate include ethylene glycol diacrylate, triethylene glycol triacrylate, 1,3-butanediol diacrylate, tetramethylene glycol diacrylate, propylene glycol diacrylate, trimethylolethane triacrylate, 1,4-cyclohexanediol diacrylate, pentaerythritol diacrylate, pentaerythritol triacrylate, pentaerythritol tetraacrylate, dipentaerythritol diacrylate, dipentaerythritol triacrylate, dipentaerythritol tetraacrylate, sorbitol triacrylate, sorbitol tetraacrylate, sorbitol pentaacrylate, sorbitol hexaacrylate, polyester acrylate oligomer and the like.

Examples of the methacrylate include tetramethylene glycol dimethacrylate, triethylene glycol dimethacrylate, trimethylolpropane trimethacrylate, trimethylolethane trimethacrylate, ethylene glycol dimethacrylate, 1,3-butanediol dimethacrylate, pentaerythritol dimethacrylate, dipentaerythritol dimethacrylate, sorbitol tetramethacrylate, bis-[p-(3-methacryloxy-2-hydroxypropoxy)phenyl]dimethylmethane, bis-[p-(3-acryloxyethoxy)phenyl]dimethylmethane and the like.

Examples of the itaconate include ethylene glycol diitaconate, propylene glycol diitaconate, 1,3-butanediol diitaconate, 1,4-butanediol diitaconate, tetramethylene glycol diitaconate, pentaerythritol diitaconate, sorbitol tetraitaconate and the like.

Examples of the crotonate include ethylene glycol dicrotonate, tetramethylene glycol dichrotonate, pentaerythritol dicrotonate, sorbitol tetracrotonate and the like.

Examples of the isocrotonate include ethylene glycol diisocrotonate, pentaerythritol diisocrotonate, sorbitol tetraisocrotonate and the like. Examples of the maleate include ethylene glycol dimaleate, triethylene glycol dimaleate, pentaerythritol dimaleate, sorbitol tetramaleate and the like.

These esters may be used alone, or two or more kinds of them may be used in combination.

Specific examples of the amide of the aliphatic polyhydric amine compound and unsaturated carboxylic acid include methylenebis-acrylamide, methylenebis-methacrylamide, 1,6-hexamethylenebis-acrylamide, 1,6-hexamethylenebis-methacrylamide, diethylenetriaminetrisacrylamide, xylenebisacrylamide, xylenebismethacrylamide and the like.

In addition to the aforementioned compounds, a vinylurethane compound having two or more polymerizable vinyl groups in one molecule described in JP-B No. 48-41708, wherein a vinyl monomer represented by the following general formula is added to a polyisocyanate compound having two or more kinds of isocyanate groups in one molecule, is included among the examples.

CH₂=C(R)COOCH₂CH(R)OH

wherein R represents H or CH₃.

A condensed compound of a polymer compound having a vinyl group or or vinylidene group, e.g. a polymer compound having a hydroxyl group, an amino group, an epoxy group, halogen atom or a sulfonyloxy group, and acrylic acid, methacrylic acid or a derivative thereof is included among the examples.

The aforementioned radical-polymerizable compounds may be used alone, or two or more kinds of them may also be used.

The amount of the radical-polymerizable compound contained in the photopolymerizable compound of the present invention is preferably from 10 to 50 parts by weight, based on 1 part by weight of the borate compound. When the amount is smaller than 10 parts by weight, the color density is lowered sometimes. On the other hand, when the amount is larger than 50 parts by weight, the storage stability is lowered sometimes.

### Other components

With regard to components other than the aforementioned components, reducing agents such as an oxygen scavenger or chain transfer agent of an active hydrogen donor, and other compounds capable of accelerating polymerization in a chain transfer manner can be added as an auxiliary.

Examples of the oxygen scavenger include phosphine, phosphonate, phosphite, primary silver salt or other compounds which can be easily oxidized by oxygen.

Specific examples include N-phenylglycine, trimethylbarbituric acid, N,N-dimethyl-2,6-diisopropylaniline, N,N,N-2,4,6-penthamethylaniline acid and the like. Furthermore, thiols, thioketones, trihaloemethyl compound, lophine dimer compound, iodonium salts, sulfonium salts, azinium salts, organic peroxide and azides are also useful as a polymerization accelerator.

The photopolymerizable composition of the present invention can be preferably used in the recording material of the present invention, which is described below. Since the photopolymerizable composition of the present invention contains the borate compound of the present invention, there can be obtained the recording material which has high sensitivity and excellent storage properties due to a steric protection effect even in cases where an acid-containing medium is also present.

### Recording material

The recording material of the present invention comprises a recording layer on a substrate, and further comprises other layer(s), if necessary.

### Recording layer

The recording layer contains the photopolymerizable composition of the present invention, a color developing component A, and a color developing component B capable of reacting with the color developing component A to color-develop the color developing component A, and further contains the other components, if necessary.

The terms "photopolymerizable composition" of the present invention used herein means a photopolymerizable composition containing the borate compound of the present invention, or a photopolymerizable composition containing at least the borate compound of the present invention, the dye and the radical-polymerizable compound.

That is, when the borate compound of the present invention is a spectral sensitizing dye borate compound (borate compound II) obtained from a cationic dye, a dye is not further contained. When the color developing component B is a compound having a polymerizable group, the aforementioned radical-polymerizable compound may not be further contained and the color developing component B having the polymerizable group can be used as the radical-polymerizable compound.

### Color developing component A and color developing component B

Both of the color developing component A, and the color developing component B capable of reacting with the color developing component A to develop a color, are substantially colorless and have excellent transparency before treatment.

At least one of the color developing component A and the color developing component B is preferably contained in microcapsules in view of stability before recording, antifogging or durability of image, and preferably has a property of being able to develop color due to mutual contact after heating and/or applying pressure.

Preferred combinations of the two components (the color developing component A and the color developing component B) forming the recording layer includes the following combinations (a) to (r) (in the following examples, the former is the color developing component A while the latter is the color developing component B).
(a) a combination of an electron donative dye precursor and an electron acceptive compound
(b) a combination of a diazonium salt compound and a coupling component (hereinafter appropriately referred to as "coupler")
(c) a combination of an organic acid metal salt such as silver behenate, silver stearate, etc. and a reducing agent such as protocatechuic acid, spiroindan, hydroquinone, etc.
(d) a combination of a long-chain fatty acid iron salt such as ferric stearate, ferric myristate, etc. and phenols such as tannic acid, gallic acid, ammonium salicylate, etc.
(e) a combination of an organic acid heavy metal salt, such as nickel, cobalt, lead, copper, iron, mercury and silver salts of acetic acid, stearic acid, palmitic acid, etc. and an alkali metal or alkali earth metal sulfate, such as calcium sulfide, strontium sulfide, potassium sulfide, etc. and combination of an organic acid heavy metal salt and an organocheleting agent such as s-diphenylcarbazide, diphenylcarbazone, etc.
(f) a combination of a heavy metal sulfate such as sulfates of silver, lead, mercury, sodium, etc. and a sulfur compound such as sodium tetrathionate, sodium thiosulfate, thiourea, etc.
(g) a combination of an aliphatic ferric salt such as ferric stearate, etc. and an aromatic polyhydroxy compound such as 3,4-hydroxytetraphenylmethane, etc.
(h) a combination of an organic acid metal salt such as silver oxalate, mercury oxalate, etc. and an organopolyhydroxy compound such as polyhydroxyalcohol, glycerin, glycol, etc.
(i) a combination of an aliphatic ferric salt such as ferric pelargonate, ferric laurate, etc. and a thiocesylcarbamide or isothiocesylcarbamide derivative
(j) a combination of an organic acid lead salt such as lead caproate, lead pelargonate, lead behenate, etc. and a thiourea derivative such as ethylenethiourea, N-dodecylthiourea, etc.
(k) a combination of a higher aliphatic heavy metal salt such as ferric stearate, copper stearate, etc. and zinc dialkylthiocarbamate
(l) a combination capable of forming oxazine dye, such as a combination of resorcin and a nitroso compound
(m) a combination of a formazane compound and reducing agent and/or metal salt
(n) a combination of a protected dye (or leuco dye) precursor and deblocking agent
(o) a combination of an oxidation type color developer and an oxidizing agent
(p) a combination of phthalonitriles and diiminoisoindolines (combination capable of forming phthalocyanine)
(q) a combination of isocyanates and diiminoisoindolines (combination capable of forming coloring dyes)
(r) a combination of pigment precursor and acid or base (combination capable of forming pigment) and the like

Among these, (a) the combination of the electron donative dye precursor and the electron acceptive compound, (b) the combination of the diazonium salt compound and coupling component, (c) the combination of the organic acid metal salt and the reducing agent, or (n) the combination of the protected dye (or the leuco dye) precursor and the deblocking agent is preferably used as the combination of the two components, the color developing component (A) and the color developing component (B), which form the aforementioned recording layer.

The combinations (a), (b) and (c) of the aforementioned composition, which are preferably contained in aforementioned recording layer, are described in detail below.

### (a) the combination of the electron donative dye precursor and the electron acceptive compound

The electron donative dye precursor used preferably in the present invention is not particularly limited so long as it is substantially colorless. However, preferable examples include those with a property of donating electrons or accepting protons such as an acid to develop color, and preferred examples thereof include a phthalide compound, fluoran compound, thiazine compound, leucoauramine compound, rhodaminelactam compound, spiropyran compound, pyridine compound, pyrazine compounds, fluorene compound and the like.

Examples of the phthalide compound include compounds described in U.S. Reissued Patent No. 23,024, U.S. Patent Nos. 3,491,111, 3,491,112, 3,491,116, 3,491,112, 3,491,116 and 3,509,174. Specific examples thereof include 3,3-bis(p-dimethylaminophenyl)-6-dimethylaminophthalide, 3,3-bis(p-dimethylaminophenyl)phthalide, 3-(p-diethylaminophenyl)-3-(1-ethyl-2-methylindol-3-yl)-4-azaphthalide, 3,3-bis(1-octyl-2-methylindol-3-yl)phthalide and the like.

Examples of the fluoran compound include compounds described in U.S. Patent Nos. 3,624,107, 3,627,6787, 3,641,011, 3,462,107, 3,627,787, 3,641,011, 3,462,828, 3,681,390, 3,920,510 and 3,959,571. Specific examples thereof include 2-(benzylamino)fluoran, 2-anilino-3-methyl-6-diethylaminofluoran, 2-anilino-3-methyl-6-dibutylaminofluoran, 2-anilino-3-methyl-6-N-ethyl-N-isoamylaminofluoran, 2-anilino-3-methyl-6-N-methyl-N-cyclohexylaminofluoran, 2-anilino-3-chlor-6-diethylaminofluoran, 2-anilino-3-methyl-6-N-ethyl-N-isobutylaminofluoran, 2-anilino-6-dibutylaminofluoran, 2-anilino-3-methyl-6-N-methyl-N-tetrahydrofurfurylaminofluoran, 2-anilino-3-methyl-6-piperidinoaminofluoran, 2-(o-chloroanilino)-6-diethylaminofluoran, 2-(3,4-dichloranilino)-6-diethylaminofluoran and the like.

Examples of the thiazine-based compound include benzoylleucomethyleneblue, p-nitrobenzylleucomethyleneblue and the like.

Examples of the leucoauramine compound include 4,4'-bis-dimethylaminobenzhydrin benzyl ether, N-halophenyl-leucoauramine, N-2,4,5-trichloroleucoauramine and the like.

Examples of the rhodaminelactam compound include rhodamine-B-anilinolactam, rhodamine-(p-nitrile)lactam and the like.

Examples of the spiropyran compound include compounds described in U.S. Patent No. 3,971,808, and specific examples thereof include 3-methyl-spiro-dinaphthopyran, 3-ethyl-spiro-dinaphthopyran 3,3'-dichloro-spiro-dinaphthopyran, 3-benzylspiro-dinaphthopyran, 3-methyl-naphtho-(3-methioxy-benzo)spiropyran, 3-propyl-spiro-dibenzopyran and the like.

Examples of the pyridine compound and pyrazine compounds include compounds described in U.S. Patent Nos 3,775,424, 3,853,869 and 4,246,318.

Examples of the fluorene compound include compounds described in JP-A No. 61-240989.

The amount of the electron donative dye precursor contained in the recording layer is preferably from 0.1 to 5 g/m², and more preferably from 0.1 to 3 g/m². When the amount is smaller than 0.1 g/m², the color density becomes insufficient sometimes. On the other hand, when the amount exceeds 5 g/m², the coatability is lowered sometimes.

When using electron donative dye precursors each of which develops a color of a hue such as cyan, magenta or yellow as the electron donative dye precursor, the recording material of the present invention can be used as a full-color recording material.

As the cyan, magenta and yellow color developing dyes, those described in U.S. Patent No. 4,800,149 can be used.

As the electron donative dye precursor for yellow color development, those described in U.S. Patent No. 4,800,148 can be used. As the electron donative dye precursor for cyan color development, those described in JP-A No. 63-535342 can be used.

Preferred examples of the electron acceptive compound capable of reacting with the electron donative dye precursor to develop color include hydroxybenzoic acid, ester compound, phenol derivative, salicylic acid derivative, metal salt of aromatic carboxylic acid, acid clay, bentonite, novolak resin, metal-treated novolak, metal complex and the like.

Specific examples thereof include those described in JP-A Nos. 4-226455, 63-173682, 59-83693, 60-141587, 62-99190, European Patent No. 29323, in JP-A Nos. 62-167077, 62-16708, 63-317558, JP-BNos. 40-9309 and 45-14039, JP-ANos. 52-140483, 48-51510, 57-210886, 58-87089, 59-11286, 60-176795 and 61-95988. The electron acceptive compound may have a polymerizable group.

The electron acceptive compound is preferably used in an amount within a range from 0.1 to 30 parts by weight, and more preferably from 0.5 to 15 parts by weight, based on 1 part by weight of the electron donative dye precursor used. When the amount is smaller than 0.1 parts by weight, the color density is insufficient sometimes. On the other hand, when the amount exceeds 30 parts by weight, the sensitivity is lowered and the coating properties are lowered, sometimes.

### (b) the combination of the diazonium salt compound and the coupler

The diazonium salt compound reacts with the coupler as a coupling component described below to develop color of a desired hue, and is a photodecomposable diazonium salt compound which is decomposed when exposed to light in a specific wavelength range before the reaction, whereby the compound has no color developing capability even if the coupling component is present.

The hue in this color developing system is decided by an azo dyes produced by reacting the diazonium salt compound with the coupler. Accordingly, since a maximum absorption wavelength (color developing hue) can be controlled by changing a chemical structure (position and type of substituent) of the diazonium salt compound or the coupler, any color hue can be obtained depending on the combination thereof.

Examples of the photodecomposable diazonium salt compound used preferably in the present invention include an aromatic diazonium salt compound represented by the following formula:

Ar-N₂ ⁺X⁻

wherein Ar represents a substituted or non-substituted aryl group, and X⁻ represents an acid anion.

In the above formula, Ar represents a substituted or non-substituted aryl group. Examples of the substituent include an alkyl group, alkoxy group, alkylthio group, aryl group, aryloxy group, arylthio group, acyl group, alkoxycarbonyl group, carbamoyl group, carbamide group, sulfonyl group, sulfamoyl group, sulfonamide group, ureido group, amino group, heterocyclic group, cyano group, nitro group, halogen atom and the like, and these substituents may also be substituted.

Ar is preferably an aryl group having 6 to 30 carbon atoms and examples thereof include a phenyl group, 2-methylphenyl group, 2-chlorophenyl group, 2-methoxyphenyl group, 2-butoxyphenyl group, 2-(2-ethylhexyloxy)phenyl group, 2-octyloxyphenyl group, 3-(2,4-di-t-pentylphenoxyethoxy)phenyl group, 4-chlorophenyl group, 2,5-dichlorophenyl group, 2,4,6-trimethylphenyl group, 3-chlorophenyl group, 3-methylphenyl group, 3-methoxyphenyl group, 3-butoxyphenyl group, 3-cyanophenyl group, 3-(2-ethylhexyloxy)phenyl group, 3,4-dichlorophenyl group, 3,5-dichlorophenyl group, 3,4-dimethoxyphenyl group,
3-(dibutylaminocarbonylmethoxy)phenyl group, 4-cyanophenyl group, 4-methylphenyl group, 4-methoxyphenyl group, 4-butoxyphenyl group, 4-(2-ethylhexyloxy)phenyl group, 4-benzylphenyl group, 4-aminosulfonylphenyl group, 4-N,N-dibutylaminosulfonylphenyl group, 4-ethoxycarbonylphenyl group, 4-(2-ethylhexylcarbonyl)phenyl group, 4-fluorophenyl group, 3-acetylphenyl group, 2-acetylaminophenyl group, 4-(4-chlorophenylthio)phenyl group, 4-(4-methylphenyl)thio-2,5-butoxyphenyl group, 4-(N-benzyl-N-methylamino)-2-dodecyloxycarbonylphenyl group and the like.

These groups may also be substituted with an alkyloxy group, an alkylthio group, a substituted phenyl group, a cyano group, a substituted amino group, a heterocyclic group or a halogen atom.

The diazonium salt compound used preferably in the present invention preferably has 12 or more carbon atoms in the compound, solubility of 1% or less in water and solubility of 5% or more in ethyl acetate.

Specific examples of the diazonium salt compound used preferably in the recording material of the present invention are shown below but are not limited thereto.

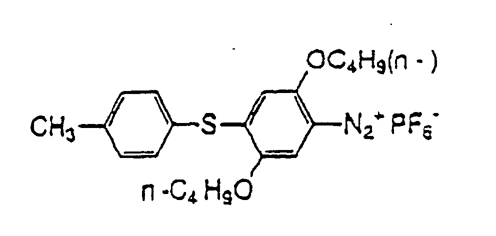

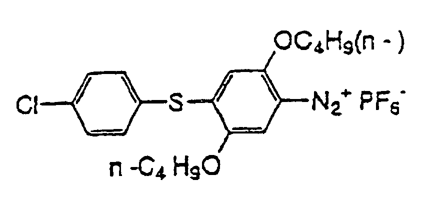

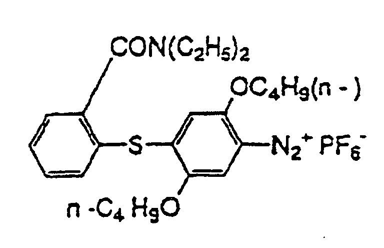

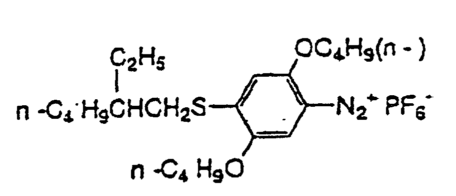

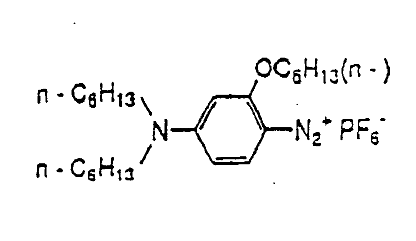

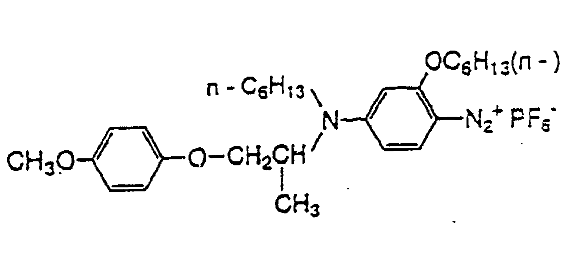

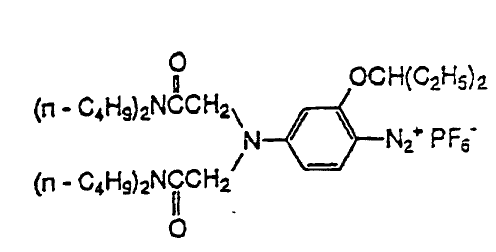

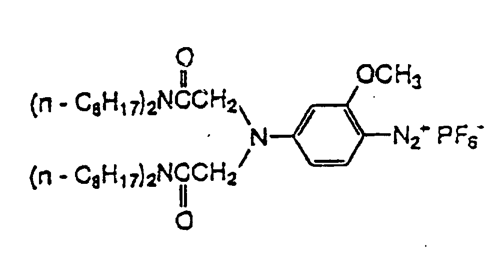

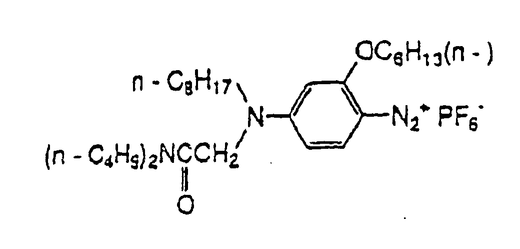

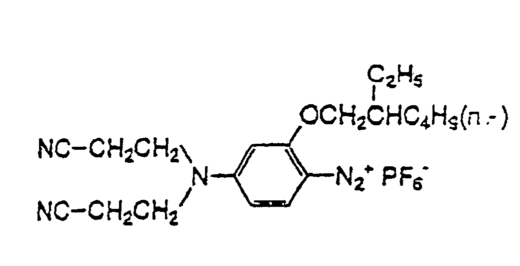

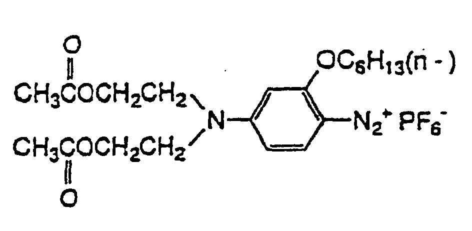

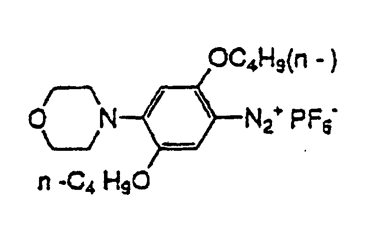

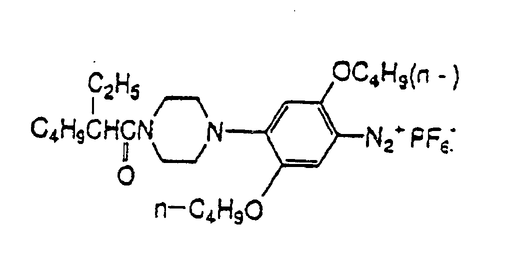

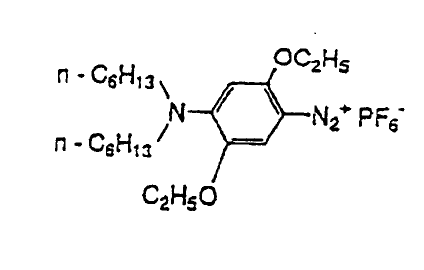

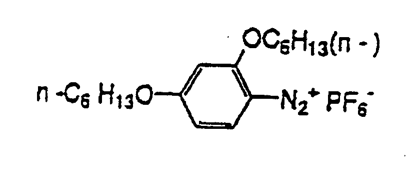

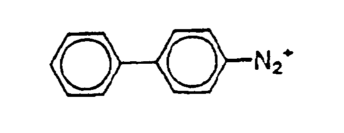

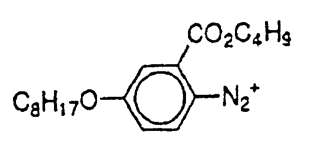

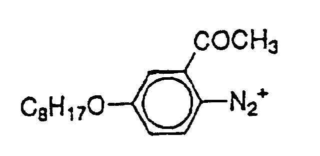

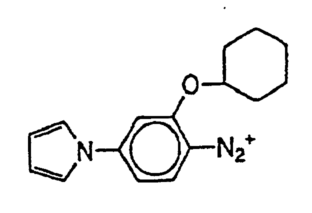

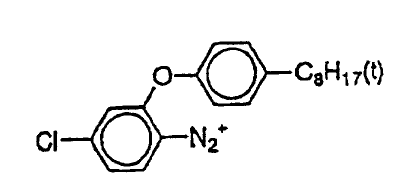

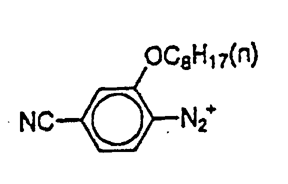

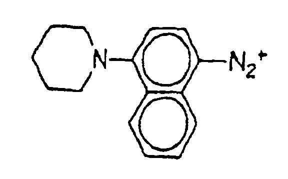

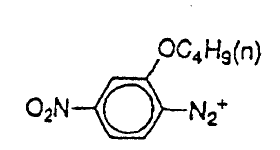

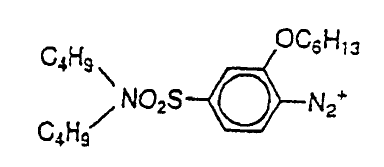

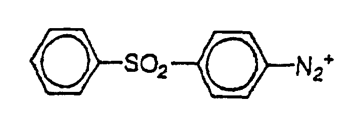

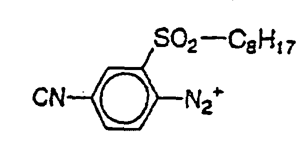

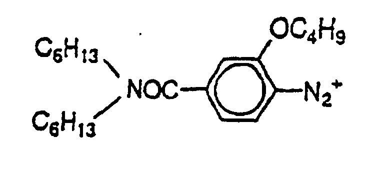

In the present invention, these diazonium salt compounds may also be used alone, or two or more kinds of them may also be used in combination depending on various purposes such as controlling the hue.

The diazonium salt compound is preferably contained in the recording layer in an amount within a range from 0.01 to 3 g/m², and more preferably from 0.02 to 1.0 g/m². When the amount is smaller than 0.01 g/m², a sufficient color developing property can not be obtained. On the other hand, when the amount exceeds 3 g/m², the sensitivity is lowered and the fixing time must be increased, which is not preferred.

As the coupler engaging in the coupling reaction with the diazonium salt compound, any of those capable of coupling with the diazonium salt compound in basic and/or neutral environments to form a dye can be used. These couplers can be used alone, or two or more kinds of them can be used in combination.

The couplers are described in Research Disclosure, No. 17643, VII-C to G and Research Disclosure, No. 307105, VII-C to G. Non-diffusing couplers having a hydrophobic group referred to as a ballast group and polymerized couplers are preferred.

Among the couplers used preferably in the present invention, the cyan coupler may be a naphthol coupler, phenol coupler or the like and specific examples thereof include couplers described in U.S. Patent Nos. 2,369,929, 2,772,162, 2,801,171, 2,895,826, 3,446,622, 3,758,308, 3,772,002, 4,052,212, 4,126,396, 4,146,396, 4,228,233, 4,254,212, 4,296,199, 4,296,200, 4,327,173, 4,333,999, 4,334,011, 4,343,011, 4,427,767, 4,451,559, 4,690,889 and 4,775,616, West German Patent No. 3,329,729, specifications of European Patent Nos. 121,365A and 249,453A, and JP-A No. 61-42,658.

Examples of the magenta coupler include imidazole[1,2-b]pyrazoles described in U.S. Patent No. 4,500,630, pyrazolo[1,5-b][1,2,4]triazoles described in U.S. Patent No. 4,540,654 and the like.

Examples of the magenta coupler further include a pyrazolotriazole coupler wherein a branched alkyl group is directly linked at the 2-position, 3-position or 6-position of a pyrazolotriazole ring as described in JP-A No. 61-65245, a pyrazoloazole coupler having a sulfonamide group in a molecule as described in JP-A No. 61-65,246, a pyrazoloazole coupler having an alkoxyphenylsulfonamide ballast group in a molecule as described in JP-A No. 61-147254, a pyrazolotriazole coupler having an alkoxy or aryloxy group at the 6-position as described in European Patent Application Laid-Open Nos. 226849A and 294785A, and couplers described in U.S. Patent Nos. 3,061,432, 3,725,067, 4,310,619, 4,351,897 and 4,556,630, European Patent No. 73,636, JP-A Nos. 55-118034, 60-35730, 60-43659, 60-185951 and 61-72238, and International Publication WO88/04795, Research Disclosure Nos. 24220 and 24230.

Examples of the yellow coupler include couplers described in U.S. Patent Nos. 3,933,501, 3,973,968, 4,022,620, 4,248,961, 4,314,023, 4,326,024, 4,401,752 and 4,511,649, European Patent No. 24,9473A, JP-B No. 58-10739 and British Patent Nos. 1,425,020 and 1,476,760.

Typical examples of the polymerized dyes-forming coupler are described in U.S. Patent Nos. 3,451,820, 4,080,211, 4,367,282, 4,409,320 and 4,576,910, European Patent No. 34,1188A and British Patent No. 2,102,137.

A so-called methylene compound having a methylene group adjacent to a carbonyl group can also be included.

In addition, those described in Japanese Patent Application Nos. 9-260336 and 9-271395 can also be included and can be appropriately selected within the range corresponding to the object of the present invention. The coupler may also have a polymerizable group.

Details are described in JP-A Nos. 4-201483, 7-223367, 7-223368, 7-323660, 5-278608, 5-297024, 6-18669, 6-18670 and 7-316280. Those described in Japanese Patent Application Nos. 8-027095, 8-02796, 8-030799, 8-12610, 8-132394, 8-358755, 8-358756 and 9-069990, which were previously filed by the present applicant, can also be used as references.

The coupler is preferably added in the recording layer in an amount within a range from 0.02 to 5 g/m², and more preferably from 0.1 to 4 g/m², in view of the effect. When the amount is smaller than 0.02 g/m², the color developing property is lowered sometimes. On the other hand, when the amount exceeds 5 g/m², the coating properties are lowered sometimes.

The coupler compound is preferably used in an amount within a range from 0.1 to 20 parts by weight, and more preferably from 1 to 10 parts by weight, based on 1 part by weight of the diazonium salt compound. When the amount is smaller than 0.1 part by weight, a sufficient color developing property can not be obtained. On the other hand, when the amount exceeds 20 parts by weight, the coating properties are lowered, which is not preferred.

The coupler compound can also be used by adding a water-soluble polymer, together with the other components, and dispersing solids using a sand mill. The method of dispersing or emulsifying a solid is not specifically limited, and a conventionally known method can be used. Details of these methods are described in JP-A No. 59-190886, 2-141279 and 7-17145.

In the present invention, if necessary, organic bases such as tertiary amines, piperidines, piperazines, amidines, formamidines, pyridines, guanidines, morpholines and the like can be used for the purpose of accelerating the coupling reaction.

Examples of these organic bases include piperazines such as N,N'-bis(3-phenoxy-2-hydroxypropyl)piperazine, N,N'-bis[3-(p-methylphenoxy)-2-hydroxypropyl]piperazine, N,N'-bis[3-(p-methoxyphenoxy)-2-hydroxypropyl]piperazine, N,N'-bis[3-(phenylthio-2-hydroxypropyl)piperazine, N,N'-bis[3-(β-naphthoxy)-2-hydroxypropyl]piperazine, N-3-bis(β-naphthoxy)-2-hydroxypropyl-N'-methylpiperazine, 1,4-bis{[3-(N-methylpiperadino)-2-hydroxy]propyloxy}benzene, etc.; morpholines such as N-[3-(β-naphthoxy)-2-hydroxy]propylmorpholine, 1,4-bis[3-(morpholino-2-hydroxy)propyloxy]benzene, 1,3-bis[3-(morpholino-2-hydroxy)propyloxy]benzene, etc.; piperidines such as N-(3-phenoxy-2-hydroxypropyl)piperidine, N-dodecylpiperidine, etc.; triphenylguanidine, 4-hydroxybenzoic acid 2-N-methyl-N-benzylaminoethyl ester, 4-hydroxybenzoic acid 2-N,N-di-n-butylaminoethyl ester, 4-(3-N,N-dibutylaminopropoxy)benzenesulfonamide, 4-(2-N,N-dibutylaminoethoxycarbonyl)phenoxyacetamide, etc.

These organic bases may be used alone, or two or more kinds of them may also be used in combination.

These organic bases are described in JP-A Nos. 57-123086, 60-49991 and 60-94381, and Japanese Patent Application Nos. 7-228731, 7-235157 and 7-235158.

An amount of the organic base used is not specifically limited, but the organic base is preferably used in the amount within a range from 1 to 30 mol per mol of the diazonium salt.

An auxiliary color developer can also be added for the purpose of accelerating the color developing reaction.

Examples of the auxiliary color developer include a phenol derivative, naphthol derivative, alkoxy-substituted benzene, alkoxy-substituted naphthalene, hydroxy compound, carbonamide compound, sulfonamide compound and the like.

It is considered that high color density is obtained because these compounds have an action of reducing a melting point of the coupler compound or basic substance or improving heat transmission of the microcapsule wall. (c) The combination of the organometal salt and the reducing agent

Specific examples of the organometal salt include a silver salt of long-chain aliphatic carboxylic acid, such as silver laurate, silver myristate, silver palmitate, silver stearate, silver arachate, silver behenate, etc.; silver salt of organic compound having an imino group, such as benzotriazole silver salt, benzimidazole silver salt, carbazole silver salt, phthalazinone silver salt, etc.; silver salt of sulfur-containing compound, such as s-alkylthio glycolate, etc.; silver salt of aromatic carboxylic acid, such as silver benzoate, silver phthalate, etc.; silver salt of silver sulfonate, such as silver ethanesulfonate, etc.; silver salt of silver sulfinate, such as silver o-toluenesulfinate, etc.; silver salt of phosphoric acid, such as silver phenylphosphate, etc.; silver barbiturate; silver saccharate; silver salt of salicylaldoxime; or an any mixture thereof.

Among these, long-chain aliphatic silver carboxylate is preferred and silver behenate is more preferred. Behenic acid may also be used in combination with silver behenate.

The reducing agent can be appropriately used based on the description of JP-ANo. 53-1020, page 227, lower left column, line 14 to page 229, upper right column, line 1. It is preferred to use mono-, bis-, tris- or tetrakisphenols, mono- or bisnaphthols, di- or polyhydroxynaphthalenes, di- or polyhydroxybenzenes, hydroxymonoethers, ascorbic acid, 3-pyrazolidones, pyrazolines, pyrazolones, reducing sugars, phenylenediamines, hydroxylamines, reductons, hydroxamines, hydrazides, amidoximes, N-hydroxyureas or the like.

Among these, aromatic reducing agents such as polyphenols, sulfonamidephenols, naphthols and the like are particularly preferred.

To ensure sufficient transparency of the recording material, (a) the combination of the electron donative dye precursor and the electron acceptive compound and (b) the combination of the diazonium compound and the coupler are preferably used.

### Encapsulation

The method of encapsulating the aforementioned color developing component A or the color developing component B will be described. As the encapsulation method, a conventionally known method can be used.

Examples thereof include methods of utilizing coacervation of a hydrophilic wall forming material described in U.S. Patent Nos. 2,800,457 and 2,800,458, interfacial polymerization methods described in U.S. Patent No. 3,287,154, British Patent No. 990,443, JP-B Nos. 38-19574, 42-446 and 42-771, methods by deposition of a polymer described in U.S. Patent Nos. 3,418,250 and 3,660,304, method using an isocyanate polyol wall material described in U.S. Patent No. 3,796,669, method using an isocyanate polyol wall material described in U.S. Patent No. 33,914,451, methods using urea-formaldehyde and urea formaldehyde-resorcinol wall forming materials described in U.S. Patent Nos. 4,001,140, 4,087,376 and 4,089,802, methods using wall forming material such as metalmine-formaldehyde resin, hydroxypropylcellulose, etc. described in U.S. Patent No. 4,925,455, in situ methods by polymerization of a monomer described in JP-B No. 36-9168 and JP-A No. 51-9076, electrolytic dispersion cooling method described in British Patent Nos. 952,807 and 965,074, spray-drying methods described in U.S. Patent Nos. 3,111,407 and British Patent No. 930,422 and the like.

The encapsulation method is not limited thereto. In the present invention, it is particularly preferred to use an interfacial polymerization method of mixing an oil phase, which is prepared by dissolving or dispersing the color developing component A in a hydrophobic organic solvent as the core of the capsule, with an aqueous phase which is prepared by dissolving a water-soluble polymer, emulsifying and dispersing the mixture using means such as a homogenizer, and heating to cause a polymer forming reaction at an oil droplet interface, resulting in formation of a microcapsule wall of a polymer substance.

That is, capsules having a uniform particle diameter can be formed in a short time, thereby making it possible to obtain a recording material having an excellent storage property.

The reactant capable of forming a polymer is added in the interior and/or exterior of the oil droplets. Specific examples of the polymer substance include polyurethane, polyurea, polyamide, polyester, polycarbonate, urea-formaldehyde resin, melamine resin, polystyrene, styrene-methacrylate copolymer, styrene-acrylate copolymer and the like. Among these, polyurethane, polyurea, polyamide, polyester and polycarbonate are preferred, and polyurethane and polyurea are particularly preferred. The aforementioned polymer substances can also be used in combination.

Examples of the water-soluble polymer include gelatin, polyvinyl pyrrolidone, polyvinyl alcohol and the like.

When using polyurethane as the capsule wall material, the microcapsule wall can be formed by incorporating a polyhydric isocyanate and a second substance (e.g. polyol, polyamine, etc.) capable of reacting with the polyhydric isocyanate into an aqueous water-soluble polymer solution ( aqueous phase) or an oily medium (oil phase) to be encapsulated, emulsifying and dispersing the mixture and then heating the result to cause a polymer forming reaction at an oil droplet interface.

As the polyhydric isocyanate, and the polyol and polyamine, which are reacted with the polyhydric isocyanate, those described in U.S. Patent Nos. 3,281,383, 3,773,695 and 3,792,268, JP-BNos. 48-40347, 49-24159, 48-80191 and 48-84086 can be used.

In the present invention, in cases where microcapsules containing the color developing component A is prepared, the color developing component included therein may also be present in a state of a solution or a solid in the capsules.

When the color developing component A is included in the state of a solution in the capsules, the color developing component A may be encapsulated in the state of being dissolved in a solvent. In this case, the solvent is preferably used in an amount within a range from 1 to 500 parts by weight based on 100 parts by weight of the color developing component A.

When the solubility of the color developing component A to be encapsulated in the solvent is poor, a low boiling solvent having high solubility can also be used in combination. Examples of the low boiling solvent include ethyl acetate, propyl acetate, isopropyl acetate, butyl acetate, methylene chloride and the like.

As the aqueous phase, an aqueous solution prepared by dissolving a water-soluble polymer is used. After the oil phase is introduced in the aqueous solution, the mixture is emulsified and dispersed by using means such as a homogenizer. The water-soluble polymer serves as a dispersion medium capable of making the dispersion homogeneous and easy and of stabilizing the emulsified and dispersed aqueous solution. To emulsify and disperse the mixture more homogeneously and to stabilize the mixture, a surfactant may also be added to at least one of the oil phase and the aqueous phase. As the surfactant, a known surfactant for emulsification can be used. The amount of the surfactant added is preferably from 0.1 to 5% by weight, and more preferably from 0.5 to 2% by weight, based on the weight of the oil phase.

As the surfactant to be contained in the aqueous phase, those that do not cause precipitation or agglomeration due to reaction with a protective colloid can be favorably selected and used by preferable selection.

Preferred examples of the surfactant include, for example, sodium alkylbenzenesulfonate, sodium alkyl sulfate, dioctyl sodium sulfossucinate, polyalkylene glycol (e.g., polyoxyethylene nonyl phenyl ether) and the like.

As mentioned above, the water-soluble polymer to be contained as the protective colloid in the aqueous phase mixed with the oil phase can be appropriately selected from known anionic polymers, nonionic polymers and amphoteric polymers.

As the anionic polymer, any of natural and synthetic polymers can be used, and examples thereof include those having a group of -COO-, -SO₂- or the like.

Specific examples thereof include natural polymers such as gum arabic, arginic acid, pectin, and the like; semisynthetic polymers such as carboxymethylcellulose, gelatin derivative (e.g. phthalated gelatin, and the like), sulfated starch, sulfated cellulose, sulfonic acid lignin, and the like; and synthetic polymers such as maleic anhydride (including hydrolyzate) copolymer, acrylic (methacrylic) polymer and copolymer, vinylbenzenesulonic polymer and copolymer, carboxy-modified polyvinyl alcohol, and the like.

Examples of the nonionic polymer include polyvinyl alcohol, hydroxyethylcellulose, methylcellulose and the like.

Examples of the amphoteric surfactant include gelatin and the like. Among these, gelatin, gelatin derivatives and polyvinyl alcohol are preferred.

The aforementioned water-soluble polymer is used as an aqueous solution of 0.01 to 10% by weight.

All components including the color developing component to be contained in the recording layer can also be used after solid-dispersing using means such as a sand mill, together with water-soluble polymers, sensitizers and other auxiliary color developing agents. However, it is more preferred to use these as an emulsified dispersion prepared by previously dissolving the components in a high boiling organic solvent, which is slightly soluble or insoluble in water, mixing the resulting solution with an aqueous polymer solution (aqueous phase) containing a surfactant and/or a water-soluble polymer as a protective colloid, and emulsifying the mixture using a homogenizer. In this case, a low boiling solvent can also be used as an auxiliary solubilizer, if necessary.

All components including the color developing component can also be emulsified and dispersed separately, or emulsified and dispersed after they are previously mixed and dissolved in a high boiling solvent. A preferred diameter of emulsified/dispersed particles is not more than 1 µm.

The oil phase, which contains the aforementioned components, the protective colloid and the aqueous phase containing a surfactant can be emulsified easily by using means ordinarily used for emulsification such as high speed stirring, ultrasonic dispersion, and the like, into fine particles, for example, known emulsification apparatuses such as a homogenizer, mantongory, ultrasonic dispersion machine, dissolver, Keddy mill or the like.

After emulsification, the emulsified material is heated to 30-70°C to accelerate the capsule wall forming reaction. During the reaction, it is necessary to reduce probability of collision of the capsules by adding of water and to stir sufficiently, so as to prevent agglomeration of the capsules.

A dispersed material for preventing agglomeration may also be added during the reaction. With the progress of the polymerization reaction, generation of a carbon dioxide gas is observed and termination of the generation can be regarded as an end point of the capsule wall forming reaction. Microcapsules including a desired dye therein can be usually obtained by reacting for several hours.

An average particle diameter of the microcapsules used in the recording material of the present invention is preferably not more than 20 µm, and more preferably not more than 5 µm in view of obtaining high resolution. When the formed microcapsule is too small, surface area to a fixed solid content increases and, therefore, a large amount of a wall material is required. Thus, the average particle diameter is preferably not less than 0.1 µm.

### Other components

As other components, the recording layer can contain the following known antioxidants for the purpose of improving fastness of the image against light and heat or reducing yellowing due to light after fixing.

Examples of the antioxidant include those described in European Patent Nos. 223739A, 309401A, 309402A, 310551A, 310552A and 459416A, Germany Patent No. 3435443A, JP-A Nos. 54-48535, 62-262047, 63-113536, 63-163351, 2-262654, 2-71262, 3-121449, 5-61166 and 5-119449, U.S. Patent Nos. 4,814,262 and 4,980,275.

The recording layer can also contain known various additives used conventionally in a thermal recording material or a pressure-sensitive recording material, as the other components.

Specific examples of these antioxidants include compounds described in JP-A Nos. 60-107384, 60-107383, 60-125470, 60-125471, 60-125472, 60-287485, 60-287486, 60-287487, 60-287488, 61-160287, 61-185483, 61-211079, 62-146678, 62-146680, 62-146679, 62-282885, 63-051174, 63-89877, 63-88380, 63-088381, 63-203372, 63-224989, 63-251282, 63-267594, 63-182484, 1-239282, 4-291685, 4-291684, 5-188687, 5-188686, 5-110490, 5-1108437 and 5-170361, JP-B Nos. 48-043294 and 48-033212.

Examples of the binder used in the recording layer include known water-soluble polymer compounds and latexes.

Examples of the water-soluble polymer compound include methylcellulose, carboxymethylcellulose, hydroxyethylcellulose, hydroxypropylcellulose, starch derivative, casein, gum arabic, gelatin, ethylene-maleic anhydride copolymer, styrene-maleic anhydride copolymer, polyvinyl alcohol, epichlorhydrin-modified polyamide, isobutylene-maleinsalycilic anhydride copolymer, polyacrylic acid, amide polyacrylate, and modified ones thereof. Examples of the latexes include styrene-butadiene rubber latex, methyl acrylate-butadiene rubber latex, vinyl acetate emulsion and the like.

The recording layer can contain known inorganic pigments as the other components.

Specific examples thereof include kaolin, calcined kaolin, talc, pagodite, diatomaceous earth, calcium carbonate, aluminum hydroxide, magnesium hydroxide, zinc oxide, lithopone, amorphous silica, colloidal silica, calcined gypsum, silica, magnesium carbonate, titanium oxide, alumina, barium carbonate, mica, microballoon, urea-formalin filler, polyester particle, cellulose filler and the like.

The recording layer can include various additives such as known waxes, antistatic agents, defoamers, conductive agents, fluorescent dyes, surfactants, ultraviolet absorbers and precursors thereof as the other components.

### Formation of recording layer

The recording layer is formed by coating the coating solution for recording layer on a substrate and drying the coating solution.

Examples of a solvent that can be used in the coating solution for recording layer, include: water; alcohol such as methanol, ethanol, n-propanol, isopropanol, n-butanol, sec-butanol, methylcellosolve, 1-methoxy-2-propanol, and the like; halogen solvent such as methylene chloride, ethylene chloride, and the like; ketones such as acetone, cyclohexanone, methyl ethyl ketone, and the like; ester such as methylcellosolve acetate, ethyl acetate, methyl acetate, and the like; toluene; xylene; or mixtures of two or more kinds of these. Among these, xylene is particularly preferred.

When the substrate is coated with the coating solution for recording layer, there can be used coaters such as a blade coater, rod coater, knife coater, roll doctor coater, reverse roll coater, transfer roll coater, gravure coater, kiss-roll coater, curtain coater, extrusion coater and the like.

The coating solution can be coated with reference to the coating method described in "Research Disclosure, Vol. 200" (December 1980, Item 20036, XV).

The film thickness of the recording layer is preferably from 0.1 to 50 µm, and more preferably from 5 to 35 µm.

### Substrate

As the substrate, any paper substrate used in a conventional pressure-sensitive paper, thermal paper, or dry or wet diazo copying paper can be used.

Specific examples thereof include acidic paper, neutral paper, coat paper, plastic film-laminated paper prepared by laminating plastic such as polyethylene on a paper, synthetic paper, plastic film made of polyethylene terephthalate or polyethylene naphthalate and the like. When using a transparent material as the substrate, it becomes possible to irradiate light from the substrate side of the recording material in a latent image forming step or fixing step.

The substrate may contain various additives such as fluorescent whiteners, dyes and the like.

### Other layers

### Protective layer:

In the recording material of the present invention, a protective layer as one of the other layer(s) may also be provided on the recording layer. As the protective layer, two or more layers may also be laminated, if necessary.

Examples of the materials used in the protective layer include a water-soluble polymer compound such as polyvinyl alcohol, carboxy-modified polyvinyl alcohol, vinyl acetate-acrylamide copolymer, silicon-modified polyvinyl alcohol, starch, modified starch, methylcellulose, carboxymethylcellulose, hydroxymethylcellulose, gelatin, gum arabic, casein, styrene-maleic acid copolymer hydrolyzate, isobutuylene-maleic anhydride copolymer hydrolyzate, polyacrylamide derivative, polyvinyl pyrrolidone, sodium polystyrene sulfonate, sodium arginate, and the like; and latexes such as styrene-butadiene rubber latex, acrylonitrile-butadiene rubber latex, methyl acrylate-butadiene rubber latex, vinyl acetate emulsion, and the like.

The storage stability can be further improved by crosslinking the water-soluble polymer compound of the protective layer, and known crosslinking agents can be used as the crosslinking agent.

Specific examples thereof include a water-soluble initial condensate such as N-methylolurea, N-methylolmelamine, urea-formalin, and the like; dialdehyde compounds such as glyoxal, glutaraldehyde, and the like; inorganic crosslinking agent such as boric acid, borax, and the like; and polyamide epichlorhydrin.

The protective layer may also be cured by electrons. The protective layer may also contain known dyes, metal soaps, waxes, surfactants, fluorescent whiteners, ultraviolet absorbers or the like.

The amount of the protective layer coated is preferably from 0.2 to 5 g/m², and more preferably from 0.5 to 2 g/m². The film thickness is preferably from 0.2 to 5 µm, and more preferably from 0.5 to 2 µm.

### Back coat layer

In the recording material of the present invention, a back coat layer as one of the other layer(s) may be provided so as to correct curl balance of the substrate or to prevent penetration of chemicals from the back surface.

The back coat layer can also be provided in the same manner as in the case of the protective layer, and can also be provided on the back surface in the form of a label; i.e., by using in combination with a release paper and via an adhesive layer.

### Intermediate layer

In the recording material of the present invention, when laminating on the substrate a plurality of recording layers each having a different hue, an intermediate layer containing optionally a filter dye can also be provided between the respective monochromatic recording layers forming the recording layer.

The intermediate layer comprises mainly a binder, and can optionally contain additives such as curing agents, polymer latexes, micas, ultraviolet absorbers and the like. When using the color filter, it can be used after being by selected from the aforementioned spectral sensitizing dyes. It is preferred to use a compound having the same light absorption wavelength as that of the spectral sensitizing dye of each upper side of the intermediate layer because a clear image can be thereby formed.

The filter dye can be added in a desired layer, particularly intermediate layer, after emulsifying and dispersing by an oil-in-water dispersion method or a polymer dispersion method.

According to the oil-in-water dispersion method, the filter dye is dissolved in any one of a high boiling solvent having a boiling point of not less than 175°C and a low boiling solvent having a boiling point of 30-160°C or a mixed solution of both solutions, and then the resulting solution is finely dispersed in an aqueous solvent such as water, aqueous gelatin solution, aqueous polyvinyl alcohol solution or the like, in the presence of a surfactant.

The high boiling solvent includes, for example, solvents described in U.S. Patent No. 2,322,027. The high boiling solvent and auxiliary solvent may be the same solvent as that used in the production of the microcapsules.

Dispersion may be accompanied with phase inversion and the solution may be used for coating after removing or reducing the auxiliary solvent by distillation, nudel water-washing, ultrafiltration or the like.

Specific examples of the latex used in steps of the polymer dispersion method, curing and impregnation are described in U.S. Patent No. 4,199,383, West German Patent Application (OLS) Nos. 2,541,274 and 2,541,230, JP-A Nos. 49-74538, 51-59943 and 54-32552, and "Research Disclosure, Vol. 148" (August 1976, Item 14850).

Preferred examples of the latex include acrylate or methacrylate, such as ethyl acrylate, n-butyl acrylate, n-butyl methacrylate, 2-acetacetoxyethyl methacrylate, and the like; and copolymer latex of acid monomer, such as acrylic acid, 2-acrylamide-2-methylpropanesulfonic acid, and the like.

### Anti-halation layer

It is also possible to provide a layer containing a polymer capable of reducing oxygen permeability, e.g., gelatin, PVA, and the like, between the substrate and the recording layer. It becomes possible to prevent photo-oxidative discoloration of the image by forming such a layer.

Furthermore, it is possible to provide a so-called anti-halation layer between the substrate and the recording layer, or to provide the anti-halation layer at the opposite side of the recording layer in the case of a transparent substrate. In this case as well, an anti-halation layer capable of being bleached with light or heat is preferred in view of an improvement in whiteness of the unexposed portion. When bleaching with light, for example, a combination of dye and a boron compound can be used. When bleaching with heat, for example, a system of bleaching a color-developed dye using a base or a nucleophilic agent can be utilized.

When using the recording material of the present invention as a full-color recording material, plural recording layers having different hues are laminated on the substrate and each recording layer contain microcapsules containing the color developing component A capable of developing a color having a different hue, and the color developing component B, but these components may also be contained in a single layer (as a matter of course, the component contained in the capsules and the other component may also be replaced with each other). When these recording materials are irradiated with light, a multi-color image is formed by photosensitization due to differences in light source wavelength.

When using a plurality of photopolymerization initiators having different absorption wavelengths, a latent image corresponding to light having different wavelengths is formed. Accordingly, by using the color developing components capable of developing different hues (e.g. yellow, magenta, and cyan) corresponding to the absorption wavelengths (may also be the same color, complementary colors or another color relation), a multi-color recording material, particularly, a full-color recording material can be produced. A corresponding photopolymerization initiator and color developing component may also be contained separately in each layer to cause color separation, or may also be contained in a single layer. When contained in the single layer, the both are preferably included in the microcapsules. When contained in the single layer, a multi-color recording material, particularly, a full-color recording material can be produced in a simple manner.

### Image recording method

The recording material of the present invention can be used in a conventionally known image recording method.

A preferred image recording method using the recording material of the present invention will be described below.

The recording material of the present invention can form an image through the following steps; a latent image forming step of irradiating the recording layer with light, which is absorbed by the dye and is not absorbed by the borate compound represented by the aforementioned formula (I), in an image-like pattern, and polymerizing the polymerizable compound with a radical generated at a portion irradiated with light, to form a latent image; and an image visibilizing step of applying heat and/or pressure to the whole surface of the recording layer and reacting the color developing component A with the color developing component B to thereby make visible the latent image.

In the case of the recording material wherein the recording layer contains a plurality of organic dyes, a multi-color image can be easily obtained and a full-color image can be easily obtained by using organic dyes having three primary colors such as yellow, magenta and cyan as the hue. The absorption wavelength of the dyes, which can be selected on formation of the multi-color image, can be selected within a wide range from ultraviolet to near infrared and the resulting image exhibits little color mixture.

This image recording process will be described in detail.

In the latent image forming step, when the dye is irradiated with light, the dye is excited and a radical is generated from a borate compound by an interaction between the dye and borate compound. The polymerizable compound is polymerized by the radical. The polymerizable compound refers to the color developing component B having a polymerizable group, a capsule oil having a polymerizable group, and the radical-polymerizable compound which is present at the exterior of the capsules. These compounds or at least one of them are polymerized. On heating or pressurizing in the image visibilizing step, contact between the color developing component A and the color developing component B is prevented. That is, color of only the unexposed portion is developed by the contact between the color developing component A and the color developing component B.

The wavelength of a light source may be appropriately selected from a wide range from ultraviolet to near infrared according to the dye and the borate compound to be used. As the light source, for example, a semiconductor laser, LED, xenon light, fluorescent lamp or mercury lamp can be used. It is also possible to use a light source having two or more kinds of wavelengths according to the organic dye to be used.

Light is usually irradiated from the recording layer side of the recording material. When using a transparent substrate as the substrate of the recording material, light can also be irradiated from the face of the substrate side.

The amount of light for forming the latent image may be an amount sufficient to initiate the polymerization of the radical-polymerizable compound, and may be comparatively small. Accordingly, a large light capacity is not required for writing of the image and an inexpensive light source can be employed, and furthermore, image writing can be conducted at high speed.

Heat and/or pressure to be applied to the whole surface of the recording layer in the image visibilizing step may be selected under the conditions sufficient for the microcapsules to break, or for a substance to penetrate through the capsule walls. Specifically, the conditions of the temperature and/or pressure and time may be appropriately adjusted according to the material of the capsule wall of the microcapsules. The heating temperature is preferably from 50 to 250°C, and particularly preferably from 70 to 150°C. For cases where heat is applied to the whole surface of the recording layer, examples of a heat source that can be used for heating, include a heat roller, thermal head, heat stamp, near infrared rays (laser), infrared rays (laser) and the like. When applying pressure to the whole surface of the recording layer, examples of a pressurizing method include using a pressure roller, pressure pen or the like.

The image thus formed is preferably subjected to a fixing step of irradiating the whole surface of the recording layer with light. The dye used as the spectral sensitizing dye, which is originally present in the recording layer, is bleached by a radical from a borate compound as a result of exposure, to improve thereby the whiteness of the unexposed area (exposed portion in the latent image forming step). The polymerizable compound, which is not polymerized by light in the fixing step and remains, is also polymerized, thereby exerting the excellent effect of fixing the image more firmly.

At this time, light having any wavelength of 300 to 1000 nm may also be irradiated and lights having the absorption wavelengths of both the dye and the borate compound may also be irradiated. As a light source, for example, there can be used those used generally, such as a laser, xenon light, fluorescent lamp, mercury lamp or the like. As a matter of course, the light source used in this case is not for writing an image, but for irradiating the whole surface of the recording layer of the recording material. Therefore, even if those having high output are used, the cost does not become high and low cost and high speed can be realized.

### EXAMPLES

The following Examples further illustrate the present invention but are not to be construed to limit the scope thereof. In the following Examples, percentages are by weight unless otherwise stated.

### Example 1: Black color development

### Preparation of electron donative colorless dye-including microcapsule solution (I):

8.9 g of a black color-developing electron donative colorless dye (1) represented by the following structural formula was dissolved in 16.9 g of ethyl acetate, and then 20g of capsule wall material (trade name: Takenate D-110N, manufactured by Takeda Chemical Industries Co., Ltd.) and 2g of capsule wall material (trade name: Millionate MR200, manufactured by Nippon Polyurethane Industries Co., Ltd. ) were added.

The resulting solution was added to a mixed solution of 42 g of 8% phthalated gelatin and 1.4 g of a 10% sodium dodecylbenzenesulfonate solution, and then emulsified and dispersed at a temperature of 20°C to obtain an emulsion. To the resulting emulsion, 14 g of water and 72 g of an aqueous 2.9% tetraethylenepentamine solution were added. The mixed solution was heated to 60°C while stirring and allowed to stand for 2 hours to prepare an electron donative colorless dye-including microcapsule solution (I) having an average particle diameter of 0.5 µm, comprising the electron donative colorless dye (1) as a core.

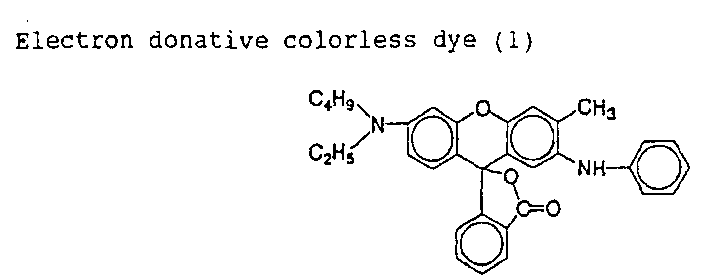

### Preparation of photopolymerizable composition emulsion (I):

A photopolymerizable composition emulsion (I) is composed of a borate compound-containing solution (A) and a dye-containing solution (B) described below.

### Preparation of borate compound-containing solution (A):

0.5 g of the borate compound (1-1) represented by aforementioned [Chemical Formula 19] and 2.5 g of tricresyl phosphate were dissolved in 4.5 g of isopropyl acetate (solubility in water: about 4.3%) and the resulting solution was added to a mixed solution of 7.8 g of an aqueous 15% gelatin solution, 0.4 g of an aqueous 10% solution of a surfactant (1) represented by the following structural formula and 3.7 g of water. Then, the mixed solution was emulsified at 10000 rpm using a homogenizer (manufactured by Nippon Seiki Co., Ltd.) to prepare a borate compound-containing solution (A).

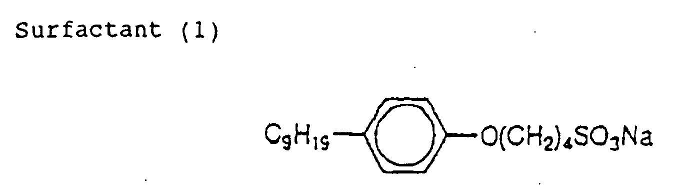

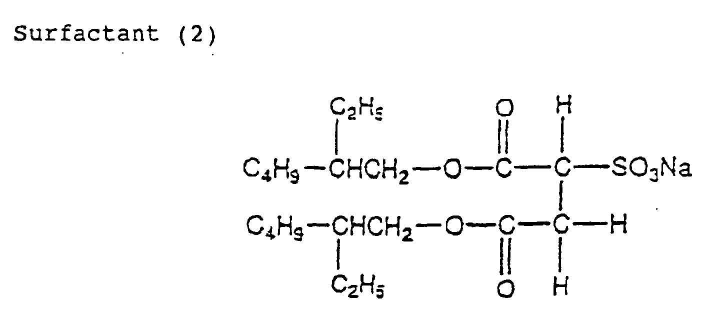

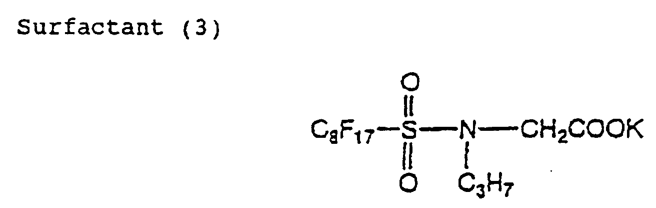

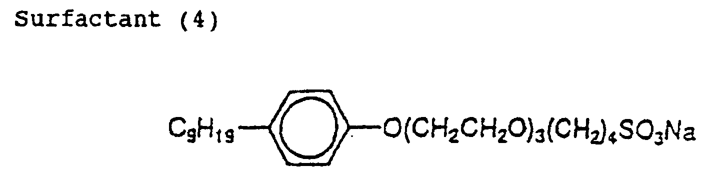

### Preparation of dye-containing solution (B):

To a mixed solution of 0.498 g of a spectral sensitizing dye (1) represented by the following structural formula, 0.498 g of an auxiliary (1) represented by the following structural formula used for enhancement of sensitivity, and 5.25 g of isopropyl acetate (solubility in water: about 4.3%), 83 g of an electron acceptive compound having a polymerizable group (1) represented by the following structural formula was added.

The resulting solution was added to a mixed solution of 109.1 g of an aqueous 15% gelatin solution, 0.8 g of an aqueous 2% solution of the surfactant (1) and 4.0 g of an aqueous 2% solution of a surfactant (2) represented by the aforementioned formula, and the mixed solution was emulsified for five minutes at 10000 rpm using a homogenizer (manufactured by Nippon Seiki Co., Ltd.) to prepare a dye-containing solution (B).

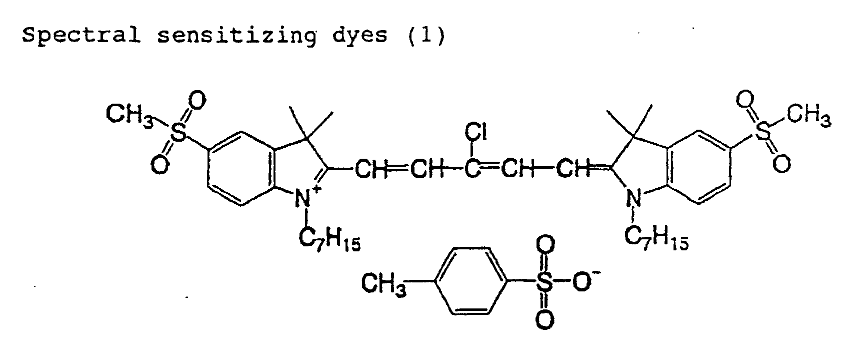

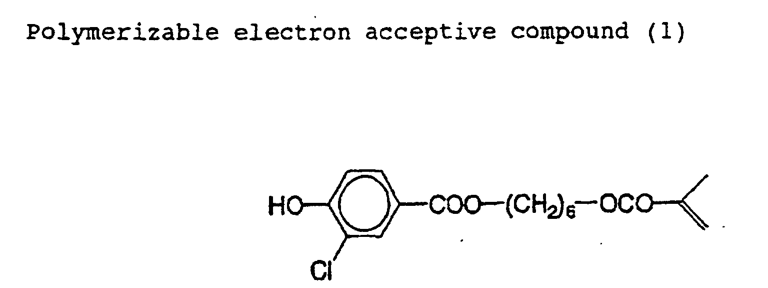

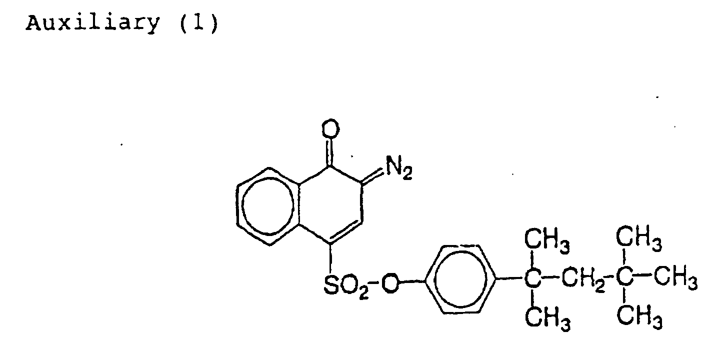

### Preparation of coating solution (I) for photosensitive thermal recording layer:

2 g of the electron donative colorless dye-including microcapsule solution (I), 2.25 g of the borate compound-containing solution (A), 7.36 g of the dye-containing solution (B) and 0.41 g of an aqueous 15% gelatin solution were mixed to prepare a coating solution (I) for photosensitive thermal recording layer.

### Preparation of coating solution for protective layer:

4.5 g of an aqueous 10% gelatin solution, 4.5 g of distilled water, 0.5 g of an aqueous 2% solution of a surfactant (3) represented by the aforementioned structural formula, 0.3 g of an aqueous 2% solution of a surfactant (4) represented by the aforementioned structural formula, 0.5 g of an aqueous 2% solution of a vinyl sulfone compound (hardening agent), Cyloid 72 (FUJI-DIVISION CHEMICAL LTD.) in an amount sufficient to provide a dry coat weight of 50 mg/m² and 1 g of Snowtex N were mixed to prepare a coating solution for protective layer.

### Production of photosensitive thermal recording material

On a polyethylene terephthalate (PET) blue base substrate having a thickness of 175 µm, the coating solution (I) for photosensitive thermal recording layer was coated using a coating bar so that the dry weight of the photosensitive thermal recording layer was 30 g/m², and then dried.

On the resulting layer, the coating solution for protective layer was coated using a coating bar so that the dry weight of the protective layer was 2 g/m², and then dried, to produce a photosensitive thermal recording material.

The photosensitive thermal recording material was exposed to light from the protective layer side at a maximum exposure energy of 15 mJ/cm² in the form of a step-wedged image so that the exposure energy changes in turn, using a semiconductor laser beam having a wavelength of 657 nm.

The recording material wherein a latent image has been formed by exposure was heated on a heating plate at 120°C for 5 seconds, and then the whole surface of the photosensitive thermal recording layer of the recording material was irradiated with light on a high luminance (58000 lux) sharkstain for 30 seconds. As a result, distinct color was developed to obtain a step-wedged image wherein whiteness of the unexposed portion was high.

### Evaluation of sensitivity:

In a certain step corresponding to the same exposure dose in a wedge image of the material, a difference between the exposure energy of this step and energy required to form the unexposed portion of the material [(energy required until the unexposed portion is formed) - (exposure energy of this step)] was measured and calculated and the resultant value was used as an index of the sensitivity. Accordingly, the smaller the numerical value, the higher the sensitivity is. The results are shown in Table 1.

### Evaluation of sensitivity after thermo-treatment

The resulting photosensitive thermal recording material was allowed to stand in an environment with a temperature of 35°C and a relative humidity of 80%RH for 3 days and the sensitivity was evaluated in the same manner as above. The results are shown in Table 1.

### Measurement of density:

The color density (Dₘₐₓ) and fog density (Dₘᵢₙ) were measured by using a Macbeth transmission type densitometer (manufactured by Macbeth Co.) or a Macbeth reflection type densitometer (manufactured by Macbeth Co.). The results are shown in Table 1.

### Example 2: Black color development

In the same manner as in Example 1, except that the borate compound (1-7) was used in place of the borate compound (1-1) used in the preparation of the photopolymerizable composition emulsion (I), a photosensitive thermal recording material was produced, and then the same evaluation as in Example 1 was conducted. The results are shown in Table 1.

### Example 3: Black color development

In the same manner as in Example 1, except that the borate compound (1-8) was used in place of the borate compound (1-1) used in the preparation of the photopolymerizable composition emulsion (I), a photosensitive thermal recording material was produced, and then the same evaluation as in Example 1 was conducted. The results are shown in Table 1.

### Example 4: Black color development

In the same manner as in Example 1, except that the borate compound (1-9) was used in place of the borate compound (1-1) used in the preparation of the photopolymerizable composition emulsion (I), a photosensitive thermal recording material was produced, and then the same evaluation as in Example 1 was conducted. The results are shown in Table 1.

### Example 5: Black color development

In the same manner as in Example 1, except that the borate compound (1-10) was used in place of the borate compound (1-1) used in the preparation of the photopolymerizable composition emulsion (I), a photosensitive thermal recording material was produced, and then the same evaluation as in Example 1 was conducted. The results are shown in Table 1.

### Comparative Example 1: Black color development

In the same manner as in Example 1, except that a borate compound represented by the following structural formula (comparative compound 1) was used in place of the borate compound (1-1) used in the preparation of the photopolymerizable composition emulsion (I), a photosensitive thermal recording material was produced, and then the same evaluation as in Example 1 was conducted. The results are shown in Table 1.

### Comparative Example 2: Black color development

In the same manner as in Example 1, except that a borate compound represented by the following structural formula (comparative compound 2) was used in place of the borate compound (1-1) used in the preparation of the photopolymerizable composition emulsion (I), a photosensitive thermal recording material was produced, and then the same evaluation as in Example 1 was conducted. The results are shown in Table 1.

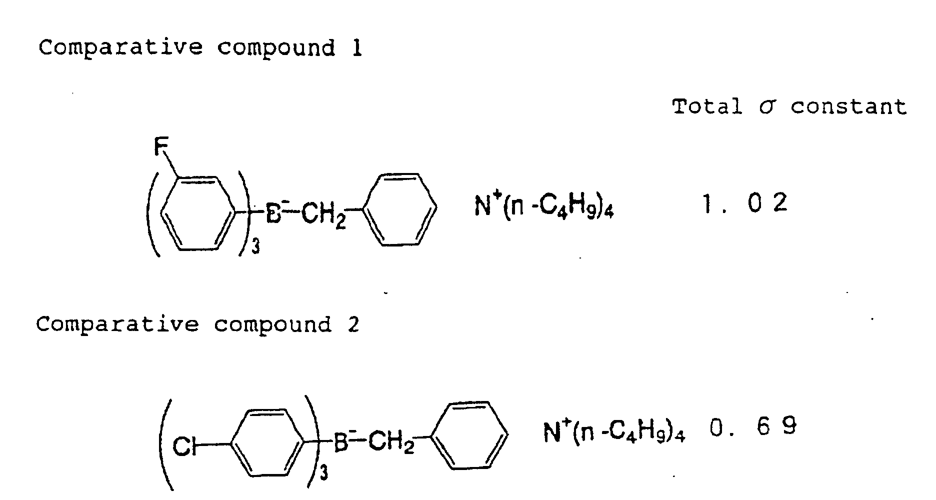

### Example 6: Magenta color development

### Preparation of electron donative colorless dye-including microcapsule solution (II)

In the same manner as in Example 1, except that a magenta color-developing electron donative colorless dye (2) represented by the following structural formula was used in place of the electron donative colorless dye (1) used in the preparation of the electron donative colorless dye-including microcapsule solution (I), an electron donative colorless dye-including microcapsule solution (II) having an average particle diameter of 0.5 µm, comprising an electron donative colorless dye (2) as a core was prepared.

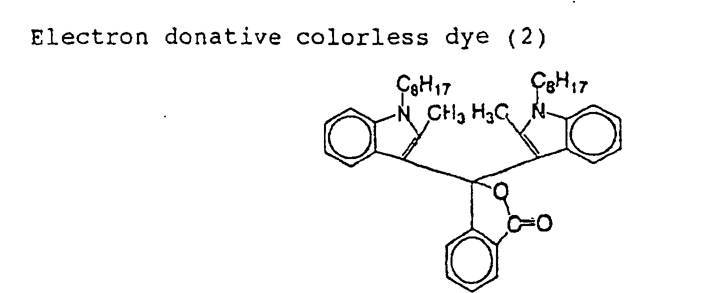

### Preparation of photopolymerizable composition emulsion (II):

To a mixed solution of 0.6 g of the borate compound (1-16), 0.1 g of the spectral sensitizing dye (I), 0.1 g of the auxiliary (I) used for enhancement of sensitivity, and 3 g of isopropyl acetate (solubility in water: about 4.3%), 5 g of the electron acceptive compound (1) having a polymerizable group was added.

The resulting solution was added to a mixed solution of 13 g of an aqueous 13% gelatin solution, 0.8 g of an aqueous 2% solution of the surfactant (1) and 0.8 g of an aqueous 2% solution of the surfactant (2), and the mixed solution was emulsified at 10000 rpm using a homogenizer (manufactured by Nippon Seiki Co., Ltd.) for 5 minutes to prepare a photopolymerizable composition emulsion (II).

### Preparation of coating solution (II) for photosensitive thermal recording layer:

4 g of the electron donative colorless dye-including microcapsule solution (II), 12 g of a photopolymerizable composition emulsion (II) and 12 g of an aqueous 15% gelatin solution were mixed to prepare a coating solution (II) for photosensitive thermal recording layer.

### Manufacture of photosensitive thermal recording material:

On a substrate made of a polyester film filled with white dyes (trade name: Lumilar E-68L, manufactured by Toray Co., Ltd.) having a thickness of 100 µm, the coating solution (II) for photosensitive thermal recording layer was coated using a coating bar so that the dry weight of the photosensitive thermal recording layer was 6 g/m², and then dried.

On the resulting layer, the coating solution for protective layer prepared in Example 1 was coated using a coating bar so that the dry weight of the protective layer was 2 g/m², and then dried, to produce a photosensitive thermal recording material. The resulting photosensitive thermal recording material was evaluated in the same manner as in Example 1. The results are shown in Table 1.

### Example 7: Magenta color development:

In the same manner as in Example 6, except that the borate compound (1-17) was used in place of the borate compound (1-16) used in the preparation of the photopolymerizable composition emulsion (II), a photosensitive thermal recording material was produced, and then the same evaluation as in Example 6 was conducted. The results are shown in Table 1.

### Comparative Example 3: Magenta color development:

In the same manner as in Example 6, except that a borate compound represented by the following structural formula (comparative compound 3) was used in place of the borate compound (1-16) used in the preparation of the photopolymerizable composition emulsion (II), a photosensitive thermal recording material was produced, and then the same evaluation as in Example 6 was conducted. The results are shown in Table 1.

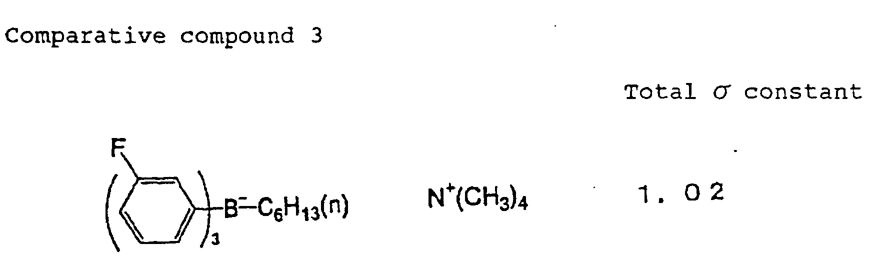

**Table 1**

| | Borate compound | Sensitivity (mJ/cm²) | Sensitivity after thermo-treatment (mJ/cm²) | Dₘₐₓ | Dₘᵢₙ |
|---|---|---|---|---|---|
| Example 1 | 1-1 | 0.57 | 0.59 | 2.68 | 0.05 |
| Example 2 | 1-7 | 0.65 | 0.68 | 2.65 | 0.05 |
| Example 3 | 1-8 | 0.34 | 0.41 | 2.61 | 0.06 |
| Example 4 | 1-9 | 0.41 | 0.45 | 2.62 | 0.05 |
| Example 5 | 1-10 | 0.69 | 0.71 | 2.65 | 0.05 |
| Comparative Example 1 | Comparative compound 1 | 0.76 | 0.81 | 2.59 | 0.05 |
| Comparative Example 2 | Comparative compound 2 | 0.62 | 1.38 | 2.53 | 0.06 |
| Example 6 | 1-16 | 0.23 | 0.25 | 2.17 | 0.07 |
| Example 7 | 1-17 | 0.24 | 0.26 | 2.16 | 0.07 |
| Comparative Example 3 | Comparative compound 3 | 1.08 | 1.11 | 2.02 | 0.07 |

As is apparent from the results of Table 1, the recording materials containing the borate compound of the present invention (Examples 1 to 7) have good initial sensitivity, excellent sensitivity after the thermo-treatment and good storage properties. On the other hand, the recording materials of Comparative Examples 1 and 3 were inferior in initial sensitivity. The reason is considered to be as follows. That is, the sensitivity was lowered because the total σ constant of the borate compound was high, such as 1.02, and the electron attractive property was too strong. The recording material of Comparative Example 2 was superior in initial sensitivity, but was inferior in sensitivity after the thermo-treatment. This reason is considered as follows. That is, the acid stability is poor because an electron attractive group is absent at the ortho-position of the aryl group represented by the general formula (II).

According to the present invention, there can be provided the novel borate compound which has high sensitivity and is superior in storage properties even in a case where an acid-containing medium is also present, and the photopolymerizable compound and the recording material which contain the same.

## Claims

1. A borate compound represented by one of the following general formulae (III) and (IV): 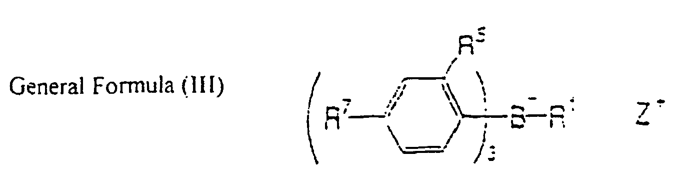 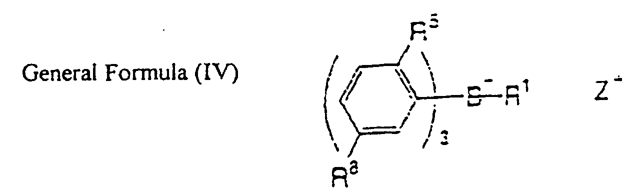 wherein Z⁻ represents a group capable of forming a cation, R¹ represents an alkyl group which may have a substituent; R⁵ represents an electron donative group and R⁷ in the general formula (III) and R⁸ in the general formula (IV) are electro attractive groups, said compound being selected from the group consisting of

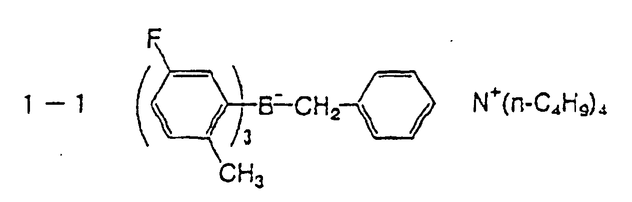

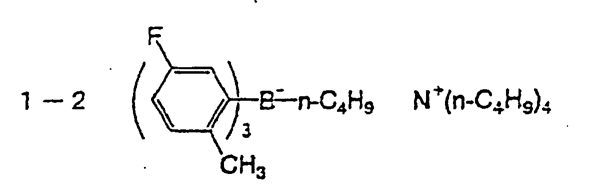

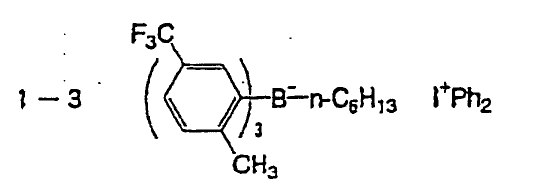

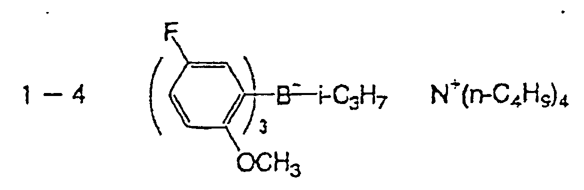

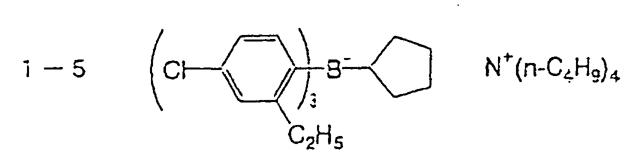

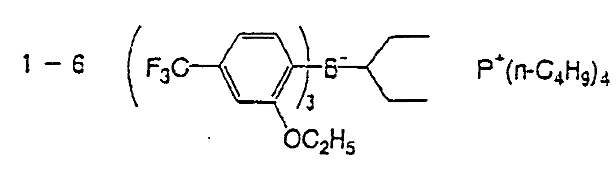

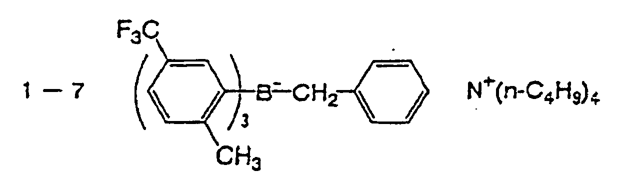

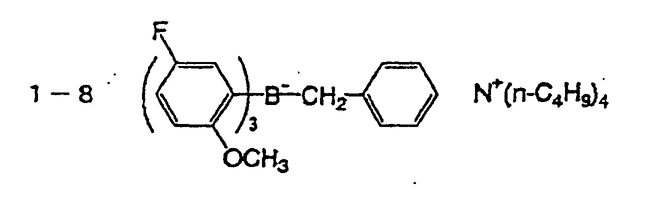

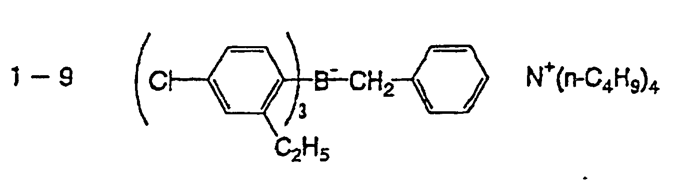

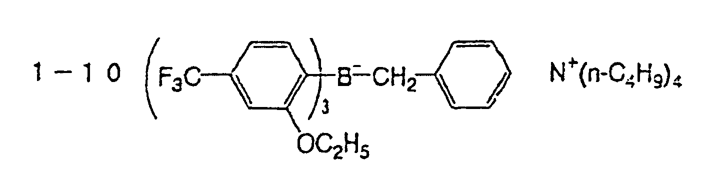

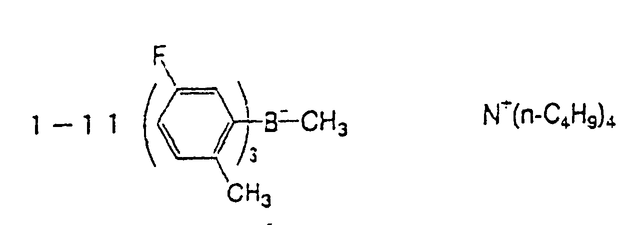

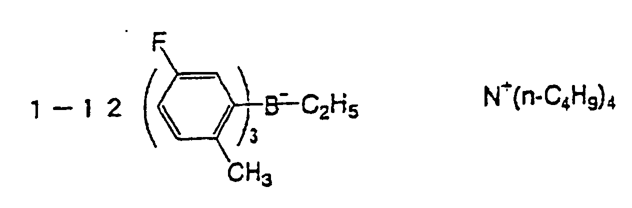

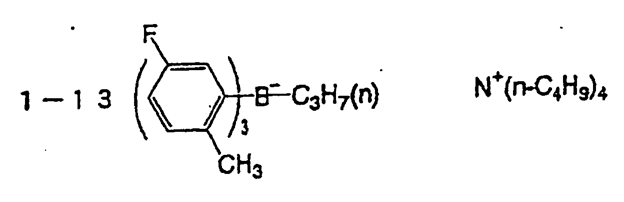

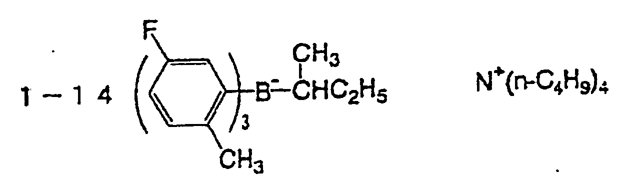

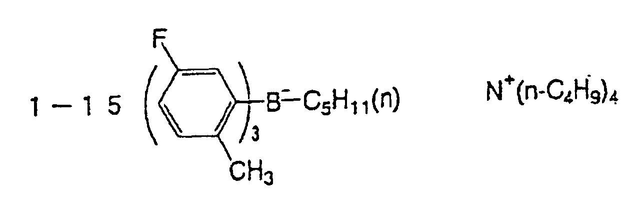

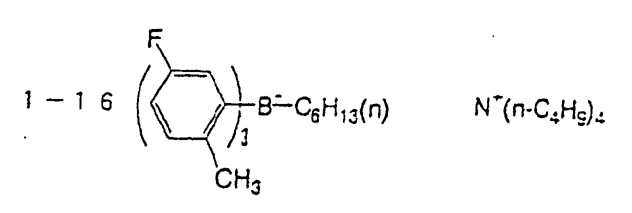

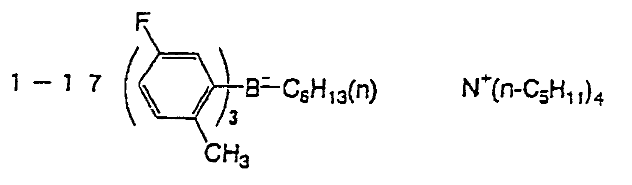

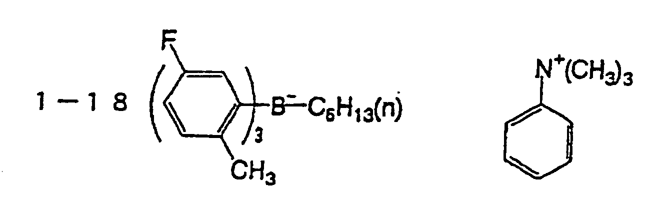

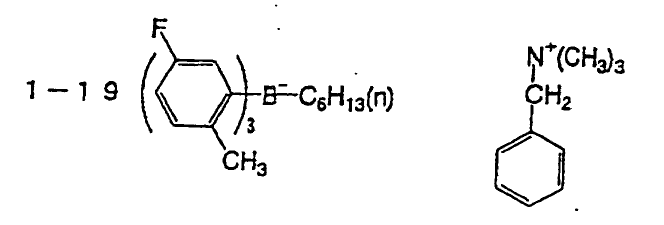

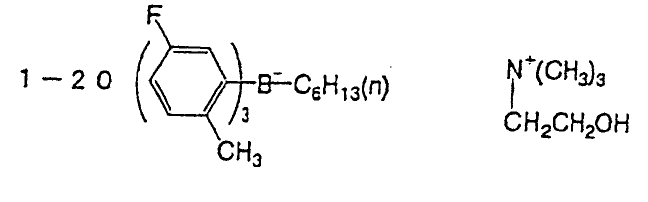

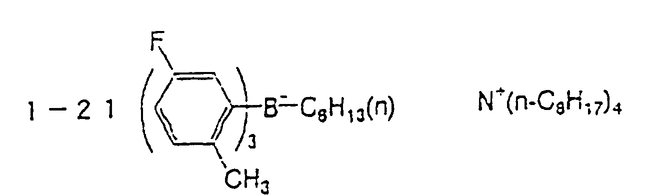

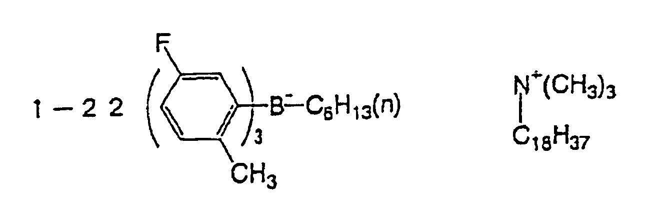

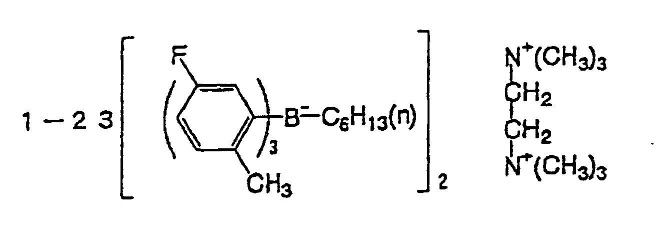

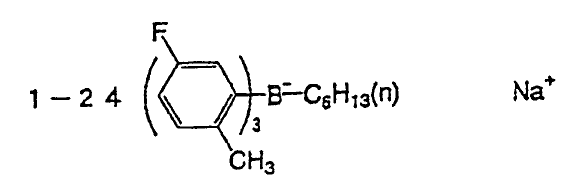

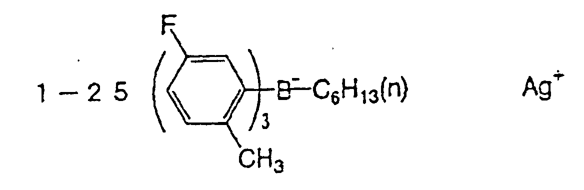

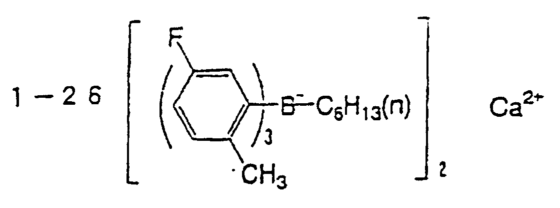

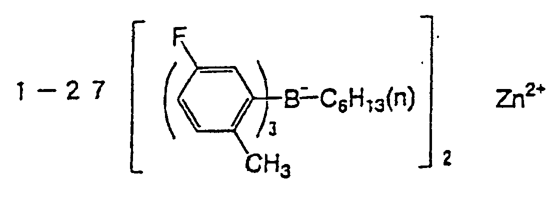

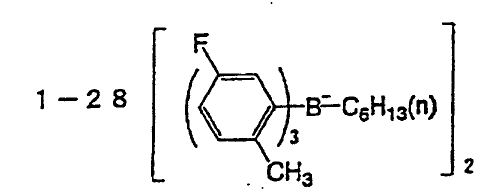

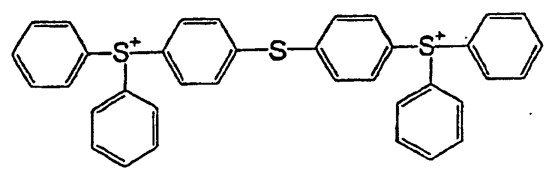

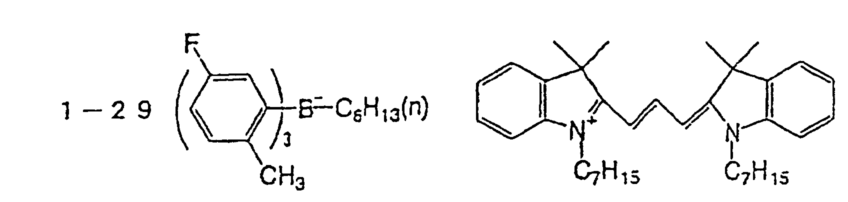

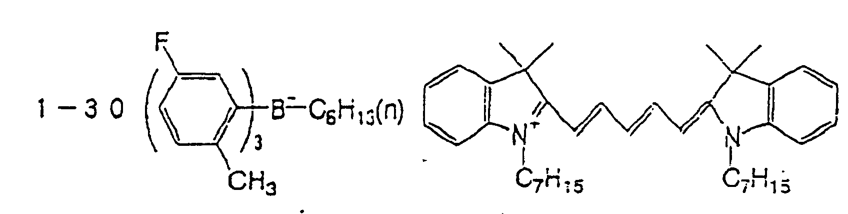

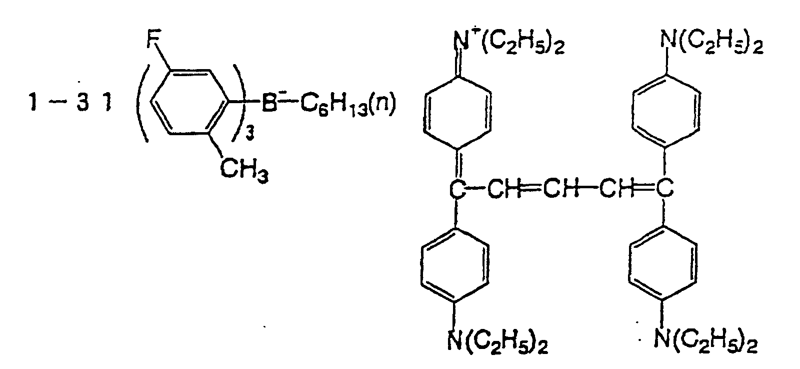

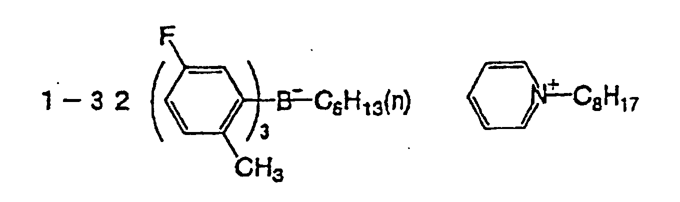

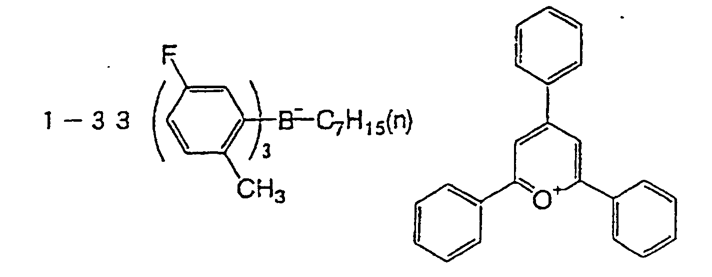

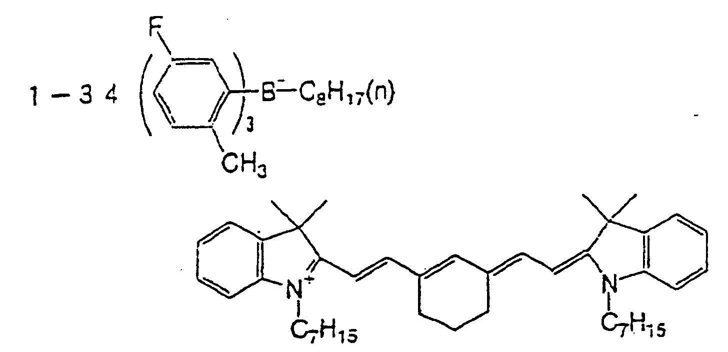

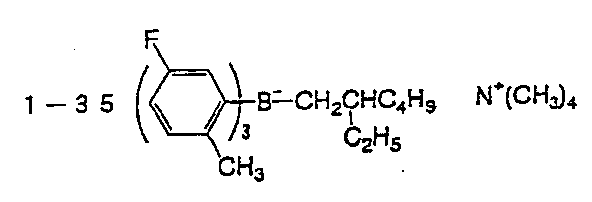

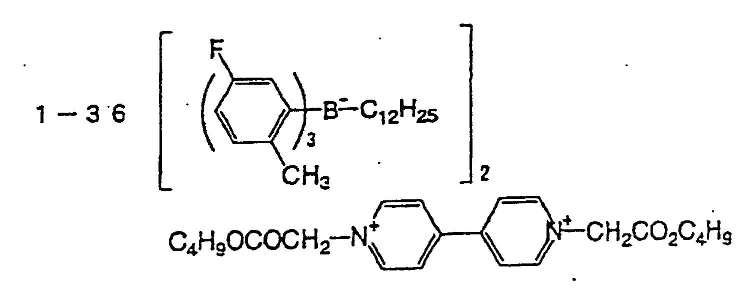

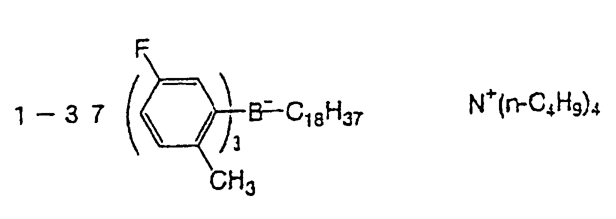

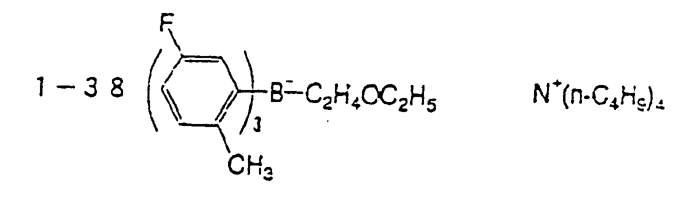

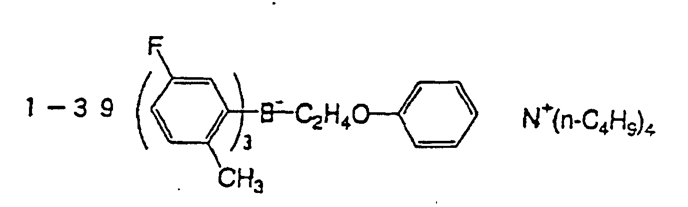

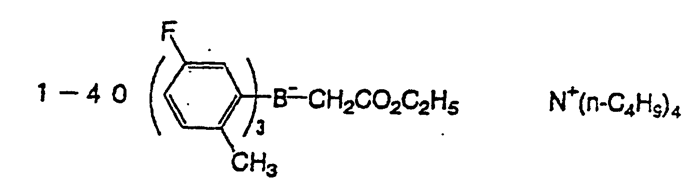

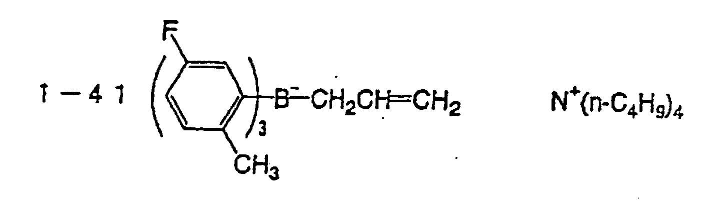

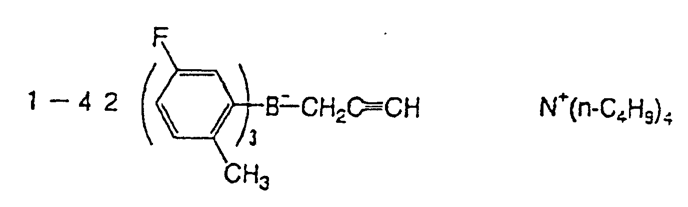

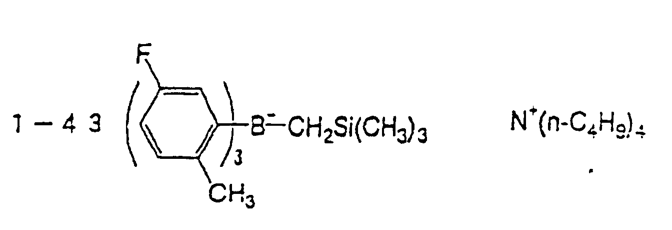

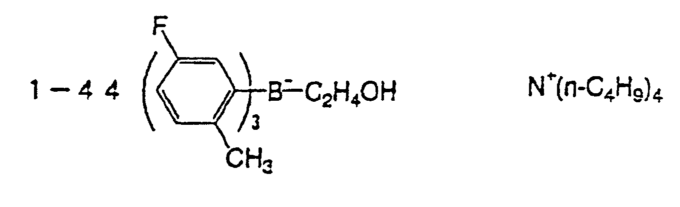

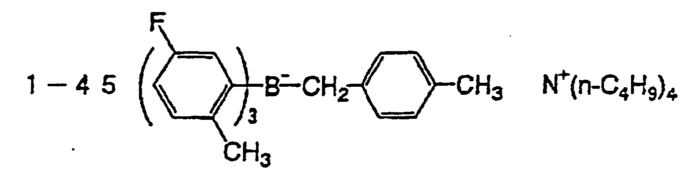

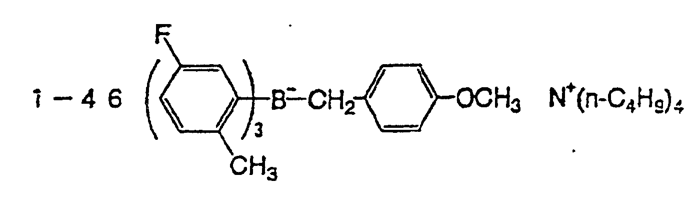

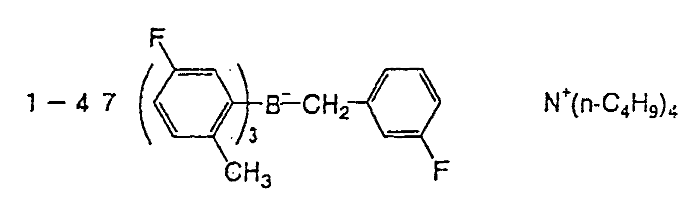

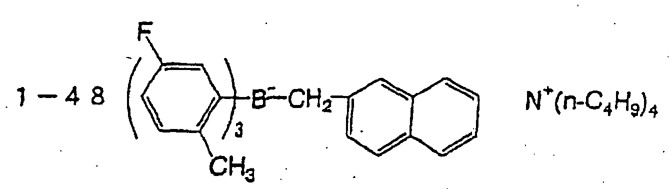

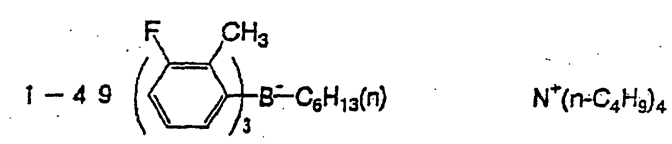

2. A photopolymerizable composition comprising the borate compound of claim 1.

3. A photopolymerizable composition according to claim 2, further comprising a dye and a radical-polymerizable compound.

4. A recording material comprising a substrate and a recording layer on the substrate, said recording layer containing the photopolymerizable composition of claim 2 or 3, a color developing component (A), and a color developing component (B) capable of reacting with the color developing component (A) to develop color of the color developing component (A).

5. A recording material according to claim 4, wherein a combination of two components, the color developing components (A) and (B), is selected from
(a) a combination of an electron donative dye precursor and an electron attractive compound,
(b) a combination of a diazonium salt compound and a coupler,
(c) a combination of an organometal salt and a reducing agent,
(d) a combination of a protected dye precursor and a deblocking agent, and
(e) a combination of a leuco dye precursor and a deblocking agent.

6. A recording material according to claim 5, wherein the color developing component (A) or (B) is contained in the form of microcapsules.

## Patentansprüche

1. Boratverbindung gemäss einer der folgenden allgemeinen Formeln (III) und (IV): 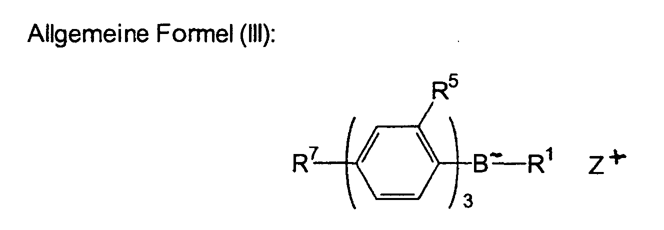 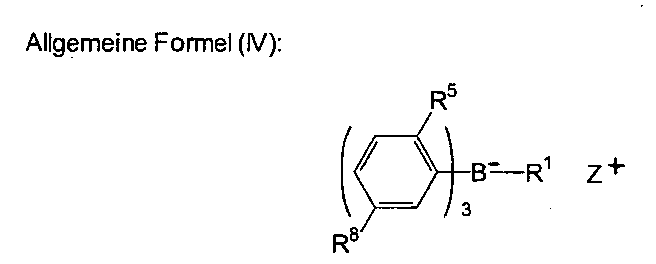 worin Z⁺ eine Gruppe darstellt, die zur Ausbildung eines Kations in der Lage ist, R¹ ist eine Alkylgruppe, die einen Substituenten aufweisen kann, R⁵ ist eine Elektronendonorgruppe und R⁷ in der allgemeinen Formel (III) und R⁸ in der allgemeinen Formel (IV) sind elektronenanziehende Gruppen; wobei die Verbindung ausgewählt ist aus den folgenden:

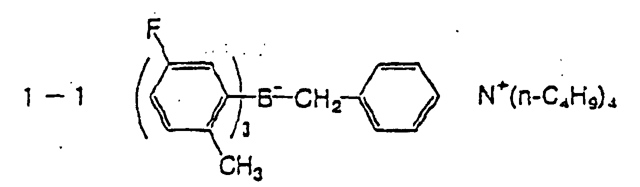

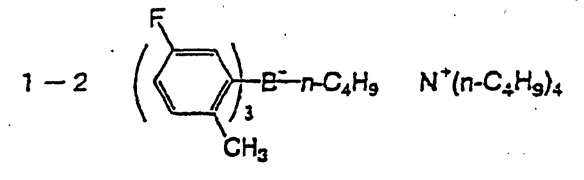

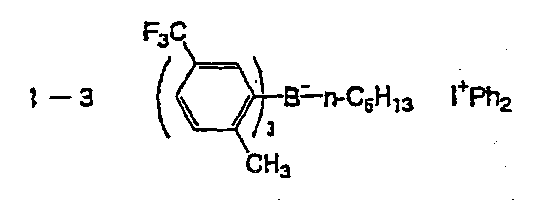

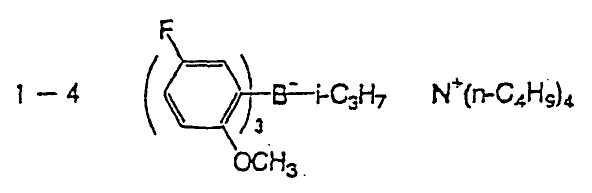

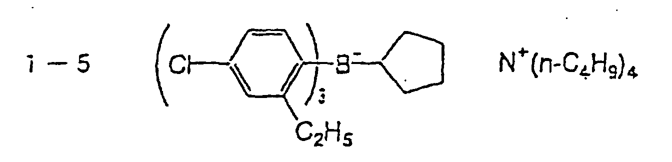

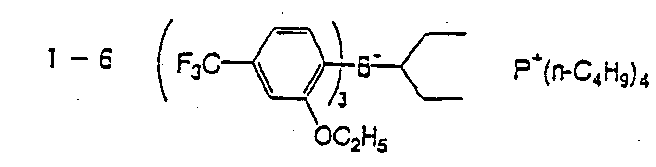

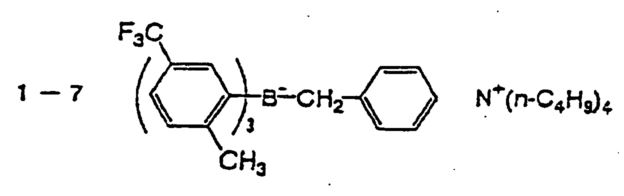

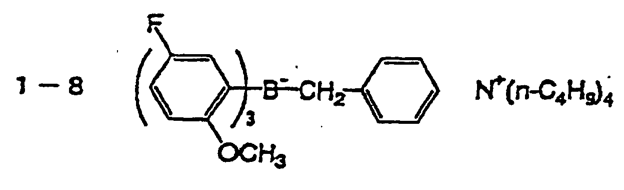

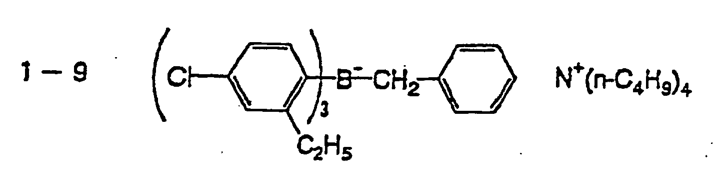

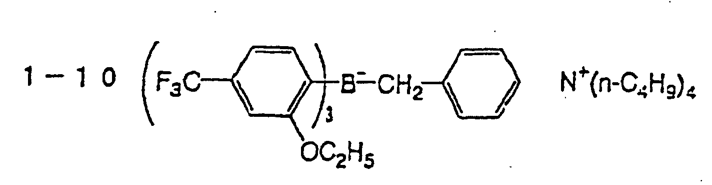

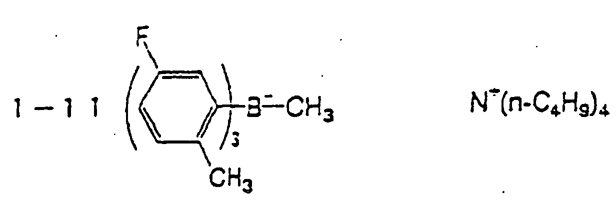

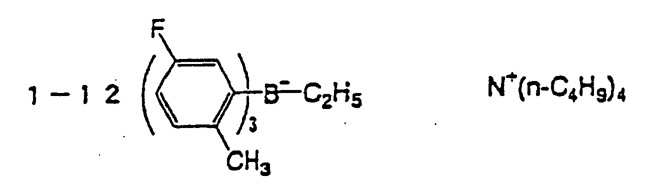

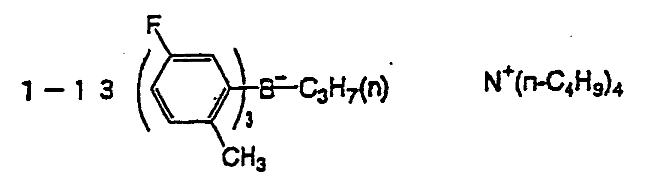

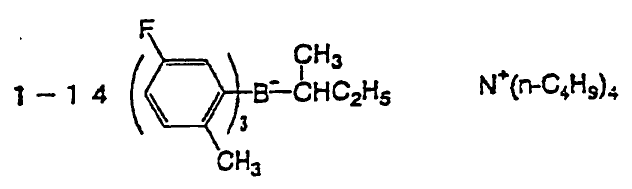

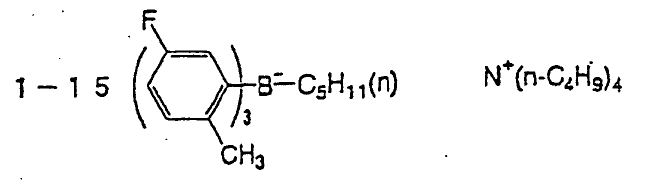

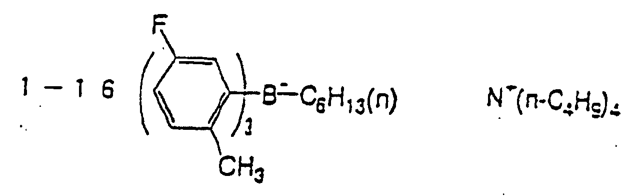

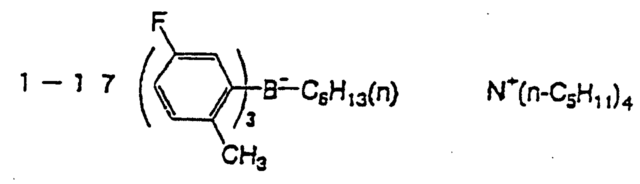

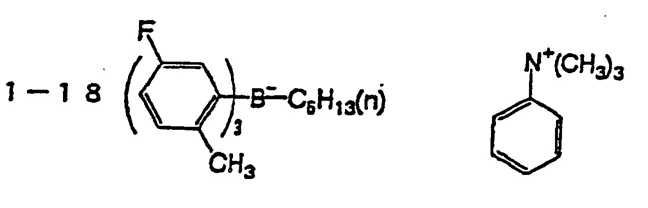

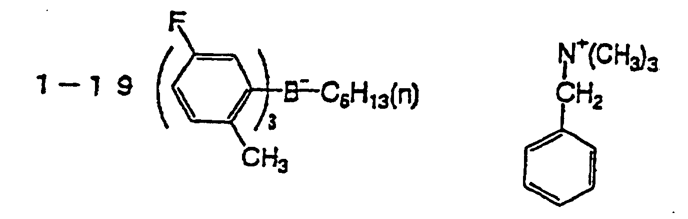

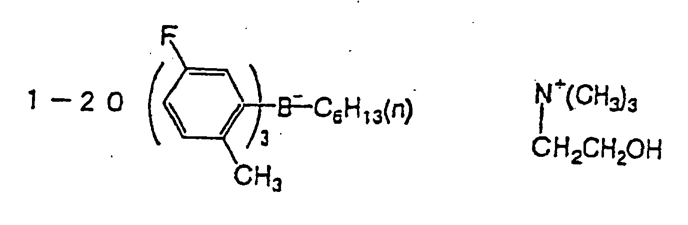

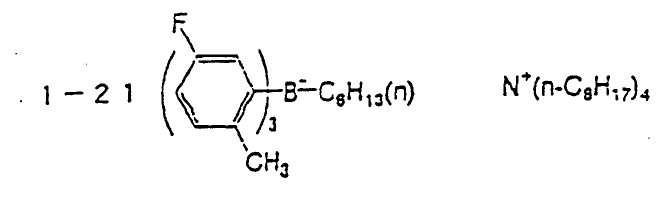

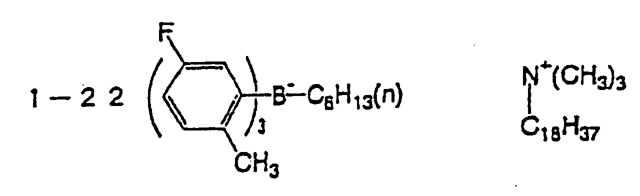

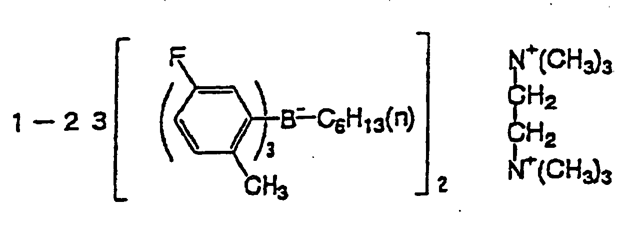

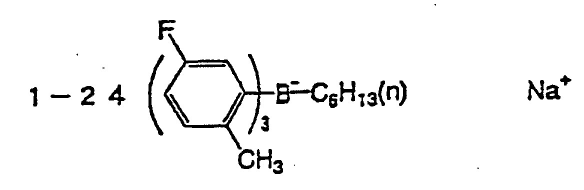

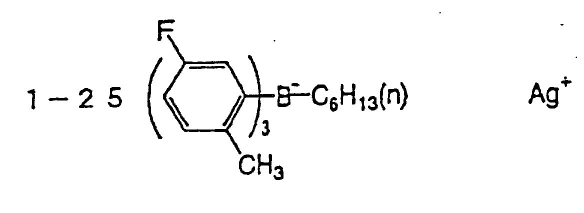

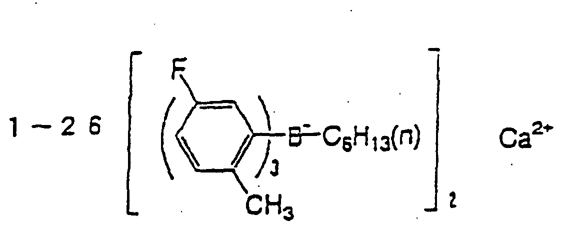

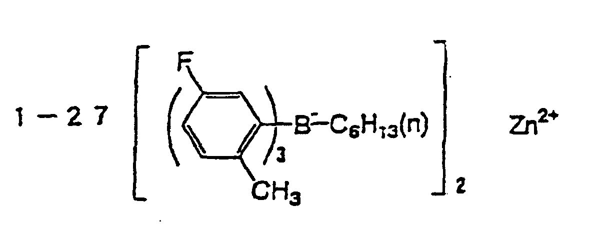

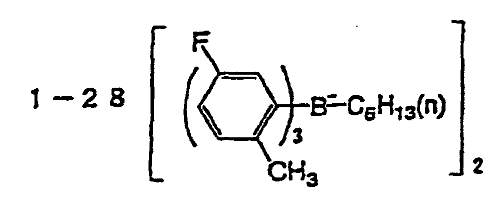

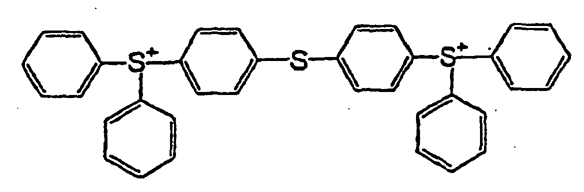

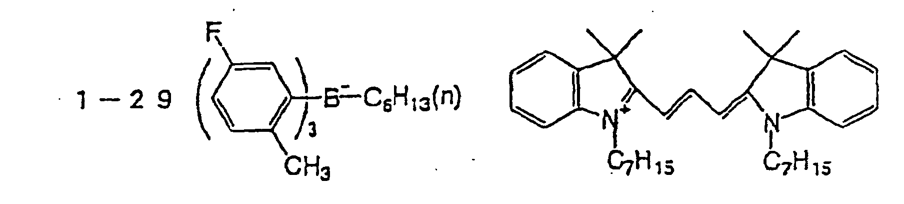

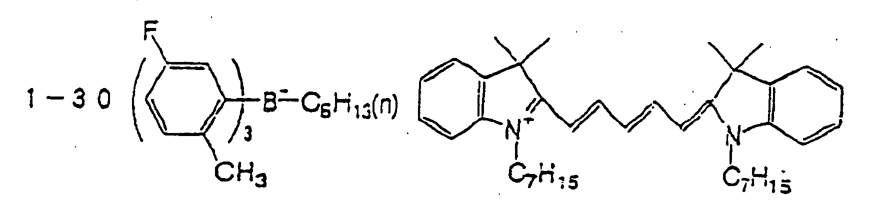

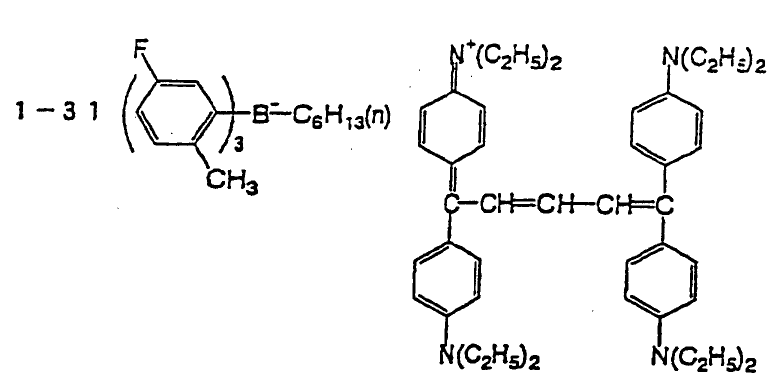

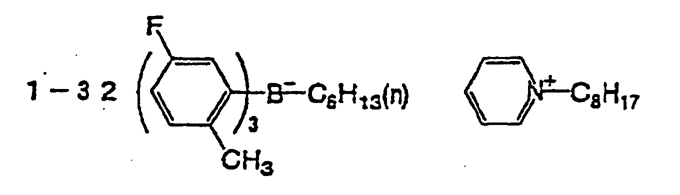

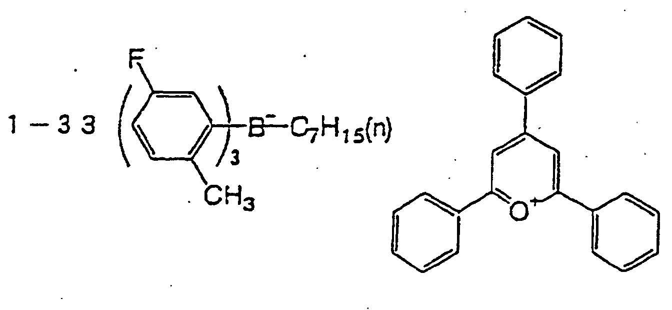

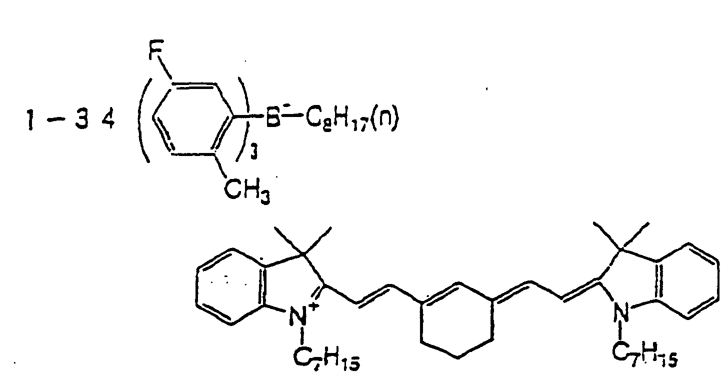

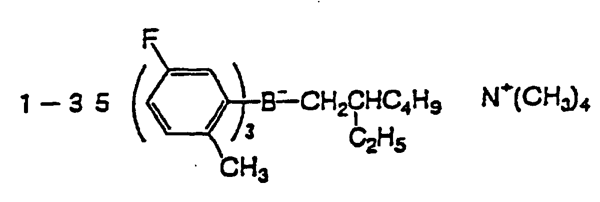

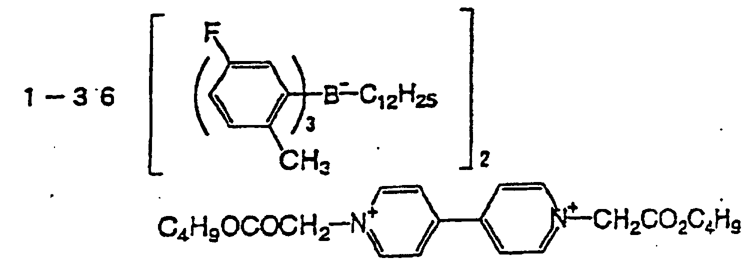

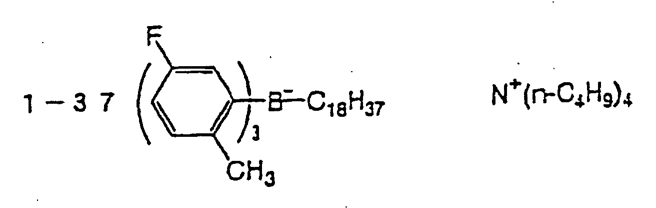

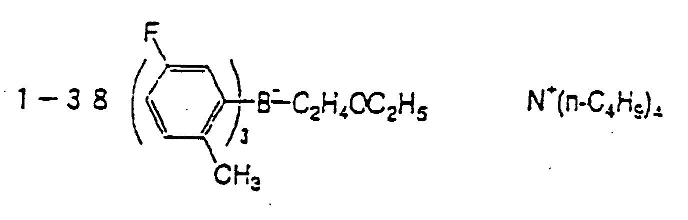

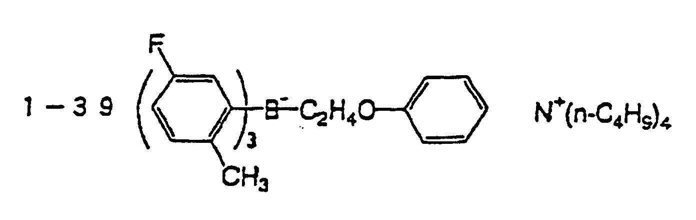

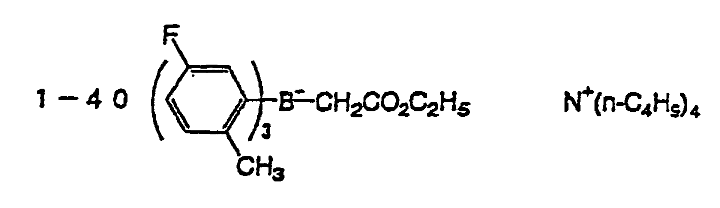

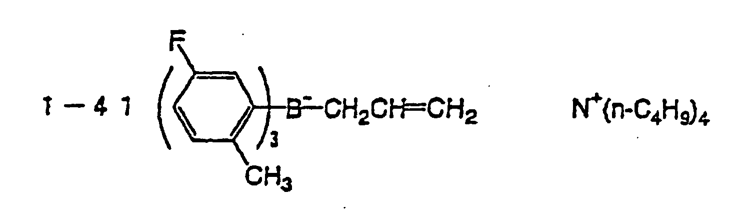

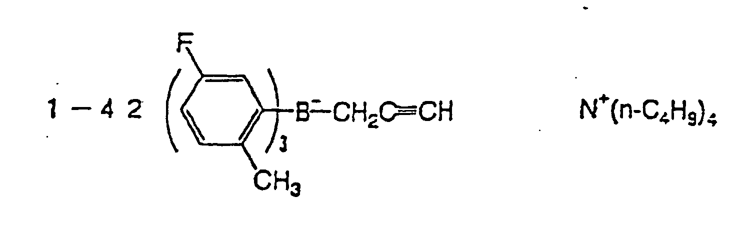

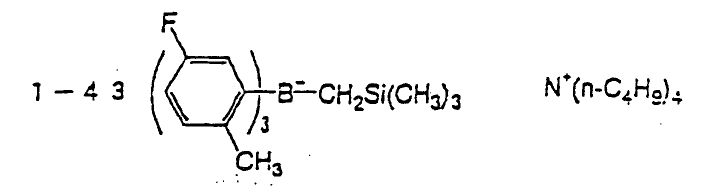

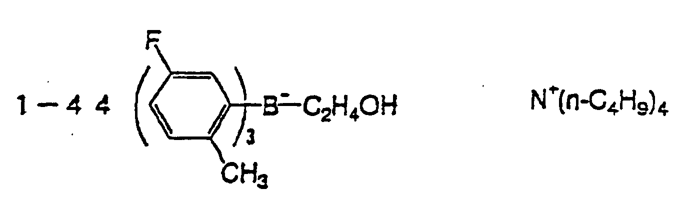

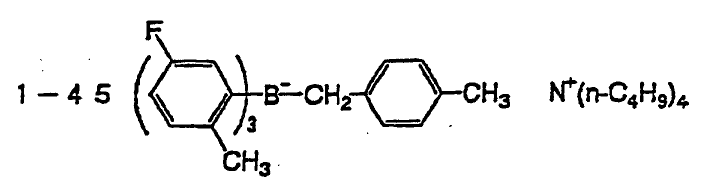

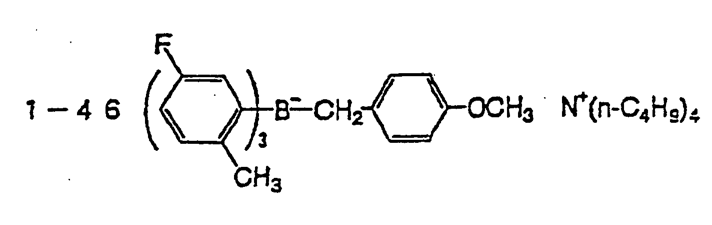

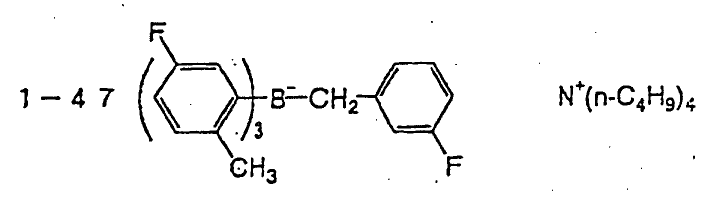

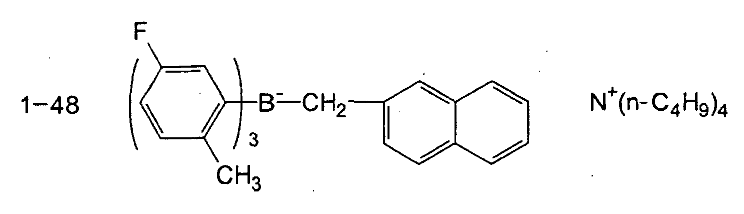

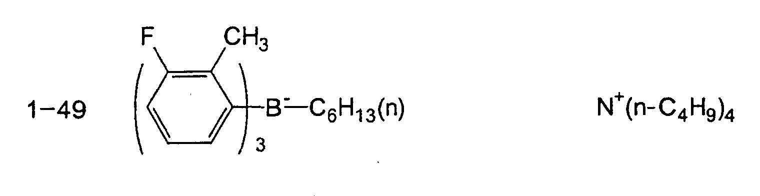

2. Fotopolymerisierbare Zusammensetzung, die die Boratverbindung gemäss Anspruch 1 umfasst.

3. Fotopolymerisierbare Zusammensetzung gemäss Anspruch 2, die ferner einen Farbstoff und eine radikalpolymerisierbare Verbindung umfasst.

4. Aufzeichnungsmaterial, das ein Substrat und eine auf dem Substrat befindliche Aufzeichnungsschicht umfasst, die Aufzeichnungsschicht enthält die fotopolymerisierbare Zusammensetzung gemäss Anspruch 2 oder 3, eine Farbentwicklungskomponente (A) und eine Farbentwicklungskomponente (B), die in der Lage ist, mit der Farbentwicklungskomponente (A) zu reagieren, wodurch die Farbe der Farbentwicklungskomponente (A) hervorgebracht wird.

5. Aufzeichnungsmaterial gemäss Anspruch 4, worin die Kombination der zwei Komponenten, der Farbentwicklungskomponenten (A) und (B), ausgewählt ist aus
(a) einer Kombination aus einem elektronenabgebenden Farbstoffvorläufer und einer elektronenanziehenden Verbindung,
(b) einer Kombination aus einer Diazoniumsalzverbindung und einem Kuppler,
(c) einer Kombination aus einem Organometallsalz und einem Reduktionsmittel,
(d) einer Kombination aus einem geschützten Farbstoffvorläufer und einem Deblockierungsmittel, und
(e) einer Kombination aus einem Leukofarbstoffvorläufer und einem Deblockierungsmittel.

6. Aufzeichnungsmaterial gemäss Anspruch 5, worin die Farbentwicklungskomponente (A) oder (B) in Form von Mikrokapseln enthalten ist.

## Revendications

1. Composé de borate représenté par une des formules générales suivantes (III) et (IV) : 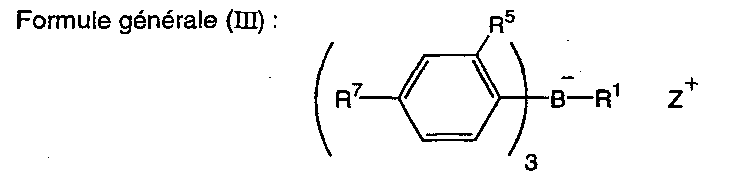 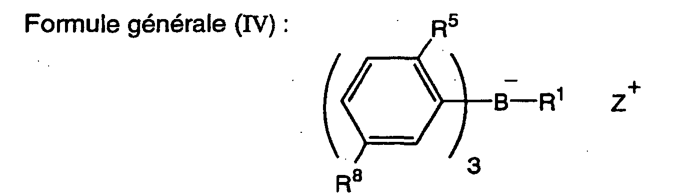 dans laquelle Z⁺ représente un groupe capable de former un cation, R¹ représente un groupe alkyle qui peut avoir un substituant, R⁵ représente un groupe donneur d'électrons et R⁷ dans la formule générale (III) et R⁸ dans la formule générale (IV) sont des groupes attracteurs d'électrons, ledit composé étant choisi dans le groupe constitué par

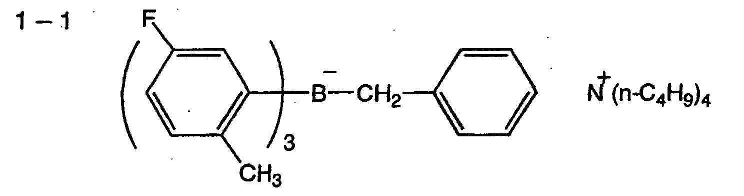

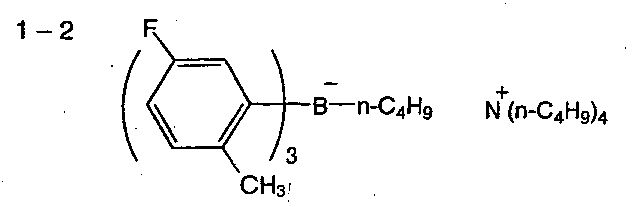

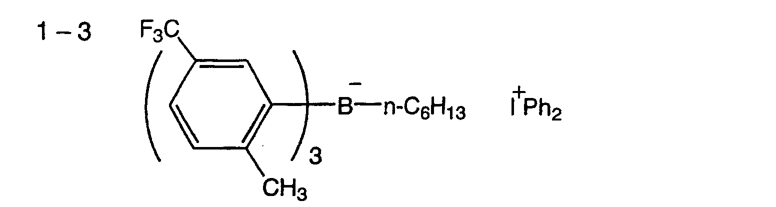

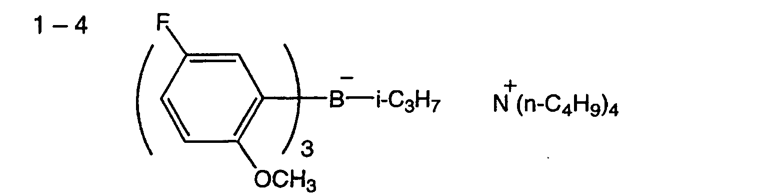

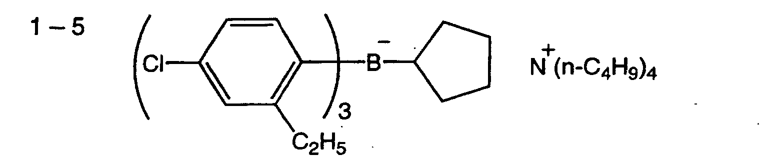

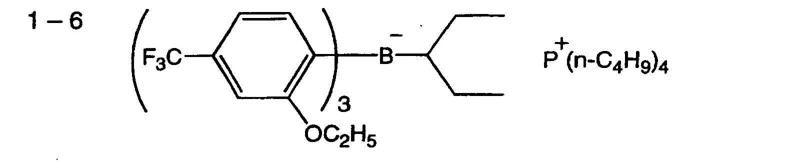

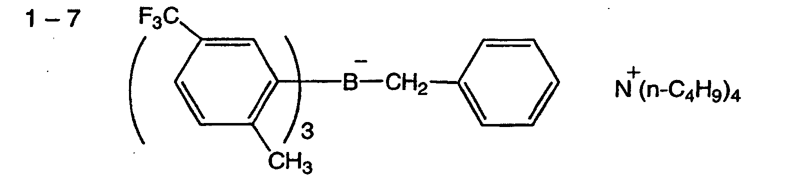

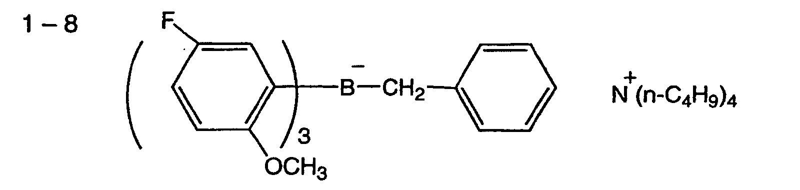

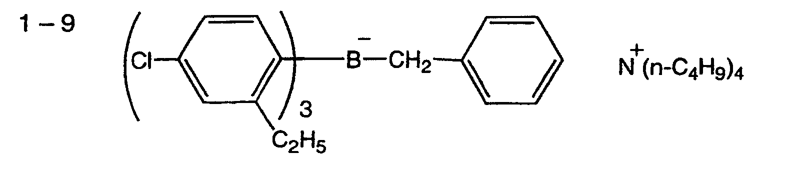

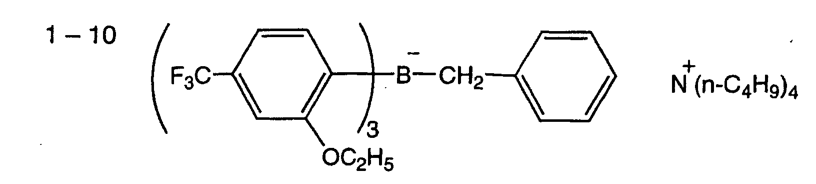

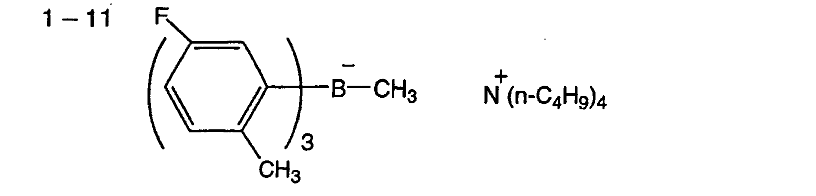

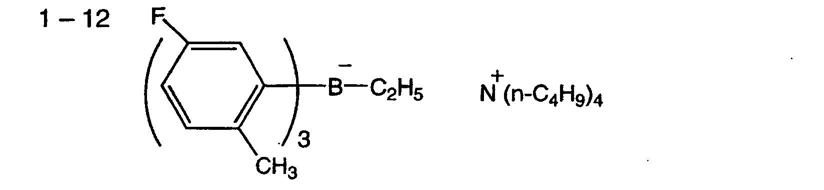

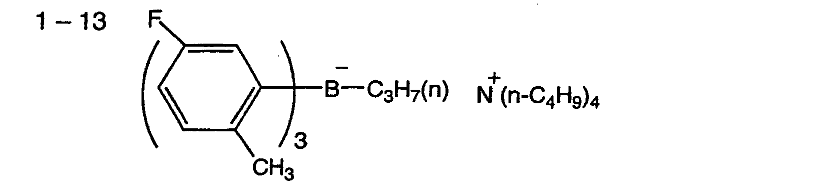

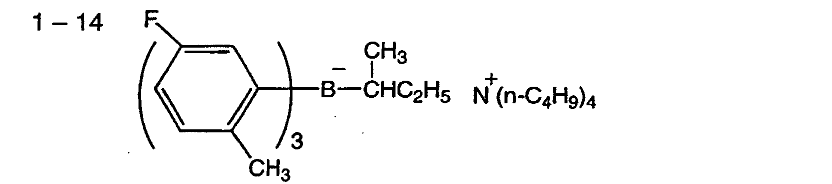

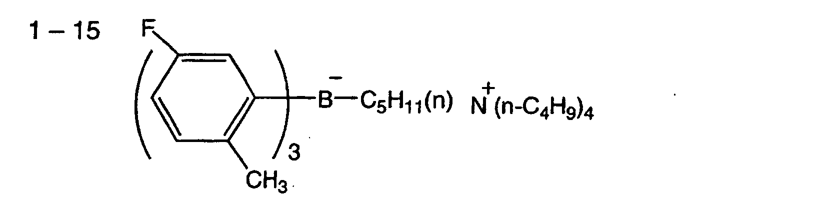

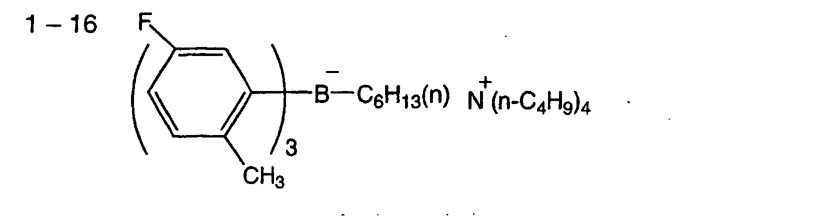

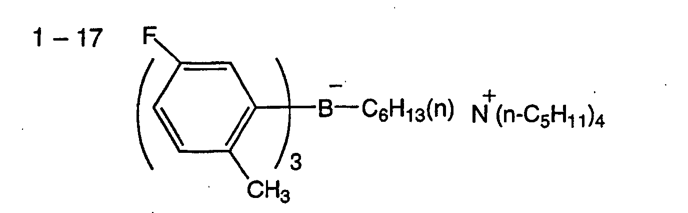

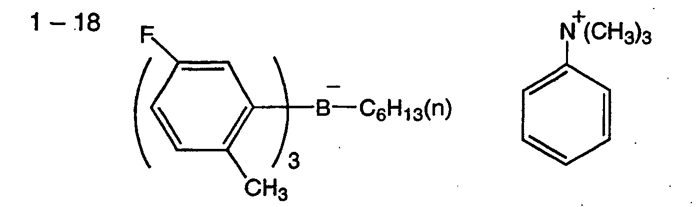

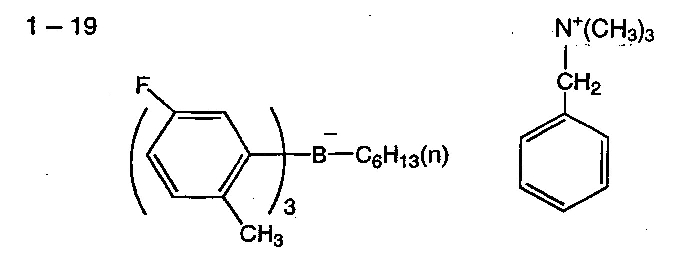

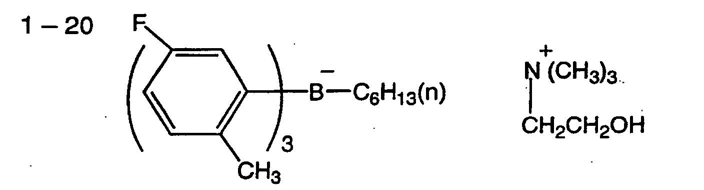

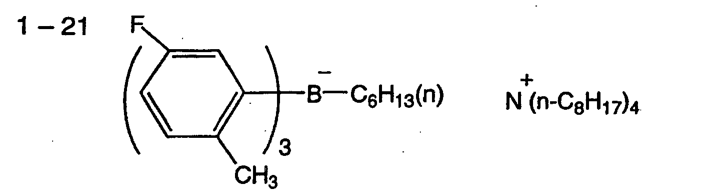

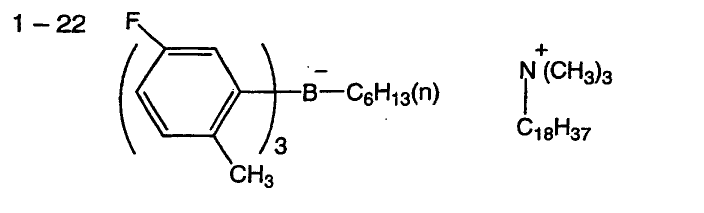

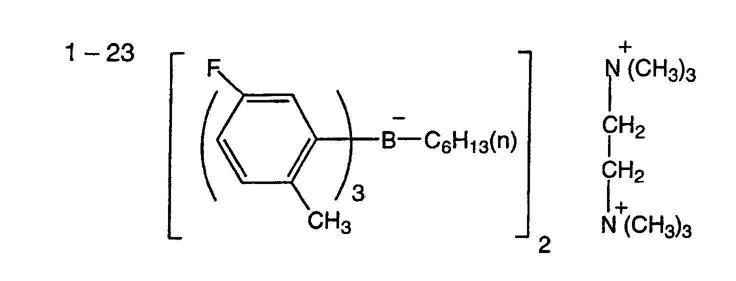

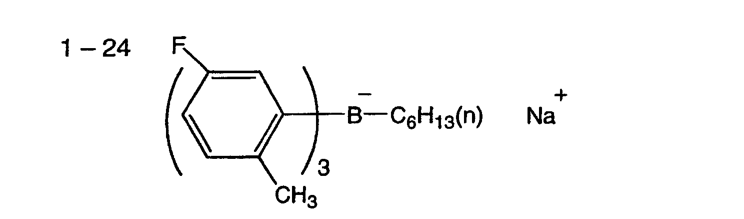

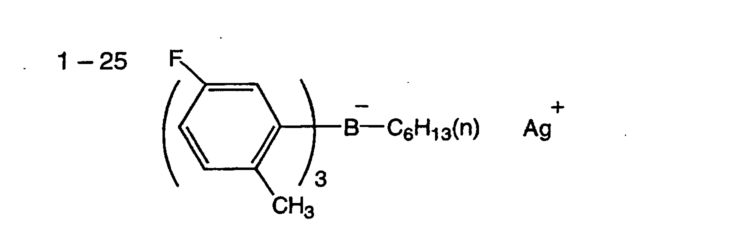

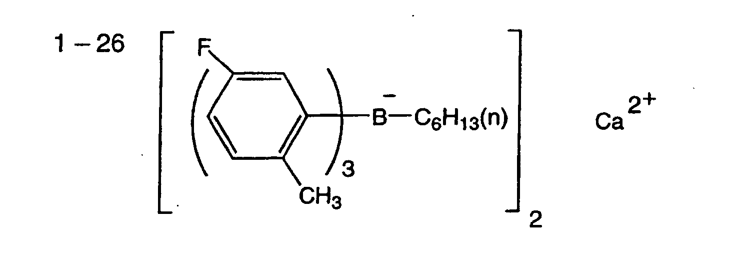

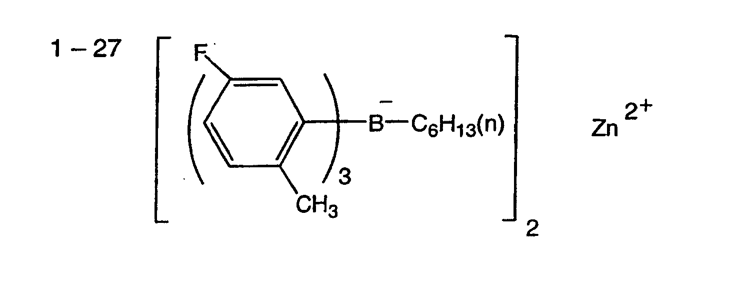

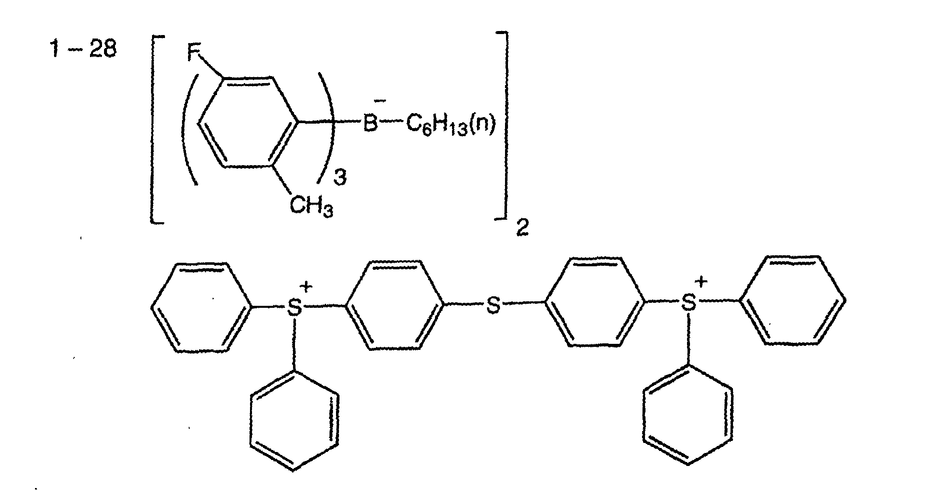

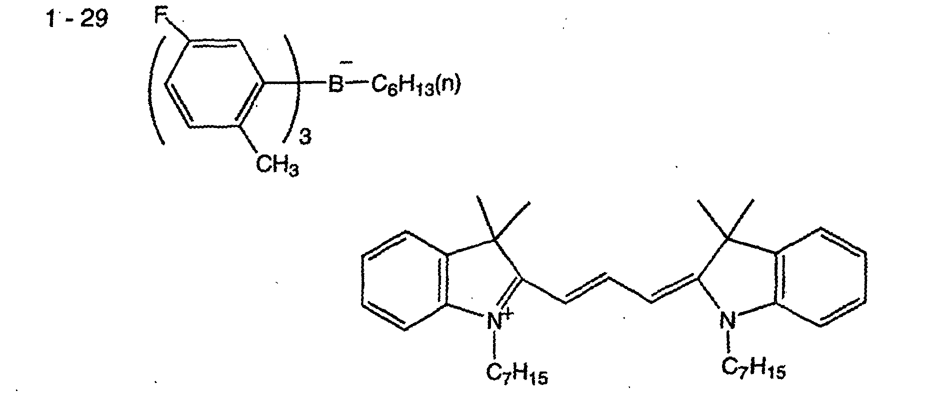

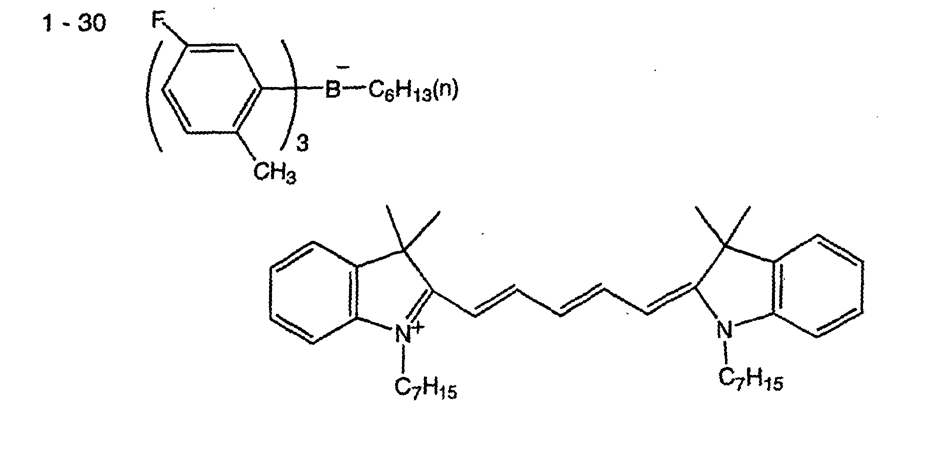

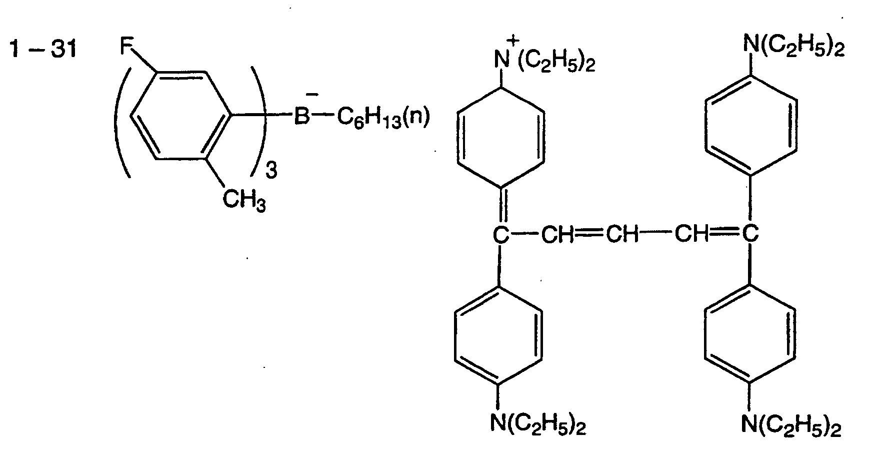

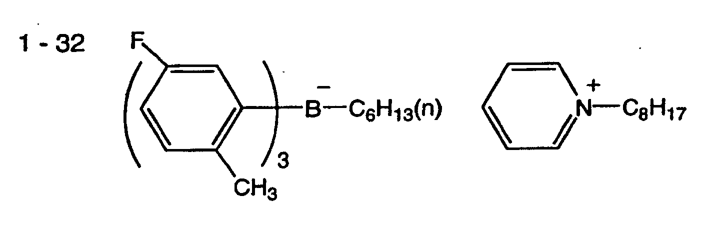

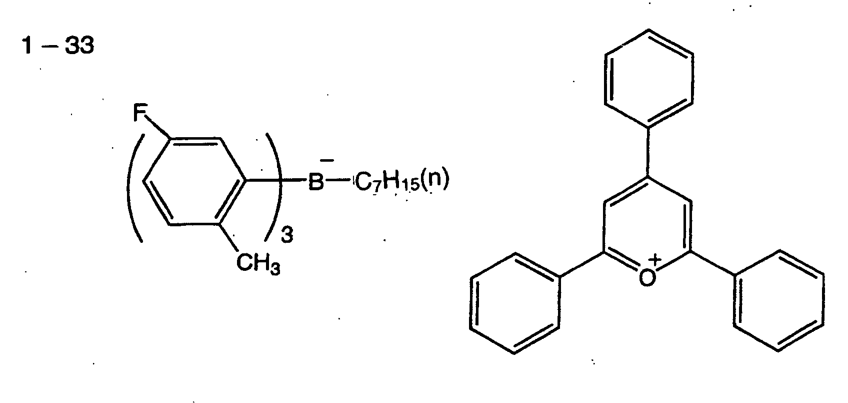

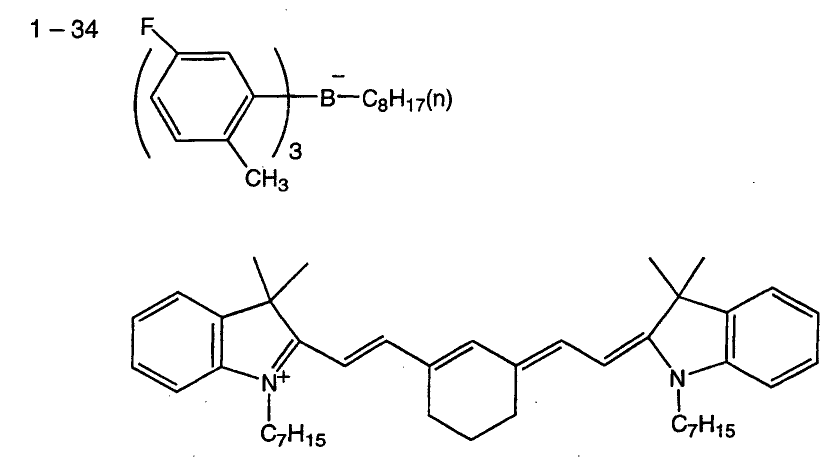

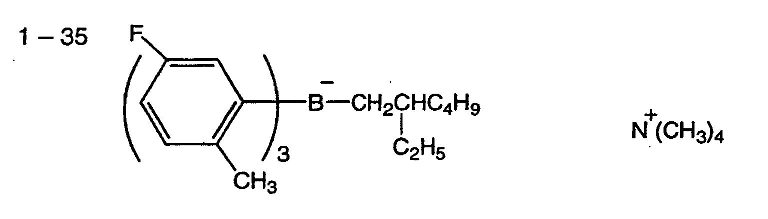

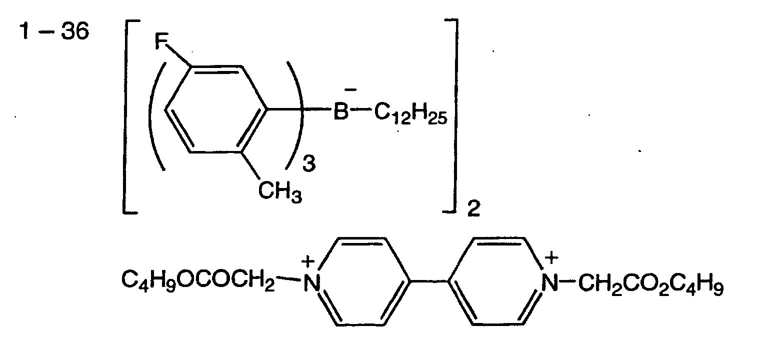

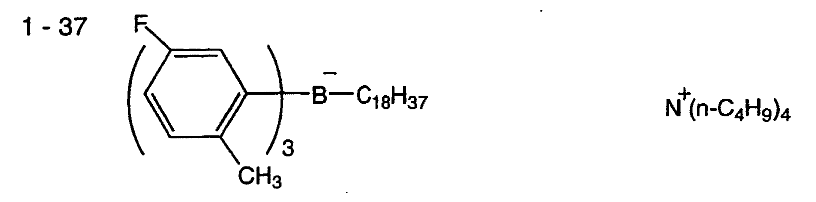

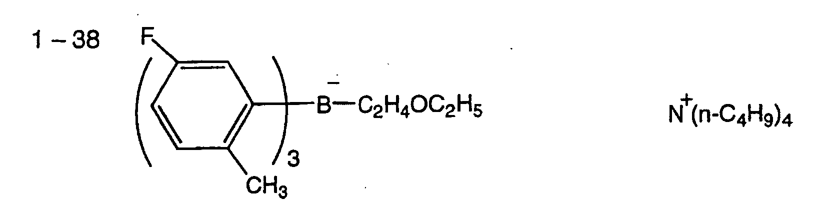

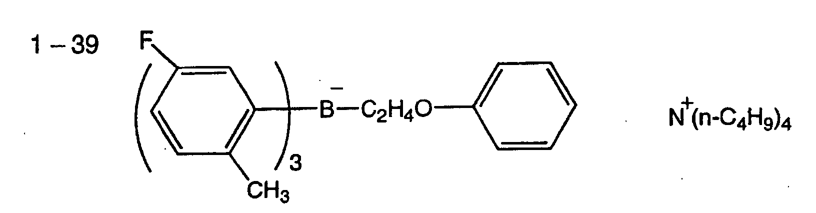

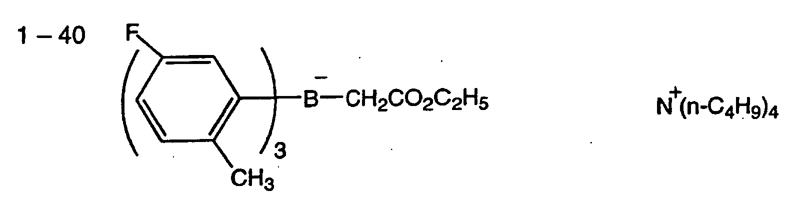

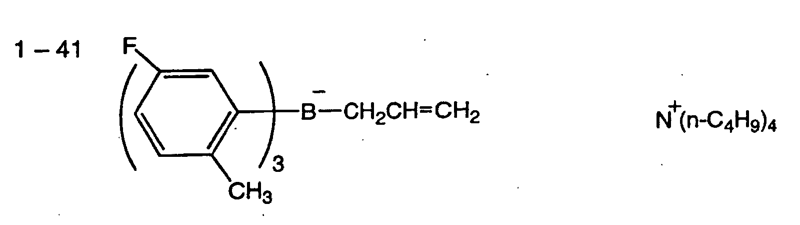

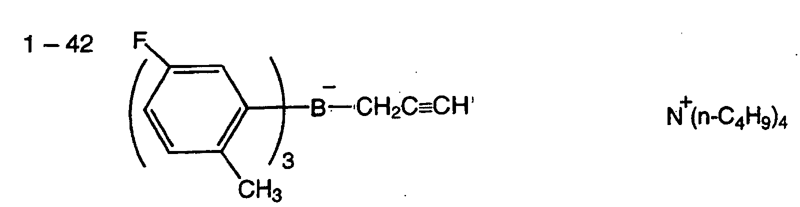

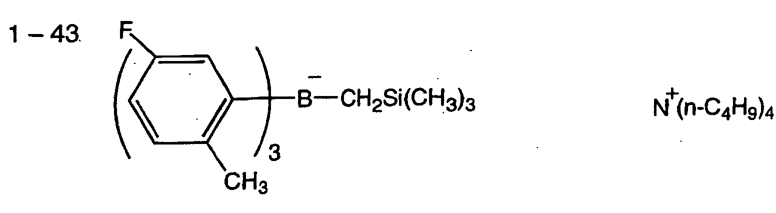

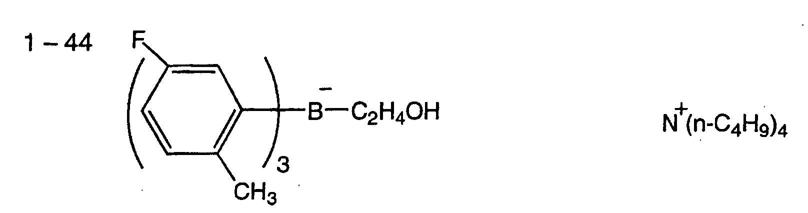

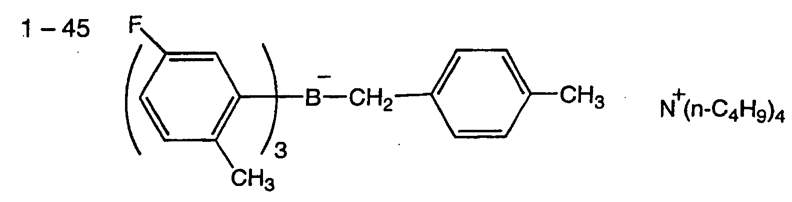

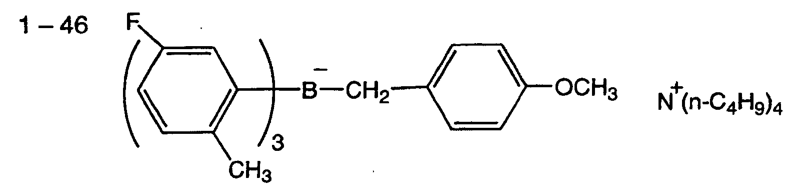

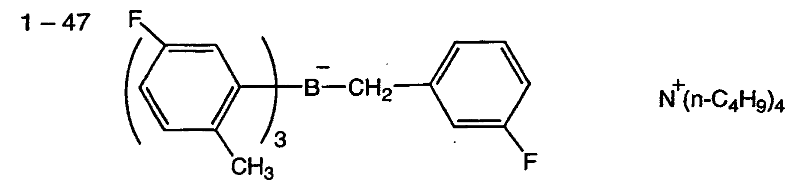

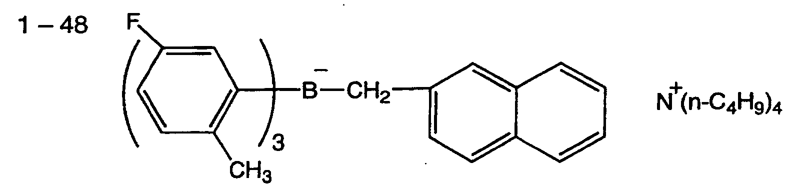

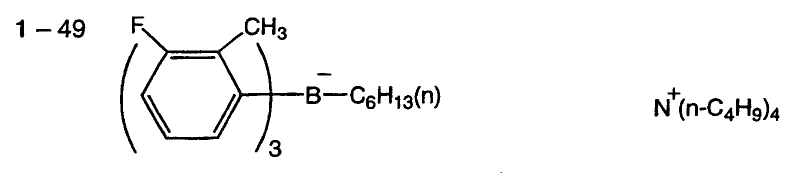

2. Composition photopolymérisable, comprenant le composé borate de la revendication 1.

3. Composition photopolymérisable selon la revendication 2, comprenant en outre un colorant et un composé polymérisable par radicaux.

4. Matériau d'enregistrement comprenant un substrat et une couche d'enregistrement sur le substrat, ladite couche d'enregistrement contenant la composition photopolymérisable selon la revendication 2 ou 3, un composant développeur de couleur (A), et un composant développeur de couleur (B) capable de réagir avec le composant développeur de couleur (A) pour développer le composant développeur de couleur (A).

5. Matériau d'enregistrement selon la revendication 4, dans lequel une combinaison des deux composants, les composants développeurs de couleur (A) et (B), est choisie parmi :
(a) une combinaison d'un précurseur de colorant donneur d'électrons et d'un composé attracteur d'électrons,
(b) une combinaison d'un composé sel de diazonium et d'un coupleur,
(c) une combinaison d'un sel organométallique et d'un agent réducteur,
(d) une combinaison d'un précurseur de colorant protégé et d'un agent débloquant, et
(e) une combinaison d'un précurseur de leuco-colorant et d'un agent débloquant.

6. Matériau d'enregistrement selon la revendication 5, dans lequel le composant développeur de couleur (A) ou (B) est contenu sous forme de microcapsules.
